# EUROPÄISCHE PATENTSCHRIFT

(11) **EP 4 285 403 B1**
(45) Veröffentlichungstag und Bekanntmachung des Hinweises auf die Patenterteilung: **06.08.2025**
(21) Anmeldenummer: 22708766.5
(22) Anmeldetag: 28.01.2022
(51) Int. Cl.: H01L 21/67, H01L 21/687, H01L 21/677, H01L 21/68

(54) **ANLAGE UND VERFAHREN ZUM VERBINDEN VON ELEKTRONISCHEN BAUGRUPPEN**
SYSTEM AND METHOD FOR CONNECTING ELECTRONIC ASSEMBLIES
INSTALLATION ET PROCÉDÉ PERMETTANT DE RELIER DES ENSEMBLES ÉLECTRONIQUES

(30) Priorität: 29.01.2021 DE 102021102129; 07.04.2021 DE 102021108635
(43) Veröffentlichungstag der Anmeldung: 06.12.2023
(73) Patentinhaber: PINK GmbH Thermosysteme, 97877 Wertheim (DE)
(72) Erfinder: OETZEL, Christoph, 97896 Freudenberg Boxtal (DE); MÜSSIG, Stefan, 97904 Dorfprozelten (DE)
(74) Vertreter: Spachmann, Holger
(86) Internationale Anmeldenummer: PCT/EP2022/052029
(87) Internationale Veröffentlichungsnummer: WO 2022/162135

(56) Entgegenhaltungen:
- EP-A2- 0 886 299
- EP-A2- 1 331 659
- WO-A1-2009/150239
- WO-A1-2019/091574
- DE-A1- 102017 100 053
- DE-U1- 20 122 579
- GB-A- 1 472 671
- JP-A- H05 347 321
- US-A1- 2013 108 406
- US-A1- 2014 220 302
- US-A1- 2015 109 598

## Beschreibung

Die Erfindung betrifft eine Anlage zum Verbinden von elektronischen Baugruppen und/oder zum Fertigen von Werkstücken, insbesondere eine Sinter- bzw. Lötanlage.

Des Weiteren betrifft die Erfindung ein Verfahren zum Verbinden von elektronischen Baugruppen und/oder zum Fertigen von Werkstücken, insbesondere für eine Sinter- bzw. Lötanlage, insbesondere eine Vakuumsinter- oder Vakuumlötanlage, bevorzugt eine Diffusionslötanlage.

### STAND DER TECHNIK

Aus dem Stand der Technik sind Anlagen und Verfahren zum Verbinden von elektronischen Baugruppen, insbesondere Löt- und Sinteranlagen mit einer Prozessatmosphäre, insbesondere Vakuum oder Gasatmosphäre bekannt, die als Einzelanlagen und nicht für eine kontinuierliche Fertigung ausgelegt sind. Dabei kommt es zwischen den einzelnen Verfahrensschritten bzw. den einzelnen Positionen der Anlage zu unerwünschten Stillstandszeiten, in welchen einzelne Konfektionierungsarbeiten, wie ein Umsetzen von Werkstücken auf eine Transporteinheit oder ein Abdecken der Werkstücke mit einer Prozessabdeckung händisch, durchgeführt werden. Im Stand der Technik sind daher Anlagen zum Verbinden von elektronischen Baugruppen bekannt, die nicht voll automatisiert arbeiten. In derartigen bekannten Anlagen bzw. Verfahren werden einzelne Arbeitsschritte händisch durchgeführt und bedürfen eines manuellen Eingriffs. Hierbei können Fehler bei der Konfektionierung der Werkstücke auftreten.

Durch Unterbrechung der einzelnen Schritte bzw. durch Unterbrechungen zwischen den einzelnen Positionen kann die Ausbildung eines Reinraums, insbesondere einem Reinraum nach ISO 5, nicht immer sichergestellt werden.

Ein Rein- oder Reinstraum ist ein Raum, in dem die Konzentration luftgetragener Teilchen sehr gering gehalten wird. Rein- und Reinsträume werden für spezielle Fertigungsverfahren - vor allem in der Halbleiterfertigung - benötigt, wo in gewöhnlicher Umgebungsluft befindliche Partikel die Strukturierung integrierter Schaltkreise im Bereich von Bruchteilen eines Mikrometers stören würden. Weitere Anwendungen von Reinräumen oder Reinraumtechnik finden sich in der Optik- und Lasertechnologie, sowie beim hier betrachteten Sintern oder Diffusionslöten.

Internationale Standards definieren spezielle Reinheitsanforderungen für den Betrieb kontrollierter Umgebungen. Die Normen und Richtlinien regeln die Partikelkonzentration (beispielsweise die EN ISO 14644 und VDI 2083 aus 2019) oder zusätzlich die Keimbelastung der Umgebungen (beispielsweise EU-GPMP-Leitfaden aus 2019).

Für Reinsträume, wie sie in der Mikroelektronik Verwendung finden, gibt es mehrere hierarchische Bereiche mit entsprechender Reinraumklasse. So umgibt den Reinstraum (Klasse ISO 4 und besser), in dem mit Substraten gearbeitet wird, ein abgetrennter Bereich mit den benötigten Anlagen zur Beschichtung und Strukturierung.

Die DE 201 22 579 U1 zeigt einen Bestückungsautomaten und einen Lötautomaten. Dadurch werden zumindest zwei Module ausgebildet, wobei die Schaltungsträger durch einen Schieber auf ein Förderband des Bestückungsautomaten zugeführt werden. In dem Bestückungsautomaten werden mit einem Greifarm weitere Schaltungskomponenten aus einem Magazinbehälter auf die Schaltungsträger aufgebracht. Das Förderband geht innerhalb des Bestückungsautomaten in das Förderband über, das die Schaltungsträger in den Lötautomaten führt. Durch den Lötautomaten wird die Fertigungsstation ausgebildet.

Die DE 10 2016 123 362 B3 zeigt einen Mehrfachbestückungskopf. Dies bedeutet, dass in einem festen Raster Chip-Halteeinrichtung angeordnet sind. Folglich können mehrere Chips gleichzeitig entnommen bzw. aufgeladen werden.

Die DE 10 2019 134 410 A1 zeigt eine Anlage mit einer Folienumsetzereinheit.

Die US 2008/0 127 486 A1 zeigt eine Anordnung von mehreren Chips, die übereinander auf einem Substrat angeordnet sind.

Die DE 10 2018 004 086 A1 zeigt eine Durchlaufanlage zur Beschichtung von Substraten, umfassend ein Prozessmodul und eine Vakuumschleuse. Dadurch wird ein automatisiertes Verfahren von Fertigungs-Werkstückträgern gezeigt. Eine Rückführeinheit zur Rückführung des Substratträgers nach Entnahme der Substrate zur erneuten Verwendung kann umfasst sein kann.

Die US 2013/0 108 406 A1 zeigt einen Greifer, der mehrere matrixförmig angeordnete Werkstücke gleichzeitig aufnehmen kann.

In der JP 2013-219 096 A ist das Beladen eines Werkstückträgers mit Werkstücken gezeigt, wobei zwischen den Werkstücken Polster angeordnet werden.

Zum weiteren Stand der Technik kann auf die WO 2009/150239 A1, US 2015/109598 A1, WO 2019/091574 A1, EP 1 331 659 A2, JP H05 347321 A, EP 0 886 299 A2, GB 1 472 671 A, US 2014/220302 A1 und OE 10 2017 100053 A1 verwiesen werden.

Aufgabe der Erfindung ist es, eine Anlage bzw. ein Verfahren vorzuschlagen, die einen automatisierten, insbesondere vollautomatisierten, Ablauf ermöglicht, wodurch insbesondere die Ausbildung eines ISO 5 Reinraums sichergestellt werden kann.

Des Weiteren ist es Aufgabe der Erfindung, eine Anlage bzw. ein Verfahren vorzuschlagen, bei welchen auf eine händische Überprüfung einzelner Positionen bzw. einzelner Verfahrensschritte verzichtet werden kann.

Diese Aufgabe wird durch eine Anlage und ein Verfahren nach den unabhängigen Ansprüchen gelöst. Vorteilhafte Weiterentwicklungen der Erfindung sind Gegenstand der Unteransprüche.

### OFFENBARUNG DER ERFINDUNG

Gegenstand der Erfindung ist eine Anlage zum Verbinden von elektronischen Baugruppen und/oder zum Fertigen von Werkstücken, insbesondere eine Sinter- oder Lötanlage, umfassend mehrere Module zum Verbinden der elektronischen Baugruppen und/oder zum Fertigen der Werkstücke. Die Löt- oder Sinteranlage ist insbesondere für eine Prozessatmosphärenbildung, insbesondere für einen Vakuumbetrieb ausgelegt. In einer Ausgestaltung als Vakuumlötanlage kann diese bevorzugt als Diffusionslötanlage ausgestaltet sein.

Es wird vorgeschlagen, dass zumindest ein Modul als Beladestation und ein Modul als Entladestation ausgebildet ist, oder ein Modul als Beladestation und als Entladestation ausgebildet ist. In beiden Fällen ist zumindest ein weiteres Modul als Fertigungsstation ausgebildet, und ein Fertigungs-Werkstückträger zur Aufnahme der elektronischen Baugruppen und/oder der Werkstücke vorgesehen, der über eine Transporteinheit von der Beladestation über die Fertigungsstation zur Entladestation automatisiert bewegbar ist, wobei die Anlage insbesondere für eine Fließfertigung ausgebildet ist, wobei ein Mehrfachgreifer vorgesehen ist, durch welchen zumindest zwei elektronische Baugruppen und/oder Werkstücke auf den Fertigungs-Werkstückträger gleichzeitig aufsetzbar sind. Der Mehrfachgreifer weist zumindest zwei unabhängig voneinander bewegbare Greifarme auf, die jeweils zur Aufnahme von einer elektronischen Baugruppe und/oder einem Werkstück ausgebildet sind, und durch die Greifarme eine Ausrichtung zumindest einer, insbesondere aller elektronischen Baugruppe und/oder zumindest eines, insbesondere aller Werkstücke in eine Achse quer oder längs zu dem Mehrfachgreifer erfolgen kann.

Mit einer derartigen Anlage kann beispielsweise eine Fließfertigung erfolgen, wobei ein automatisierter und insbesondere vollautomatisierter Ablauf ermöglicht wird. Da insbesondere keine Unterbrechungen bei der Durchführung der unterschiedlichen Schritte in den unterschiedlichen Modulen erfolgt, kann beispielsweise ein Reinraum, insbesondere ein Reinraum nach ISO 5, ausgebildet werden. Die Anlage kann sich daher insbesondere für die Mikroelektronik eignen, wobei die elektronischen Baugruppen und/oder die Werkstücke Baugruppen bzw. Werkstücke der Mikroelektronik ausbilden können. Vornehmlich kann ein Einsatz bei der Herstellung von Hochleistungselektronik, und zur Bildung von Leistungshalbleiter-Kontaktstrukturen mit Bondbuffern vorgesehen sein, wie es z.B. in der DE 10 2009 022 660 B3 beschrieben ist. Die Werkstücke können insbesondere Hochenergiehalbleiterschalter, wie Sie in Frequenzumrichtern eingesetzt werden, und dazu zugehörige Schaltungsträger und/oder Kühlkörper umfassen, d.h. mehrteilig sein, wobei die Einzelteile mittels Löten, Sintern oder ähnliche Verfahren miteinander zu verbinden sind. Ein bevorzugter Anwendungsbereich ist die Verbindung von Halbleiterbauteilen mit zugehörigen Kühlträgern, die als Werkstücke im Sinne der Erfindung zu verstehen sind.

Die Anlage kann insbesondere eine Sinteranlage oder eine Lötanlage sein. Hierzu bietet sich ein Niederdruck-Sintern an, wie es z.B. in DE 3414065 A1, DE 10 2014 114 093 B4, DE 10 2004 019 567 B3 beschrieben ist. In diesem Zusammenhang kann Sintern zum einen das Herstellen oder Verändern von Werkstoffen unter hohem Druck sowie Temperatur, insbesondere unterhalb der Schmelztemperatur, betreffen. Werkstoffen können insbesondere keramische oder metallische Werkstoffe sein. Zum anderen kann unter Sintern das Verbinden von mehreren Elementen eines Werkstücks, beispielsweise eine Elektronikeinheit und ein Kühlkörper oder elektronische Bauteile und Leiterplatten (PCBs), verstanden werden. Dabei können temperaturbeständige Sinterverbindungen hergestellt werden. Derartige Sinterverbindungen können eine Alternative zu herkömmlichen Lötverbindungen darstellen und insbesondere in der Leistungselektronik Anwendung finden. Dazu kann bevorzugt eine Niederdruck-Verbindungstechnik (NTV), die bereits mit Erfolg bei der Herstellung großflächiger Bauelemente eingesetzt wird, zur Verbindung der Werkstücke, beispielsweise IGBT-Module eingesetzt werden. NTV nutzt ein Drucksintern einer Schicht aus Silberpulver zur Verbindungsbildung. Rasterelektronenmikroskopische Untersuchungen verdeutlichen, dass die für die NTV geeigneten Pulver bereits bei einer Temperatur von 200° C an Luft bei Umgebungsdruck spontan versintern. Bei gleichzeitiger Einwirkung eines Drucks von über 20 MPa wird die Pulverschicht zu einer festen Silberschicht kompaktiert, die in der Lage ist, hohe Scherspannungen aufzunehmen. Im Vergleich zu konventionellen Verbindungstechniken, die auf der Verfestigung einer flüssigen Phase beruhen, kann bei der NTV durch geeignete Verläufe von Druck und Temperatur während des Verbindungsprozesses die Temperatur, bei der die verbundene Anordnung frei von mechanischen Spannungen ist, in einem weiten Bereich eingestellt werden. Insbesondere ein Kupfersintern in jeglicher Form, z.B. mit einer Sinterpaste auf Kupferbasis bietet sich für eine Fließfertigungs-Sinteranlage an.

Andererseits kann die Anlage als Lötanlage, insbesondere als Vakuumlötanlage ausgebildet sein. Als Lötverfahren kann beispielsweise ein Reflow- oder Diffusionslötverfahren eingesetzt werden. Reflow-Löten oder Wiederaufschmelzlöten (engl.: reflow soldering) bezeichnet ein in der Elektrotechnik gängiges Weichlötverfahren zum Löten von elektronischen Bauteilen. Voraufgetragene Lötdepots wie Löt-Preforms werden zwischen zu verlötenden Werkstücken angeordnet und aufgeschmolzen, um eine Lötverbindung herzustellen.

Im Diffusionslötprozess wird ein Lot komplett zu intermetallischer Phase legiert. Der Schmelzpunkt der resultierenden Phasen liegt deutlich über der Betriebstemperatur der aktiven Bauteile. Er ist ebenfalls stark erhöht gegenüber dem Schmelzpunkt des Lots. Außerdem besitzen die intermetallischen Phasen einen deutlich höheren Elastizitätsmodul. Der Prozess wird sowohl für das Kupfer-Zinn-System mit Einsatz in Leistungsmodulen als auch für das Gold-Zinn-System für das Löten auf Leiterplatten beschrieben. Lastwechseltests mit aktivem Ein- und Ausschalten der Chips haben ergeben, dass Bauteile mit dieser Verbindungstechnologie um eine Größenordnung höhere Zyklenzahlen erreichen.

Zur Ausbildung eines Reinraums der Sinter- oder Lötanlage sind bevorzugt die Beladestation und die Entladestation, bzw. ein Modul, das als Beladestation und Entladestation ausgebildet ist, innerhalb der Anlage angeordnet. Der Reinraum verläuft daher von der Beladestation, über die Fertigungsstation, bis zur Entladestation. In diesem abgeschlossenen System kann zumindest ein Fertigungs-Werkstückträger angeordnet sein, der automatisiert bewegt werden kann.

Zur Ausbildung einer Fließfertigung sind ein oder mehrere Fertigungs-Werkstückträger, die bevorzugt gleichartig ausgebildet sind, innerhalb der Anlage angeordnet. Ein Fertigungs-Werkstückträger kann beispielsweise eine Mehrzahl von gleichartigen elektronischen Baugruppen und/oder Werkstücken aufnehmen. Die automatisierte Bewegung des Fertigungs-Werkstückträgers bzw. der Mehrzahl von Fertigungs-Werkstückträgern erfolgt über die Transporteinheit. In dem Fall, in dem ein Modul als Beladestation und Entladestation ausgebildet ist, verläuft die Transporteinheit bevorzugt zumindest von der Beladestation bis zur Fertigungsstation und wieder zurück. Sind die Beladestation und die Entladestation als separate Module ausgebildet, wobei zwischen diesen beiden Modulen die Fertigungsstation angeordnet ist, so verläuft die Transporteinheit bevorzugt von der Beladestation, über die Fertigungsstation, bis zur Entladestation. Zur Ausbildung einer Fließfertigung wird in dieser Ausführungsform bevorzugt der Fertigungs-Werkstückträger von der Entladestation zurück zur Beladestation geführt. Dies kann beispielsweise durch ein anderes Transportverfahren bzw. eine andere Transportart erfolgen. So können die Fertigungs-Werkstückträger die komplette Anlage durchlaufen, ohne dass von außerhalb der Anlage, insbesondere händisch, eingegriffen werden muss.

Automatisiert bedeutet insbesondere, dass eine Fortbewegung ohne händischen Eingriff erfolgen kann. Dafür kann die Transporteinheit beispielsweise zumindest teilweise als eine Art Fließband und/oder als Hubeinheit ausgebildet sein. Ein weiterer Vorteil der automatisierten, insbesondere vollautomatisierten, Anlage besteht darin, dass für jedes Modul an sich, sowie für die komplette Anlage, ein Reinraum, insbesondere ein ISO 5 Reinraum, ausgebildet werden kann. So kann die Anlage an sich beispielsweise geschlossen und/oder gasdicht ausgebildet sein. Ebenso können innerhalb der Anlage einzelne Prozesskammern geschlossen und/oder gasdicht ausgebildet sein.

Gemäß der Erfindung kann ein Mehrfachgreifer für Sinter- und für Lötanlagen eingesetzt werden. Unter einem Mehrfachgreifer ist ein Aufnahmeelement zu verstehen, das zumindest zwei elektronische Baugruppe oder zumindest zwei Werkstücke gleichzeitig aufnehmen und von einem Ort zu einem anderen Ort transportieren kann. Der Mehrfachgreifer kann in der Beladestation und/oder in der Entladestation eingesetzt werden. Insbesondere kann der Mehrfachgreifer bei Sinteranlagen und bei Lötanlagen verwendet werden. Mit dem Mehrfachgreifer können zumindest zwei Werkstücke zeitgleich gegriffen und umgesetzt werden. Dadurch kann ein Werkstückträger schneller be- und entladen werden.

Gemäß der Erfindung weist der Mehrfachgreifer zumindest zwei Greifarme auf, die jeweils zur Aufnahme von einer elektronischen Baugruppen und/oder einem Werkstück ausgebildet sind. Dadurch können, insbesondere baugleiche, Werkstücke zeitgleich bewegt werden. Jeder Greifarm kann einen teleskopierbaren und/oder schwenkbaren Abschnitt sowie einen Abschnitt zur Aufnahme des Werkstücks bzw. der Baugruppe umfassen. Die Aufnahme kann aus zwei Greifelementen bestehen, die ein Werkstück bzw. eine Baugruppe von zwei Seiten klemmbar fixieren. Der teleskopierbare und/oder schwenkbare Abschnitt kann teleskopierbar und/oder schwenkbar an einem Grundkörper des Mehrfachgreifers angeordnet sein. Dadurch können sich die Greifarme relativ zueinander sowie relativ zum Grundkörper bewegen.

Gemäß der vorliegenden Erfindung sind die Greifarme unabhängig voneinander bewegbar und/oder ansteuerbar. Insbesondere sind alle Greifarme auf einer Linie angeordnet, sodass nebeneinander angeordnete Werkstücke und/oder Baugruppen aufgenommen werden können. Mit anderen Worten sind die Greifarme bevorzugt nebeneinander auf einer Längsachse des Mehrfachgreifers angeordnet.

In einer bevorzugten Ausführungsform kann der Mehrfachgreifer vier Greifarme aufweisen, die jeweils zur Aufnahme von einer elektronischen Baugruppen und/oder einem Werkstück ausgebildet sind.

In einer bevorzugten Ausführungsform kann zumindest ein Greifarm pneumatisch angesteuert werden, sodass dieser relativ zu dem zumindest einen weiteren Greifarm bewegbar und/oder verschwenkbar ist. Werden mehrere Greifarme pneumatisch angesteuert, erfolgt die pneumatische Ansteuerung bevorzugt für jeden Greifarm unabhängig, sodass die Greifarme unabhängig voneinander bewegt werden können.

In einer bevorzugten Ausführungsform kann der Mehrfachgreifer vier Greifarme aufweisen, die parallel zueinander entlang einer Linie angeordnet sind, wobei die beiden äußeren Greifarme entlang der Linie verfahrbar sind, sodass diese relativ zu den beiden Inneren Greifarmen verfahrbar sind. Die Linienführung kann durch eine Form des Mehrfachgreifers erreicht werden, indem der Mehrfachgreifer beispielsweise einen linienförmigen Grundkörper aufweist. Die Greifarme können bevorzugt entlang des linienförmigen Grundkörpers bewegt werden, beispielsweise über teleskopierbare Elemente und/oder Schienenelemente. Dabei kann über die pneumatische Ansteuerung eine Art Schlittenelement ausgebildet werden, wobei insbesondere die beiden äußeren Greifarme voneinander wegbewegt werden können. Ist der Mehrfachgreifer mit mindestens drei, insbesondere vier, Greifarmen ausgebildet, so kann zumindest der eine Greifarm, der zwischen den beiden äußeren Greifarmen angeordnet ist, feststehend ausgebildet sein. Feststehend bedeutet insbesondere, dass sich die beiden äußeren Greifarme relativ zu dem zumindest einen mittleren Greifarm bewegen können. Des Weiteren bedeutet feststehend insbesondere, dass der zumindest eine mittlere Greifarm keine Relativbewegung bezüglich des Grundkörpers des Mehrfachgreifer ausüben kann. Ist der Mehrfachgreifer mit insgesamt vier Greifarmen, und damit mit zwei mittleren Greifarmen, ausgebildet, so können die mittleren beiden Greifarme feststehend ausgebildet sein.

In einer bevorzugten Ausführungsform kann die Fertigungsstation zumindest ein weiteres Modul als Lötmodul und/oder als Sintermodul umfassen. Bevorzugt kann die Fertigungsstation mehr als ein weiteres Modul, insbesondere ein Vorheizmodul, ein Plasmamodul, ein Lötmodul und/oder ein Sintermodul und/oder ein Abkühlmodul, umfassen. Ein Vorheizmodul dient zur Vorerwärmung der zu verbindenden Werkstücke. Ein Plasmamodul kann beispielsweise zur Reinigung der Werkstücke eingesetzt werden. Das Löt- und/oder Sintermodul kann ein Verbinden der Werkstücke, insbesondere ein thermisches Fügeverfahren unter Prozessatmosphäre durchführen. Das Abkühlmodul dient zur definierten Abkühlung der Werkstücke, so dass ein hoher Fließtakt einer In-Line Fertigung, d.h. Fließfertigung erreicht werden kann. Eine oder mehrere, zusammenhängende und ggf. durch gasdichte Schleusen verbindbare Module können eine Prozessatmosphäre, insb. Unterdruck oder Vakuum als Prozessatmosphäre zum Verbinden der Werkstücke bereitstellen.

Bevorzugt sind die weiteren Module zwischen der Beladestation und der Entladestation angeordnet. Sind die Beladestation und die Entladestation in einem gemeinsamen Modul integriert, sind die weiteren Module bevorzugt auf zumindest einer Seite bezüglich der Beladestation bzw. Entladestation angeordnet. Die Anlage kann beispielsweise als langgestreckte Durchlaufanlage ausgebildet sein. Bevorzugt kann der Fertigungs-Werkstückträger alle Module der Anlage automatisiert durchlaufen. Es ist denkbar, dass der Fertigungs-Werkstückträger die Anlage in beiden Richtungen, d.h. hin und zurück, durchlaufen kann, sodass ein Kreislauf entsteht. Dadurch kann besonders vorteilhaft eine Fließbandfertigung ausgebildet werden, die automatisiert erfolgt. Die Hin- und Zurückbewegung kann auf unterschiedlichen Ebenen innerhalb der Anlage erfolgen.

In einer bevorzugten Ausführungsform kann ein Modul als Beladestation und ein Modul als Entladestation ausgebildet sein, wobei die Beladestation der Fertigungsstation vorgeschaltet ist und die Entladestation der Fertigungsstation nachgeschaltet ist, und die Transporteinheit die elektronischen Baugruppen und/oder Werkstücke von der Entladestation, insbesondere unter Umgehung der Fertigungsstation, zurück zur Beladestation transportiert. Als Umgebung der Fertigungsstation ist insbesondere keine räumliche Umgehung, sondern eine funktionale Umgebung zu verstehen. Die Fertigungsstation kann beispielsweise eine funktionale Arbeitsstation sein, die insbesondere zumindest eine geschlossene und/oder gasdichte Prozesskammer umfasst. Bei einer Umgehung der Fertigungsstation kann diese geschlossene Prozesskammer bei der Rückführung des Fertigungs-Werkstückträgers umgangen werden. Dabei kann beispielsweise die Transporteinheit für die Rückführung außerhalb der Prozesskammer, jedoch innerhalb eines die Fertigungsstation umgebenden Außengehäuses, angeordnet sein. Eine Rückführung des Fertigungs-Werkstückträgers kann beispielsweise unterhalb oder neben der zumindest einen Arbeitsstation bzw. Prozesskammer der Fertigungsstation erfolgen. Insbesondere erfolgt die Rückführung innerhalb der Anlage, wobei bevorzugt der Fertigungs-Werkstückträger die Anlage während der kompletten Fertigung, insbesondere Fließfertigung, nicht verlässt. Die Transporteinheit kann gemäß eines Fließbandprinzips oder eines Kettenführungsprinzips aufgebaut sein. Zur Vertikalförderung von einer unterhalb der Arbeitsstation angeordneten Rückführungs-Transporteinheit kann eine Hubeinrichtung vorgesehen sein, auf dem die Werkstückträger nach einem Liftprinzip verfahren werden können.

In der Regel kann ein Transport-Werkstückträger als Fertigungs-Werkstückträger verwendet werden, insofern ist kein Umsetzen der Bauteile zwischen den verschiedenen Werkstückträgertypen erforderlich und auf einen Rücktransport des Fertigungs-Werkstückträgers kann verzichtet werden.

In einer bevorzugten Ausführungsform kann in der Beladestation zumindest ein Automatisierungsroboter zur Führung des Mehrfachgreifers vorgesehen sein, durch den zumindest zwei elektronische Baugruppen und/oder Werkstücke von einem Transport-Werkstückträger auf den Fertigungs-Werkstückträger in der Beladestation automatisiert und zeitgleich überführbar und ggf. auflegbar sind. Ebenso kann in der Entladestation zum Entladen der elektronischen Baugruppen und/oder Werkstücke ein Automatisierungsroboter vorgesehen sein. Über den Transport-Werkstückträger können die elektronischen Baugruppen und/oder die Werkstücke der Anlage zugeführt werden. Bevorzugt innerhalb der Beladestation erfolgt ein Umsetzen von dem Transport-Werkstückträger auf den Fertigungs-Werkstückträger. Dies erfolgt über einen Automatisierungsroboter, der bevorzugt innerhalb der Beladestation angeordnet ist. In einer Ausführungsform kann beispielsweise ein Automatisierungsroboter vorgesehen sein, der zum Beladen des Fertigungs-Werkstückträgers an der Beladestation sowie zum Entladen des Fertigungs-Werkstückträgers an der Entladestation ausgebildet ist. Dieser ermöglicht ein Umsetzen der Baugruppen von einem - typischerweise herstellerspezifischen - Transport-Werkstückträger auf einen anlagespezifischen Fertigungs-Werkstückträger. Dabei kann der Fertigungs-Werkstückträger beispielsweise eine Mehrzahl von Baugruppen aufnehmen, wobei der Transport-Werkstückträger nur eine, oder wenige Baugruppen transportiert. Insofern können auf einem Fertigungs-Werkstückträger Baugruppen einer Mehrzahl von Transport-Werkstückträger aufgenommen werden. Das Umsetzen erfolgt daher zumindest in der Beladestation bevorzugt mit dem Mehrfachgreifer. Durch die relativ zueinander bewegbaren Greifarme können beispielsweise mehrere nebeneinander auf mehreren Transport-Werkstücketrägern angeordnete Werkstücke zeitgleich angehoben bzw. gegriffen werden und ebenso zeitgleich auf dem Fertigungs-Werkstückträger abgesetzt werden. Da die Greifarme relativ zueinander bewegbar sind, insbesondere pneumatisch, kann eine beliebige räumliche Anordnung auf dem Fertigungs-Werkstückträger erfolgen, selbst wenn die Werkstücke auf dem Transport-Werkstückträger alle auf eine Linie nebeneinander angeordnet sind. Der Mehrfachgreifer wird insbesondere von dem Roboterarm gesteuert. Ebenso kann das Umsetzen der elektronischen Bauelemente bzw. Werkstücke von dem Fertigungs-Werkstückträger auf den Transport-Werkstückträger in der Entladestation durch einen Mehrfachgreifer durchgeführt werden.

In der Regel ist der Automatisierungsroboter als 3D- oder 2D- Handlingroboter ausgebildet. Vorteilhaft kann der Automatisierungsroboter als einachsige Handlingsachse ausgebildet sein. Dabei kann ein eindimensionaler Antrieb, z.B. als Linearantrieb ausgestaltet sein, wodurch eine hohe Geschwindigkeit bei geringen Kosten für eine Pick-and-Place Aufgabe erreichbar ist.

In einer bevorzugten Ausführungsform kann durch die Greifarme eine Ausrichtung zumindest einer, insbesondere aller aufgenommenen elektronischen Baugruppe und/oder zumindest eines, insbesondere aller aufgenommenen Werkstücke in eine Achse quer oder längs zu dem Mehrfachgreifer erfolgen, wobei die Achse insbesondre horizontal ausgerichtet ist. Eine Längsachse ist bevorzugt in Richtung der Linie ausgerichtet, in der die Greifarme angeordnet sind. Eine Querrichtung ist orthogonal dazu, wobei insbesondere beide Achsen in einer horizontalen Ebene liegen. Dadurch kann eine Ausrichtung in zumindest eine horizontale Raumrichtung erfolgen, wenn die Werkstücke oder Baugruppen von den Greifarmen aufgenommen sind. Die Ausrichtung dient dazu, dass die Werkstücke oder Baugruppen in den Fertigungs-Werkstückträger ausgerichtet eingelegt werden können.

In einer bevorzugten Ausführungsform kann zumindest ein Greifarm, insbesondere jeder Greifarm, zur Aufnahme von einer elektronischen Baugruppe und/oder einem Werkstück zumindest zwei Greifelemente aufweisen, die eine Ausrichtung der elektronischen Baugruppe und/oder des Werkstücks in eine Achse bewirkt, wobei die Achse insbesondere durch beide Greifelemente verläuft. Als Greifelement ist ein Klemmelement zu verstehen, dass das Bauteil oder das Werkstück, insbesondere an einer Seitenkante, kontaktieren kann. Sind zwei Greifelement gegenüberliegend an dem Greifarm angeordnet, kann dazwischen ein Werkstück oder ein Bauelement klemmend gehalten werden. Bevorzugt können die Greifelemente dabei relativ zueinander bewegt werden, um das Bauelement/Werkstück zu halten oder zu lösen.

Die Greifelemente sind bevorzugt zur Ausrichtung ausgelegt. Die Greifelemente sind dafür bevorzugt flächig mit je einer Seitenkante des Werkstücks in Kontakt, sodass das Werkstück in eine Richtung ausgerichtet werden kann. In einer Ausführungsform sind alle Greifarme eines Mehrfachgreifer parallel bzw. nebeneinander auf einer Achse angeordnet, sodass alle Werkstücke gleich ausgerichtet werden können. Insbesondere sind die gegenüberliegenden Greifelemente daher ebenso parallel oder auf einer Achse bezüglich des jeweils benachbarten Greifelements angeordnet. In einer anderen Ausführungsform sind die Greifelemente der Greifarme derart nebeneinander angeordnet, dass jeweils eine Rückseite eines Greifelements mit einer Rücke eines Greifelements eines benachbarten Greifarms zueinander ausgerichtet sind.

In einer bevorzugten Ausführungsform kann eine Ausrichteeinheit umfasst sein, die eine Ausrichtung der von dem Mehrfachgreifer aufgenommenen elektronischen Baugruppe und/oder des Werkstücks in eine Achse parallel und/oder quer zu dem Mehrfachgreifer bewirkt. In einer Ausführungsform kann eine erste Ausrichtung durch die Greifarme des Mehrfachgreifers in eine Achse quer zu der Achse des Mehrfachgreifers erfolgen. Die Ausrichteeinheit kann als eine Art Anschlag ausgebildet sein, auf welchen der Mehrfachgreifer zubewegt wird, damit die freien Seitenkanten der Werkstücke, die nicht durch ein Greifelement kontaktiert sind, die Ausrichteeinheit kontaktieren. Ist die Ausrichteeinheit als eine Kante ausgebildet, werden die Werkstücke/Bauteile durch Kontakt mit der Kante alle gleich ausgerichtet.

In einer bevorzugten Ausführungsform kann die Ausrichteeinheit eine Ausrichtung der elektronischen Baugruppen und/oder der Werkstücke in einer Achse quer zu der Ausrichtung durch die Greifelemente bewirken. Bevorzugt ist die Ausrichteeinheit dabei ähnlich wie der Mehrfachgreifer ausgebildet. Dies bedeutet, dass die Ausrichteeinheit ebenso Greifelemente aufweist, die zur Aufnahme bzw. zur Kontaktierung mit den Werkstücken ausgebildet sind. Dabei können die Greifelemente der Ausrichteeinheit von unten gegen die von dem Mehrfachgreifer bereits gehaltenen Werkstücke herangefahren werden, um die Werkstücke an zwei gegenüberliegenden freien Seitenkanten zu greifen und auszurichten. Zeitweise können die Werkstücke daher von allen vier Seitenkanten durch Greifelemente kontaktiert sein, um ausgerichtet zu werden. Eine Ausrichtung kann daher in zwei zueinander orthogonal verlaufende Richtungen in einer bevorzugt horizontalen Ebene erfolgen. Die Ausrichteeinheit wird anschließend bevorzugt wieder von den Werkstücken/Bauteilen wegbewegt. Anschließend können die ausgerichteten Bauteile auf den Fertigungs-Werkstückträger ausgerichtet aufgelegt werden.

**In** einer bevorzugten Ausführungsform kann in der Beladestation zur Ausrichtung und/oder Zentrierung des Fertigungs-Werkstückträgers eine Zentriervorrichtung vorgesehen sein, die eine horizontale und/oder vertikale Ausrichtung und/oder Zentrierung des Fertigungs-Werkstückträgers vor Ausnahme der elektronischen Baugruppen und/oder der Werkstücke bewirkt. Bevorzugt kann der Fertigungs-Werkstückträger einen Transportrahmen und eine darin aufgenommenen Baseplate umfassen, wobei Werkstücke in der Baseplate positioniert werden. Dadurch kann der Fertigungs-Werkstückträger bzw. die Baseplate gegenüber dem Transportrahmen des Fertigungs-Werkstückträgers exakt ausgerichtet werden, um die an dem Mehrfachgreifer ausgerichteten Werkstücke/Bauteile passgenau aufzunehmen.

Die Zentriervorrichtung kann eine Zentrierung bzw. Ausrichtung des Fertigungs-Werkzeugträgers bezüglich der Transporteinheit bewirken. Dadurch kann der Fertigungs-Werkzeugträger sozusagen zweiteilig ausgebildet sein, wobei eine sogenannte Baseplate die Aufnahmebereiche für die Werkstücke bzw. elektronischen Baugruppen bereitstellt, und ein Transportrahmen als eine Art Rahmenelement zur Aufnahme der Baseplate ausgebildet ist. Dadurch kann die Baseplate bezüglich des Transportrahmens ausgerichtet und fixiert werden. Die Baseplate ist im Folgenden als ein wesentliches Element des Fertigungs-Werkzeugträgers, oder kann den Fertigungs-Werkzeugträger in Gänze oder in wesentlichen Merkmalen zusammen mit dem Rahmenelement verwirklichen, da diese die Aufnahmen für die Mehrzahl an Werkstücken/Bauteilen umfasst. Dabei kann vorzugsweise die Baseplate relativ zu dem Transportrahmen verschoben bzw. angehoben oder abgesenkt werden. Des Weiteren können Baseplate zum Transportrahmen gegeneinander verdreht werden. Dadurch kann die Ausrichtung der Aufnahmen für die Werkstücke/Bauteile erfolgen. Dies kann bevorzugt zur lagerichtigen Ausrichtung von Werkstücken für einen Pressenprozess gegenüber Pressstempeln in der Fertigungsstation dienen.

**In** einer bevorzugten Ausführungsform kann die Zentriervorrichtung eine Zentrierplatte und/oder eine Hubeinheit umfassen, wobei eine Ansteuerung insbesondere pneumatisch erfolgt. Der Fertigungs-Werkzeugträger bzw. die Baseplate ist auf der Zentrierplatte derart angeordnet, dass eine Bewegung der Zentrierplatte relativ zu dem Fertigungs-Werkzeugträger bzw. dem Transportrahmen möglich ist. Bevorzugt sind die Zentrierplatte und der Fertigungs-Werkzeugträger bzw. die Baseplate verschieblich über zumindest zwei, insbesondere drei Auflager kontaktier. Die Auflager können Kugelrollen-Auflager sein. Über die Hubeinheit kann die Zentrierplatte angehoben und abgesenkt werden

**In** einer bevorzugten Ausführungsform kann zumindest ein Vorsprung oder Zapfen an der Zentrierplatte vorgesehen sein, der mit einem Anschlag an dem Fertigungs-Werkstückträger bzw. der Baseplate kontaktierbar ist, sodass eine Ausrichtung und/oder Zentrierung des Fertigungs-Werkstückträgers relativ zu der Zentrierplatte in der horizontalen Einspannebene erfolgen kann. Dies kann beispielsweise über ein Andrückelement erfolgen, das gegen den Fertigungs-Werkstückträger bzw. die Baseplate gepresst wird, wobei der Vorsprung bzw. Zapfen mit dem Anschlag in Kontakt kommt. Dadurch kann der Fertigungs-Werkstückträger bzw. die Baseplate im Transportrahmen des Fertigungs-Werkstückträgers ausgerichtet werden. Das Andrückelement kann als eine Art Exzenter ausgebildet sein, und insbesondere über einen Elektromotor, rechtwinklig zur Einspannebene bewegt werden. Alternativ kann das Andrückelement als Stempel innerhalb der Einspannebene ausgeführt sein und kann beispielsweise über einen Pneumatikzylinder angesteuert werden.

**In** einer weiteren Ausführungsform kann zum Umsetzen ein Sauggreifer verwendet werden, der mittels Unterdruck und unter Vermeidung von mechanischen Greifkräften die Werkstücke anheben kann. Des Weiteren können mehr als ein Automatisierungsroboter innerhalb der Anlage vorgesehen sein. **In** einer bevorzugten Ausführungsform ist ein Automatisierungsroboter in der Beladestation, ein weiterer Automatisierungsroboter in der Entladestation angeordnet. Dadurch kann ein kontinuierliches Beladen bzw. Entladen der Fertigungs-Werkstückträger innerhalb der Anlage erfolgen, wodurch eine Fließfertigung besonders vorteilhaft erreicht werden kann. Die Spezifikation der Transport-Werkstückträger ist somit unabhängig von der Spezifikation des vom Fügeprozess, z.B. Sinter- oder Lötprozess-geeigneten Fertigungs-Werkstückträger.

Eine korrekte Konfektionierung, insbesondere Lage und Anordnung der Baugruppen auf dem Fertigungs-Werkstückträger in der Beladestation kann optisch mittels zumindest einer Kamera überprüft und archiviert werden. Auch kann zur Ausrichtung eines Greifarms eines Automatisierungsroboters / Handlingroboters zumindest eine Kamera zur optischen Ausrichtung in der Be- und/oder Entladestation vorgesehen sein. Die Kamera kann beispielsweise eine korrekte Ausrichtung des oder der Werkstücke bzw. der Fügepartner innerhalb der Werkstücke, beispielsweise der DCBs (Direct Copper Bonded) zueinander oder gegenüber dem Fertigungs-Werkstückträger und/oder der Abdeckfolie und/oder der Abdeckmaske bestimmen und Justierinformationen an den Automatisierungsroboter weiterleiten. So können beispielsweise Kanten- und Eckverläufe erkannt und daraus ein X/Y-Versatz bestimmt werden. Der Automatisierungsroboter kann als üblicher Industrieroboter mit einem um mehrere Achsen bewegbaren Arm ausgeführt sein. Es kann auch als ein- oder mehrachsiges Transportsystem zum Transport von Werkstückträger, Folien, Abdeckmasken etc. ausgeführt sein.

**In** bzw. vor der Beladestation kann ein Stapelmagazin für Fertigungs-Warenträger vorgesehen sein, die insbesondere zu Beginn der Produktion ein Bestücken der Transporteinheit mit einer sequentiellen Kette von Fertigungs-Warenträger ermöglicht. Somit kann sofort ein kontinuierlicher Prozess angefahren werden, und es muss nicht auf einen Rücklauf der ersten Fertigungs-Warenträgers gewartet werden. Somit können bereits beim Hochlaufen der Fertigung hohe Stückzahlgeschwindigkeiten erreicht werden, insbesondere wenn mit einem Mehrfachgreifer mehrere Werkstücke gleichzeitig aufgenommen werden können.

Insbesondere am Ende eines Batch-Arbeitsablaufs, bei der eine Anzahl von Werkstückträgern gefügt werden soll, kann im Falle eines letzten Fertigungs-Werkstückträgers, der nicht mit Werkstücken vollständig befüllt werden kann, Dummy-Werkstücke auf die verbleibenden leeren Plätze des Fertigungs-Werkstückträgers gesetzt werden, die nach dem Fügeprozess, insbesondere einem Sinter- oder Diffusionslötprozess, wieder vom Fertigungs-Werkstückträger auf eine Dummy Position zurückgelegt werden kann.

In einer bevorzugten Ausführungsform kann eine weitere Transporteinheit zur Aufnahme des Transport-Werkstückträgers vorgesehen sein, die unabhängig von den Modulen von der Beladestation zu der Entladestation, insbesondere unter Umgehung der Fertigungsstation, verfahrbar ist. Diese weitere Transporteinheit kann beispielsweise in der Beladestation der Anlage zugeführt werden, sowie in der Entladestation aus der Anlage herausgeführt werden. Auf dem Transport-Werkstückträger sind insbesondere die Rohlinge oder unverbundenen Bauteile angeordnet, die von externen Herstellern stammen können. Die Umgehung der Fertigungsstation ist wie bereits zuvor erläutert, zu verstehen. Insbesondere kann die weitere Transporteinheit eigenständig, sowie insbesondere unabhängig von der Transporteinheit der Fertigungs-Werkstückträger der Anlage verfahrbar sein. Bevorzugt kann die Transporteinheit der Transport-Werkstückträger parallel zu den Modulen der Anlage verfahren.

In einer bevorzugten Ausführungsform kann die Beladestation eingerichtet sein, eine Prozessabdeckung auf die elektronischen Baugruppen und/oder die Werkstücke aufzubringen, und/oder die Entladestation eingerichtet sein, die Prozessabdeckung von den elektronischen Baugruppen und/oder den Werkstücken zu entfernen, insbesondere mittels eines Automatisierungsroboters aufzubringen und/oder zu entfernen. Bei der Prozessabdeckung kann es sich um eine Maske bzw. Abdeckmaske, insbesondere für einen Sinterprozess, handeln, die auf die elektronischen Baugruppen und/oder Werkstücke, die auf dem Fertigungs-Werkstückträger angeordnet sind, automatisiert aufgelegt werden kann. Die Aufbringung kann über eine automatisierte Vorrichtung bzw. einen Automatisierungsroboter erfolgen. Dabei kann die Prozessabdeckung zwischen einer Parkposition, insbesondere zum Zwischenlagern der Prozessabdeckung, und zwischen der Position auf dem Fertigungs-Werkstückträger hin und her bewegt bzw. verschoben werden. Die Prozessabdeckung kann auf einer Art Lagervorrichtung gelagert werden und über eine Schiene an die entsprechende Position verschoben werden.

Dies kann computergesteuert geregelt werden. Sind mehrere Fertigungs-Werkstückträger innerhalb der Anlage vorgesehen, insbesondere für eine kontinuierlichen Fertigung, so sind bevorzugt mehrere Prozessabdeckungen innerhalb der Anlage angeordnet. Beispielsweise kann an der Parkposition kontinuierlich eine Prozessabdeckung aufgelegt werden, wenn die zuvor dort angeordnete Prozessabdeckung entnommen, bzw. auf den Fertigungs-Werkstückträger aufgelegt, wurde. Des Weiteren kann jeweils eine Prozessabdeckung für einen Fertigungs-Werkstückträger vorgesehen sein, wobei bei Rückführen des Fertigungs-Werkstückträgers die Prozessabdeckung mit dem Fertigungs-Werkstückträger rückgeführt wird. Die Prozessabdeckung kann vor dem Rückführen von der Entladestation zur Beladestation für den Rücktransport wieder auf den Fertigungs-Werkstückträger aufgelegt werden.

In einer bevorzugten Ausführungsform kann die Beladestation und/oder die Entladestation zumindest zwei Arbeitspositionen, insbesondere drei oder vier Arbeitspositionen, umfassen, wobei der Fertigungs-Werkstückträger von einer Arbeitsposition zu einer benachbarten Arbeitsposition automatisiert, insbesondere über eine Verfahreinheit, verfahrbar ist. Jede der Arbeitspositionen kann einen von der anderen Arbeitsposition unterschiedlichen Arbeitsschritt ausüben. In einer ersten Arbeitsposition kann beispielsweise die Prozessabdeckung, insbesondere eine Abdeckmaske, auf den Fertigungs-Werkstückträger mit den elektronischen Baugruppen und/oder den Werkstücken, aufgelegt werden. Alternativ kann auf die Maske auch verzichtet werden. Nach Durchlaufen der letzten Arbeitsposition sind die elektronischen Baugruppen und/oder die Werkstücke auf dem Fertigungs-Werkstückträger bevorzugt derart vorbereitet, dass diese die Fertigungsstation, insbesondere ein Vorheizmodul, Löt- oder Sintermodul und Abkühlmodul, durchlaufen kann. Die Verfahreinheit kann als eine Art Transporteinheit ausgebildet sein, beispielsweise als Fließband oder Transportband. Die Verfahreinheit kann zusammen mit der Transporteinheit zum Rücktransport der Fertigungs-Werkstückträger eine Art Kreislauf ausbilden, um eine Fließfertigung auszubilden. Sind mehrere Fertigungs-Werkstückträger in der Anlage angeordnet, so sind diese bevorzugt in einem kontinuierlichen Abstand zueinander auf der Verfahreinheit angeordnet. Die Arbeitsstationen können sequentiell und linear hintereinander oder auch in Form eines Rundtakttisches kreisförmig benachbart zueinander angeordnet sein.

In einer bevorzugten Ausführungsform kann die Beladestation drei Arbeitspositionen umfassen, die über eine Verfahreinheit miteinander verbunden sind. Dazu können auf einer ersten Arbeitsposition die elektronischen Baugruppen und/oder die Werkstücke durch einen Automatisierungsroboter automatisiert aufgelegt werden. Zumindest eine Maske kann als erste Prozessabdeckung auf die elektronischen Baugruppen und/oder auf die Werkstücke über einen Automatisierungsroboter automatisiert aufgelegt werden. Alternativ oder zusätzlich kann in einer zweiten Arbeitsposition zumindest eine Folie oder mehrere Folienstücke als zweite Prozessabdeckung auf die Maske oder anstelle der Maske über eine Automatisierungsroboter automatisiert aufgelegt werden, und in einer dritten Arbeitsposition kann ein Verschließen des Fertigungs-Werkstückträgers mit der Folie, insbesondere über einen Halterahmen, insbes. Haltering, automatisiert erfolgen. Es ist denkbar, dass ein einzelner Automatisierungsroboter zur Ausführung aller Vorgänge in allen Arbeitspositionen vorgesehen ist. Bevorzugt sind an jeder Arbeitsposition separate Automatisierungsroboter bzw. andersartige computergesteuerte Aktuatorvorrichtungen vorgesehen, um die jeweiligen Arbeitsschritte in den Arbeitspositionen durchzuführen.

Eine Folienumsetzereinheit wird insbesondere dann eingesetzt, wenn es sich um eine Sinteranlage handelt. Bei einer Lötanlage kann auf eine Folienumsetzereinheit, und demnach auf den kompletten Einsatz einer Folie, verzichtet werden.

Bei der Folie kann es sich beispielsweise um eine temperaturfeste Ausgleichsfolie z.B. für Temperaturbereiche um 250°C, z.B. eine PTFE-Folie, eine FKM-Folie, eine Silikonfolie, eine Polyurethanelastomere-Folie, Eladur-Folien eine PFA-Folie, PI-Folie oder ähnliches wie eine Graphit-Folie, eine Aluminium-Folie oder ähnliches handeln. Bevorzugt kann die Folie als Schutz eines SMD (Surface Mounted Device)-Schablone dienen. SMD-Bauteile haben eine extrem kleine Bauform. Derartige elektronische Bauteile haben keine Drahtanschlüsse, sondern können mittels lötfähiger Anschlussflächen direkt auf eine Platine gelötet werden. Diese Technik kann auch als Oberflächenmontage bezeichnet werden. Die Folie kann ein unerwünschtes Anheften eines Gelkissens auf einer Bauteiloberfläche im Rahmen eines Sinterprozesses verhindern.

In einer bevorzugten Ausführungsform können die Beladestation und die Entladestation gespiegelt zueinander ausgebildet sein. Dadurch können besonders vorteilhaft die elektronischen Baugruppen und/oder die Werkstücke in der Beladestation kontinuierlich für den anschließenden Sintervorgang oder Lötvorgang vorbereitet werden. In der Entladestation hingegen können die zum Sintern bzw. Löten notwendigen Hilfsvorrichtungen, wie eine Prozessabdeckung oder Folie, kontinuierlich wieder entfernt werden. Da insbesondere die Arbeitsschritte der Beladestation komplementär in der Entladestation durchgeführt werden, können die beiden Module bevorzugt baugleich, jedoch gespiegelt bzw. komplementär zueinander ausgebildet sein.

In einer bevorzugten Ausführungsform kann die Transporteinheit zum Transport des Fertigungs-Werkstückträgers eine Hubeinheit und eine Unterflurfördereinheit umfassen, wobei der Verfahrweg der Unterflurfördereinheit innerhalb der Anlage, und insbesondere unter Umgehung der Fertigungsstation, insbes. einer gasdichten Prozesskammer, angeordnet ist, und insbesondere unterhalb einer Ebene verläuft, in der ein Beladen und/oder Entladen des Fertigungs-Werkstückträgers und Transport des Fertigungs-Werkstückträgers durch die Fertigungsstation erfolgt. Eine Umgehung der Fertigungsstation ist wie bereits oben erläutert zu verstehen. Durch die Unterflurfördereinheit kann der Fertigungs-Werkstückträger parallel zu den Arbeitspositionen der Beladestation bzw. Entladestation bewegt werden. Dadurch kann Bauraum eingespart werden, da die Rückführung innerhalb der Anlage erfolgen kann. So kann der Fertigungs-Werkstückträger besonders vorteilhaft von der Beladestation zur Entladestation verfahren werden. In der Entladestation kann die weitere Transporteinheit die elektronischen Baugruppen und/oder die Werkstücke aus dem Fertigungs-Werkstückträger aufnehmen, bevor der Fertigungs-Werkstückträger zu der Beladestation zurückgeführt wird.

In einer bevorzugten Ausführungsform kann eine optische Inspektionseinheit vorgesehen sein, die zumindest eine Inspektionskamera umfasst. Die zumindest eine Inspektionskamera kann in der Beladestation und/oder in der Entladestation sein, und kann zumindest eine lagerichtige Ausrichtung der Baugruppen und/oder der Werkstücke in dem Fertigungs-Werkstückträger erfassen und protokollieren. Die Inspektionskamera kann die Drehlage und einen X-Y-Versatz der Werkstücke auf dem Fertigungs-Werkstückträger überprüfen. Bevorzugt kann die Inspektionskamera oder eine zweite Inspektionskamera weiterhin die Drehlage und einen X-Y-Versatz der Werkstücke auf einem Transport-Werkstückträger oder die relative Position der Fügepartner der Werkstücke (DCBs - Direct Copper Bonded) erfassen. Die Inspektionskamera kann mit einer Beleuchtungseinheit versehen sein. Vorteilhaft kann zumindest eine Inspektionskamera an einen Greifarm eines Automatisierungsroboters angeordnet sein, der für ein Umsetzen der Werkstücke vom Transport-Werkstückträger auf den Fertigungs-Werkstückträger sorgt, angeordnet sein. Derartige optische Inspektionskameras können sowohl in der Beladestation als auch in der Entladestation umfasst sein. Die Inspektionseinheit kann eine Aufzeichnung der Lage und des Erscheinungsbildes vor- und nach Verbinden der Werkstücke durchführen. Daneben kann die Inspektionseinheit den Automatisierungsroboter über die Detektion eines X/Y-Versatzes steuern. So kann nach dem Greifen eines Werkstücks durch den Automatisierungsroboter mittels einer ersten Inspektionskamera eine Lagekorrektur des Automatisierungsroboters ermittelt werden. Mit einer zweiten Inspektionskamera kann die exakte Position des Fertigungs-Werkstückträgers ermittelt werden, so dass die Werkstücke ohne Lageversatz und in exakter Ausrichtung im Fertigungs-Werkstückträger ablegbar sind. Somit können Fehlpositionierungen eines Werkstücks im Transport-Warenträgers korrigiert und eine exakte Positionierung im Fertigungs-Werkstückträger sichergestellt werden. Hierzu können auf dem Fertigungs-Werkstückträger eine oder mehrere optische Referenzmarken zur vereinfachten Erfassung durch die Inspektionseinrichtung vorgesehen sein. Die Referenzmarken ermöglichen eine sichere und exakte Erkennung der Lageposition, so dass eine Inspektionskamera mit einer geringen optischen Auflösung oder bei schwierigen Lichtverhältnissen bzw. einer einfachen Hilfsbeleuchtung eingesetzt werden kann. Auch kann eine leichtgewichtige Inspektionskamera beispielsweise an einem Greifarm eingesetzt werden, so dass eine hohe Verfahrgeschwindigkeit und ein geringes Gewicht des Automatisierungsroboters erreicht werden kann.

In einer bevorzugten Ausführungsform kann eine Folienumsetzereinheit umfasst sein, mit zumindest einem, insbesondere zwei oder mehreren Folienumsetzern, die zum automatisierten Aufbringen von Folien als eine Prozessabdeckung in der Beladestation ausgebildet sind. Die Folienumsetzereinheit ist dazu ausgebildet, jeweils eine Folie auf den Fertigungs-Werkstückträger mit den elektronischen Baugruppen und/oder den Werkstücken, bevorzug auf der Maske, aufzulegen. Ein Folienumsetzer kann beispielsweise mit einem Greifer ausgebildet sein, wobei ein Aufnehmen der Folie pneumatische und/oder über Vakuum erfolgen kann. Insoweit kann ein Folienumsetzer als Handlingseinheit angesehen werden, die in der Lage ist, eine Folie, die als vorgeschnittenes Folienstück vorliegen kann, aufzunehmen, und räumlich an einem anderen Ort wieder abzulegen. Beispielsweise kann über einen Vakuumsauger, der an dem Folienumsetzer angeordnet ist, eine Folie aufgenommen werden. Folglich kann das Auflegen der Folie automatisiert bzw. voll automatisiert erfolgen. Ein händischer Eingriff ist nicht notwendig. Dadurch kann ein Reinraum, insbesondere ein ISO 5 Reinraum, ausgebildet werden.

In einer bevorzugten Ausführungsform kann die Folienumsetzereinheit zumindest ein, insbesondere zwei, Folienstapel umfassen, die als Folienmagazin ausgebildet sind und an einer Oberseite eine Entnahmefläche für eine obere Folie aufweisen. Die Folie kann somit ein Einzelfolienelement sein, das passgenau für einen Werkstück-Aufnahmebereich des Fertigungs-Werkstückträgers vorbereitet ist. Der Folienstapel dieser Einzelfolienelemente kann folglich aus einem Stapel einzelner Folien, bereits vorgeschnittenen sein können, ausgebildet sein, die kontinuierlich, insbesondere in einer Arbeitsposition in der Beladestation, auf die Fertigungs-Werkstückträger, welche die Arbeitsposition durchlaufen, aufgelegt werden können. Dafür kann jeweils an der Entnahmefläche, d.h. an der Seite, an der die oberste oder die unterste Folie des Stapels angeordnet ist, die oberste bzw. unterste Folie entnommen werden. Der zumindest eine Folienstapel, insbesondere zwei Folienstapel können neben der bzw. in der Beladestation angeordnet sein. Sind zwei Folienstapel vorhanden, kann besonders vorteilhaft eine unterbrechungsfreie Fließfertigung bereitgestellt werden. So kann ein erster Folienstapel nachgefüllt werden, während von dem zweiten Folienstapel weiterhin Folien entnommen werden können. Die Folienumsetzereinheit mit den Folienstapel sowie den Folienumsetzern kann bevorzugt innerhalb der Anlage angeordnet sein.

Durch den Folienstapel mit vorgeschnittenen Folien kann der Folienzuschnitt optimiert, Abfall reduziert und damit Kosten gespart werden. Bevorzugt können die Folien an die Form des Fertigungs-Werkstückträgers und des Halterahmens angepasst, insbesondere rund, rechteckig, quadratisch oder sechseckig ausgeführt sein. Der Folienwechsel sowie der Wechsel zwischen den beiden Folienstapel erfolgt automatisch, so dass hohe Taktzeiten und praktisch keine Produktionsverzögerung oder -stillstand auftritt. Es kann eine Temperaturhomogenisierung des Folienstapels und der Umgebungstemperatur erreicht werden, was bei Rollenentnahme der Folie nicht gewährleistet ist. Auch können auf dem Folienstapel Folienzuschnitte unterschiedlicher Dicke und Folien- bzw. Materialtypen für eine sequentielle Entnahme vorgesehen sein und leicht angepasst werden. Auch können bei Produktionsbeendigung Foliendummies z.B. als Kunststoff- oder Metallbleiche im Folienstapel vorgesehen sein, so dass kein unnötiger Verschnitt oder ungenutzter Folienabfall anfällt. Die Dicke der Folien kann 1mm oder weniger, insbesondere 0,25 mm oder weniger, bevorzugt 0,1 mm oder weniger, im Speziellen 0,05mm oder weniger betragen, auch kann die Anzahl der Folien im Folienstapel exakt an die Menge der zu verarbeitenden Baugruppen / Bauteilen ausgerichtet werden. Zur Be- und Entladung des Folienstapels könne ESD-Techniken zum elektrostatischen Entladen eingesetzt werden, um ein elektrostatisches Anhaften der Folien aneinander zu verhindern.

Grundsätzlich ist denkbar, eine unterste oder eine oberste Folie von einem Folienstapel zu entnehmen. In einer bevorzugten Ausführungsform kann der Folienstapel über eine Folien-Hebeeinheit verfügen, die ein schrittweises Anheben des Folienstapels in Richtung der Oberseite ermöglicht. Eine oberste Folie des Folienstapels kann auf diese Weise im Wesentlichen auf konstanter Höhe angeordnet werden. Dadurch kann sichergestellt werden, dass der Folienumsetzer jeweils die oberste Folie des Folienstapels erreichen kann, wenn dieser sich auf ein und demselben Verfahrweg, insbesondere kontinuierlich auf der gleichen Höhe, bewegt.

In einer weiteren Ausführungsform kann anstatt der Einzelfolien eine aufgerollte Endlosfolie verwendet werden. Die einzelnen Folienabschnitte bzw. Folien können von der Endlosfolie abgetrennt bzw. abgeschnitten werden. Die Endlosfolie kann beispielsweise auf einer Rolle aufgerollt sein. Durch eine Folieneinzugsrolle kann das vorderste Ende der Endlosfolie gegriffen und durch Rotation der Folieneinzugsrolle zu einer Greifposition geführt werden. Über einen Greifer kann das so erreichbar Ende der Endlosfolie auf ein gewünschtes Längenmaß gezogen werden. Bevorzugt wird während des Ziehens die Folieneinzugsrolle leicht angehoben. Nach Erreichen des gewünschten Längenmaßes wird bevorzugt die Folieneinzugsrolle auf die Folie abgesetzt, um diese zu fixieren. Über den Greifer kann die Folie auf dem gewünschten Längenmaß anschließend gespannt werden und durch einen Trennelement an einer gewünschten Position abgeschnitten werden. Anschließend kann die Folie beispielsweise gereinigt werden, bevor diese auf einen Fertigungs-Werkstückträger aufgelegt wird. In dem die eben beschriebenen Schritte kontinuierlich wiederholt werden, können mehrere Fertigungs-Werkstückträger mit einzelnen Folienabschnitten versehen werden. Die komplette Vorrichtung kann im Bereich der Beladestation, insbesondere an der Arbeitsposition angeordnet sein, an welche die Folie auf den bereits bestückten Fertigungs-Werkstückträger aufgebracht werden soll.

Es wird weiterhin eine Folienumsetzereinheit beschrieben. Die Folienumsetzereinheit eignet sich insbesondere für eine zuvor beschriebene Anlage. Des Weiteren kann die Folienumsetzereinheit unabhängig von der zuvor beschriebenen Anlage verwendet werden und/oder beispielsweise in oder an bestehende Anlagen nachgerüstet werden.

Es wird vorgeschlagen, dass zumindest ein, insbesondere zwei, Folienumsetzer und zumindest ein, insbesondere zwei, Folienstapel umfasst sind. Für die unabhängige Folienumsetzereinheit gelten ebenso die bereits erläuterten Merkmale und Vorteile.

Mit einer Folienumsetzereinheit können insbesondere Folien, insbesondere eine temperaturfeste Ausgleichsfolie z.B. für Temperaturbereiche um 250°C, z.B. eine PTFE-Folie, eine FKM-Folie, eine Silikonfolie, eine PFA-Folie, PI-Folie, Aluminium-Folie, Graphit-Folie oder ähnliche, aufgenommen werden. Der Einsatz solcher Folien wurde bereits erläutert, sie können in einem Sinterverfahren als Prozessabdeckung zwischen einem Sinterkissen oder einem Hartstempel und einer Bauteiloberfläche und/oder einer Abdeckmaske auf den Bauteilen dienen.

In einer bevorzugten Ausführungsform kann eine Reinigungseinheit für eine Reinigung einer obersten und/oder untersten Folie vor dem Umsetzen auf die elektronischen Baugruppen und/oder auf die Werkstücke umfasst sein. Dadurch kann jede Folie, beispielsweise vor einem Aufsetzen auf einen Fertigungs-Werkstückträger mit elektronischen Baugruppen und/oder Werkstücken, mithilfe der Reinigungseinheit gereinigt werden. Die Reinigungseinheit kann beispielsweise zwischen einem Folienstapel und der Position des Fertigungs-Werkstückträgers angeordnet sein.

Beim Abnehmen einer Folie vom Folienstapel können diese - vornehmlich durch statische Aufladung hervorgerufen - aneinander haften. Um dies zu vermeiden, und um auch verschiedene Folienwerkstoffe verwenden zu können, können diese vorteilhaft statisch entladen werden. Diese kann beispielsweise über ein Ionisationssystem z.B. von Keyence Deutschland GmbH, Neu-Isenburg erfolgen. Mit Hilfe einer automatischen Ionenregelung eines Ionisierens werden elektrostatische Ladungen unabhängig von der Polarität, schnell und zuverlässig neutralisiert. Dabei können Entladungsstäbe zum Aufbringen der Ionen mit oder ohne Druckluft betrieben werden.

In einer bevorzugten Ausführungsform kann der Folienstapel als Folienmagazin mit einer Folien-Hebeeinheit ausgebildet sein, sodass eine jeweils oberste Folie des Folienstapels um einen Hub nach oben in Richtung der Oberseite verfahrbar ist, und der Folienumsetzer ein Höhenausgleichsystem aufweist. Beispielsweise kann jeweils nach einer gewissen Anzahl an entnommenen Folien der Folienstapel um einen Hub von 5 mm bis 15 mm, insbesondere 10 mm, nach oben verfahren werden. Die Folien-Hebeeinheit kann beispielsweise nach 5 bis 15, insbesondere 10, entnommenen Folien den Folienstapel um 10 mm nach oben verfahren. Durch das Höhenausgleichsystem kann der Folienumsetzer Abweichungen von der Höhe, auf welcher sich die zu entnehmende oberste Folie befindet, ausgleichen. Dadurch kann der Folienumsetzer quasi eine Toleranz beim Aufnehmen der Folien bereitstellen. Insbesondere kann so die Toleranz der Höhe, auf der sich eine oberste Folie des Folienstapels befindet, ausgeglichen werden.

In einer bevorzugten Ausführungsform kann ein Folienstapel eine Vielzahl an Folien enthalten. Insbesondere kann ein Folienstapel Folien für eine Produktion über einen Zeitraum von beispielsweise 24 Stunden enthalten. Andere Zeiträume sind ebenso denkbar.

In einer bevorzugten Ausführungsform kann die Reinigungseinheit eine Linearreinigungseinheit umfassen oder als berührungslos arbeitendes Oberflächenreinigungssystem ausgebildet sein. Durch die Linearreinigungseinheit kann jeweils eine Folie durch das Reinigungssystem geschoben werden. Dabei kann die Folie beispielsweise zunächst mit einem ersten Folienumsetzer auf die Linearreinigungseinheit aufgelegt werden, dort verschoben und gereinigt werden, und anschließend mit einem zweiten Folienumsetzer wieder von der Reinigungseinheit entnommen werden.

In einer bevorzugten Ausführungsform kann die Reinigungseinheit als berührungsloses arbeitendes Oberflächenreinigungssystem ausgebildet sein. So können Verschmutzungen von dreidimensionalen oder strukturierten Oberflächen vorteilhaft beseitigt werden. Beispielsweise können durch eine pulsierende und hochturbulente Luftströmung Verunreinigungen entfernt werden. Insbesondere können unter Verwendung von Druckluft und/oder Vakuum und/oder ionisierter Luft, insbesondere in dieser Reihenfolge, positive sowie negative Ladungen in die Folie eingebracht werden, um elektrostatische Anhaftungen von Schmutzpartikel auf der Folienoberfläche zu unterbinden.

In einer bevorzugten Ausführungsform kann in der Reinigungseinheit durch ein Einbringen von positiver sowie negativer Ladungen in die Folie, die Folie elektrostatisch entladen werden. Bevorzugt können anschließend über Luft mit hohem Druck, die auf die Folie geblasen wird, die Verunreinigungen bzw. Partikel entfernt werden. Insbesondere werden anschließend die Partikel abgesaugt, beispielsweise durch eine Absaugeinheit. Als Ergebnis liegt die Folie in entladenem Zustand vor, sodass keine Partikel aufgrund elektrostatischer Anziehung anhaften können.

Dieses Verfahren eignet sich insbesondere für temperaturfeste Ausgleichsfolien z.B. für Temperaturbereiche um 250°C, z.B. eine PTFE-Folie, eine FKM-Folie, eine Silikonfolie, eine PFA-Folie, PI-Folie, Aluminium-Folie, Graphit-Folie oder ähnliche Folienarten.

Eine berührungslose Reinigung kann beispielsweise durch pulsierende Druckluft einer Rotationsdüse oder durch eine Flachstrahldüse erfolgen. Diese eignet sich beispielsweise für strukturierte Bauteile. Durch Ionisation können elektrostatischer Ladungen aufgehoben werden, so dass eine elektrostatische Anziehung aufgehoben werden kann. Besonders vorteilhaft hat sich eine Ionisation mit Druckluftunterstützung durch Flachstrahldüsen herausgestellt. Insbesondere kann ein Absaugkanal integriert sein. Derartige Reinigungseinheiten können eine kompakte Bauform für schmale Arbeitsbreiten aufweisen. Diese können auch zur Nachrüstung in bestehende Produktionsanlagen eingesetzt werden.

In einer bevorzugten Ausführungsform kann die Reinigungseinheit als STATIK-AIR Produktreihe der Dr. Escherich GmbH, München ausgebildet sein. Diese bietet eine berührungslos arbeitende Oberflächenreinigung bei Aufhebung elektrostatischer Ladungen und Entfernung störender Staub- und Materialpartikel. Für eine Reinraumanwendung ist ein integrierter Absaugkanal vorgesehen.

Bevorzugt haften einzelne Folien, insbesondere temperaturfeste Ausgleichsfolien z.B. für Temperaturbereiche um 250°C, z.B. PTFE-Folien, FKM-Folien, Silikonfolien, PFA-Folien, PI-Folien, Aluminium-Folien, Graphit-Folien oder vergleichbar, durch positive sowie negative Aufladungen nicht aneinander. Die Folien können so quasi entionisiert vorliegen. Dadurch kann sichergestellt werden, dass durch den Folienumsetzer nur eine oberste Folie von einem Folienstapel entnommen wird.

In einer bevorzugten Ausführungsform kann durch eine Höhenmessung und/oder Dickenmessung ermittelt werden, ob zwei Folien aufgenommen wurden. Die Höhenmessung bzw. Dickenmessung kann beispielsweise als Transparenzmessung ausgebildet sein, wobei durch Ermittlung der optischen Transparenz der aufgenommenen Folie bzw. Folien ermittelt werden kann, ob es sich lediglich um eine Folie handelt. Alternativ kann - um eine Prüfung der zuverlässigen Vereinzelung der Folien zu erreichen - insbesondere nach der Reinigungsstation und vor dem Auflegen der Folie auf den Fertigungs-Werkstückträger bzw. auf die Baugruppe oder die Baugruppen, die Dicke der Folie mechanisch gemessen werden. Dies kann beispielsweise mittels Abtastspitzen z.B. auf der Oberfläche des Folienstapels erfolgen. Dabei kann das Dickenmesssystem für alle Formen, Werkstoffe und Dicken der Abdeckfolien eingesetzt werden. Insbesondere können sowohl opake als auch transparente Folien damit geprüft werden. Somit kann auch bei dicken Ausgleichfolien, sprich Folien zum Höhenausgleich wie z.B. Silikonmatten oder spiegelnden Folien eine Vereinzelungsprüfung durchgeführt werden.

In einer bevorzugten Ausführungsform kann ein erster Folienumsetzer zum Entnehmen einer obersten und/oder untersten Folie von dem Folienstapel und Einlegen in die Reinigungseinrichtung ausgebildet sein, ein zweiter Folienumsetzer zum Entnehmen der Folie aus der Reinigungseinheit und Auflegen auf den Fertigungs-Werkstückträger mit den elektronischen Baugruppen und/oder den Werkstücken ausgebildet sein.

Es wird weiterhin eine Folienablöseeinheit für eine erfindungsgemäße Anlage bechrieben, bevorzugt für eine Folienumsetzereinheit. Es wird vorgeschlagen, dass eine Abschäleinheit zum Ablösen zumindest einer Folie von den elektronischen Baugruppen und/oder den Werkstücken umfasst ist. Die Folienablöseeinheit wird daher bevorzugt in der Entladestation eingesetzt bzw. angeordnet. Ein Ablösen der Folie befolgt bevorzugt nach Durchlaufen der Fertigungsstation, d. h. nach Durchführung eines Sinterprozesses in einer Sinteranlage. Bei Lötanlagen wird in der Regel keine Folie benötigt.

In einer bevorzugten Ausführungsform kann die Folienablöseeinheit relativ zum Fertigungs-Werkstückträger verfahrbar sein, wobei ein Abschälelement unter der Folie, insbesondere unter einem Einzelfolienelement, und ein Halteelement über der Folie), insbesondere über dem Einzelfolienelement, platzierbar ist, sodass ein Ablösen der Folie von den elektronischen Baugruppen und/oder den Werkstücken erfolgt. Bevorzugt wird zunächst der Fertigung-Werkstückträger an die entsprechende Arbeitsposition in der Entladestation gefahren. Die Folie ist bevorzugt als Einzelstück-Folie, d.h. als Einzelfolienelement ausgebildet, die auf einem Folienstapel aufbewahrbar ist, und die bereits auf die Form des Werkstück-Aufnahmebereichs des Fertigungs-Werkstückträger zurechtgeschnitten ist. Diese kann ggf. wiederverwendet werden, dies spart Materialkosten. Anschließend kann mit dem Abschälelement die Folie, bzw. das Einzelfolienelement angehoben und von dem Substrat, d.h. von den Werkstücken bzw. elektronischen Baugruppen, gelöst werden. Das Abschälelement kann beispielsweise als eine Art Schieber ausgebildet sein, der über die komplette Breite der Folie, bzw. des Einzelfolienelements verläuft. Um ein Anheben der Folie und das Anordnen des Abschälelements unter der Folie zu erleichtern, kann die Folie beispielsweise mit einem Saugelement oder ähnlichem an einem vorderen Ende angehoben werden. Während das Abschälelement unter der Folie angeordnet ist, ist bevorzugt das Halteelement oberhalb der Folie platziert, um die Folie zwischen dem Abschälelement und dem Halteelement zu führen. Das Halteelement kann identisch zum Abschälelement in Geometrie und Form ausgebildet sein. Bevorzugt verläuft das Halteelement daher ebenso über die komplette Breite der Folie, sodass die Folie zwischen dem Abschälelement und dem Halteelement geführt werden kann. Wird nun die Folienablöseeinheit relativ zum Fertigungs-Werkstückträger bewegt, wird die Folie über die komplette Länge des Fertigungs-Werkstückträgers von den Werkstücken bzw. elektronischen Bauelementen abgelöst. Durch das Abschälelement werden gleichzeitig die Werkstücke bzw. Bauelemente auf dem Fertigungs-Werkstückträger gehalten. Das Abschälelement und das Halteelement können an den jeweiligen Randbereichen über eine Haltestruktur in Position gehalten werden, wobei die Haltestruktur entlang der Arbeitsposition erfahrbar sein kann. Dafür können beispielsweise außerhalb der Transporteinheit in der Arbeitsposition Schienenelemente angeordnet sein, entlang dieser die Haltestruktur erfahrbar sein kann.

In einer bevorzugten Ausführungsform kann der Fertigungs-Werkstückträger relativ zur Folienablösereinheit bewegbar sein, wobei der Fertigungs-Werkstückträger verfahrbar sein kann, und die Folienablösereinheit fest stehen kann. In einer derartigen Ausführungsform wird bevorzugt der Fertigungs-Werkstückträger auf der Transporteinheit bewegt, während die Folienablöseeinheit an einer festen Position verbleibt. Dadurch kann ebenso die Folie von dem Fertigungs-Werkstückträger abgelöst werden.

In einer alternativen Ausführungsform kann ein Kontaktelement umfasst sein, das mit der zumindest einen Folie kontaktierbar ist, wobei die Folie in einem Bereich vor dem Kontaktelement von einem Greifelement aufnehmbar ist und durch Bewegung des Fertigungs-Werkstückträgers in Richtung des Greifelements von den elektronischen Baugruppen und/oder den Werkstücken entfernbar ist. Insbesondere greift das Greifelement die Folie, während der Fertigungs-Werkstückträger bewegt wird. Die Bewegung des Fertigungs-Werkstückträger erfolgt dabei bevorzugt in Richtung des Greifelements, sodass der Fertigung Werkstückträger quasi unter dem Greifelement hindurchfährt, während die Folie gehalten und von den Fertigungs-Werkstückträger abgelöst wird. Es ist ebenso denkbar, dass das Greifelement während dem Ablösen der Folie von dem Fertigungs-Werkstückträger wegbewegt wird, um das abgelöste Ende der Folie straff zu halten.

In einer bevorzugten Ausführungsform kann das Kontaktelement als eine Rolle ausgebildet sein, wobei durch Bewegung des Fertigungs-Werkstückträger und bei Kontakt mit der Folie eine Abrollbewegung der Rolle über eine Oberfläche der Folie ausführbar ist. Damit kann die Folie kontrolliert von dem Fertigungs-Werkstückträger mit den Werkstücken bzw. Bauelementen abgelöst werden. Gleichzeitig kann dadurch verhindert werden, dass sich die Werkstücke bzw. Bauelemente relativ zum Fertigungs-Werkstückträger bewegen. Das Kontaktelement bzw. die Rolle verläuft bevorzugt über die komplette Breite der Folie bzw. über den kompletten Bereich, an welchem Werkstücke bzw. Baugruppen auf dem Fertigungs-Werkstückträger angeordnet sind. Mit anderen Worten kann die Rolle als eine Art Walze oder Abdruckrolle ausgebildet sein, die eine Positionierung der Bauelemente bzw. Werkstücke auf dem Fertigungs-Werkstückträger während dem Ablösen der Folie gewährleistet. In einer bevorzugten Ausführungsform kann die Rolle an die Anordnung der Werkstücke bzw. Baugruppen auf dem Fertigungs-Werkstückträger angepasst sein. Die Rolle kann beispielsweise ein Negativabdruck mit Vertiefungen und Erhöhungen ausbilden, wobei beim Überrollen über den Fertigungs-Werkstückträger an den Stellen Vertiefungen in der Rolle angeordnet sind, an welchen sich Werkstücke bzw. Baugruppen befinden. Hingegen sind Erhöhungen dort angeordnet, an welchen die Rolle nicht in Kontakt mit den Werkstücken bzw. Baugruppen kommt (da die Folie zwischen der Rolle und den Werkstücken bzw. Baugruppen angeordnet ist, würde die Rolle nicht wirklich in Kontakt mit den Werkstücken bzw. Baugruppen kommen). Dadurch kann eine passgenaue Position der Rolle beim Überrollen des Fertigungs-Werkstückträger gewährleistet werden.

In einer bevorzugten Ausführungsform kann die Rolle über die Breite mehrerer Werkstückträger verlaufen, um mehrere Folien gleichzeitig von mehreren Werkstückträgern abzulösen.

Um das Ablösen der Folie von dem Fertigungs-Werkstückträger zu erleichtern, und insbesondere ein Greifen der Folie durch das Greifelement zu gewährleisten, kann ein Folienheber vorgesehen sein. Dieser kann einen Anschlag ausbilden, gegen welche die Folie bewegt wird, wenn der Fertigungs-Werkstückträger auf der Transporteinheit bewegt wird. Dadurch wird das mit dem Folienheber in Kontakt kommen der Ende der Folie leicht angehoben, und kann hinter dem Folienheber von dem Greifelement leichter aufgegriffen werden.

In einer bevorzugten Ausführungsform kann die Folienablöseeinheit in der Entladestation angeordnet sein. Bevorzugt ist die Folienablöseeinheit in der Arbeitsposition integriert, an welche die Folie von dem Fertigungs-Werkstückträger gelöst werden soll. Das Kontaktelement, der Folienheber sowie das Greifelement können dabei in dieser Arbeitsposition angeordnet sein.

In einer weiteren Ausführungsform weist die Anlage einen Fertigungs-Werkstückträger, der zur Aufnahme von zumindest zwei Werkstücken ausgebildet ist. Es wird vorgeschlagen, dass die zumindest zwei Werkstücke übereinander auf dem Fertigungs-Werkstückträger anordenbar sind. In einer derartigen Ausführungsform sind die zumindest zwei Werkstücke bevorzugt direkt übereinander anordenbar, wobei diese nur durch eine Folie voneinander getrennt sind. Bevorzugt sind die übereinander angeordneten Werkstücke zumindest was Form und Größe des Umfangs der Geometrie der Werkstücke betrifft identisch ausgebildet. Mit anderen Worten bedeutet dies, dass insbesondere zwei gleich große Werkstücke übereinander angeordnet sind. Bei einem Sinterverfahren können dadurch zwei übereinander angeordnete Werkstücke in einem Sintervorgang hergestellt werden, wobei diese durch zumindest eine Folie voneinander getrennt sind und dadurch nicht aneinander anhaften. Die Herstellung von zwei getrennten Werkstücken ist dadurch platzsparend sowie zeitsparend möglich.

In einer bevorzugten Ausführungsform kann zwischen den zumindest zwei Werkstücken eine Folie angeordnet sein. Die Folie dient insbesondere zur Trennung der beiden Werkstücke während eines Sinterverfahrens. Die Folie kann als eine einzelne Folie ausgebildet sein. Ebenso können mehr als eine Folie zwischen den Werkstücken angeordnet werden, wobei diese als Schutzfolie und/der Druckausgleichsfolie ausgebildet sein können.

In einer bevorzugten Ausführungsform können zumindest drei Werkstücke übereinander auf dem Fertigungs-Werkstückträger angeordnet sein. In einer derartigen Ausführungsform können drei übereinander angeordnete Werkstücke zeitgleich gesintert werden. Insbesondere ist dafür zwischen jedem Werkstück zumindest eine Folie angeordnet, um die Werkstücke voneinander zu trennen.

In einer bevorzugten Ausführungsform kann unter dem untersten Werkstück eine Folie angeordnet sein. Dadurch kann eine gezielte Ablösung der gesinterten Werkstücke von dem Fertigungs-Werkstückträger erreicht werden.

In einer bevorzugten Ausführungsform sind mehrere erste Werkstücke nebeneinander auf dem Fertigungs-Werkstückträger, und mehrere zweite Werkstücke oberhalb der ersten Werkstücke auf dem Fertigungs-Werkstückträger angeordnet. Bevorzugt sind jeweils ein erstes Werkstück sowie ein zweites Werkstück direkt übereinander angeordnet, wobei das jeweilige erste Werkstück in der Geometrie, insbesondere der Umfangsform, die jeweiligen zweiten Werkstück entspricht. Während des Sinterverfahrens und der damit einhergehende Druckausübung auf jedes Werkstück können sich ein jeweiliges erstes Werkstück sowie ein jeweiliges zweites Werkstück gegeneinander abstützen. Das Sinterverfahren pro Fertigungs-Werkstückträger kann dadurch optimiert werden.

Der Fertigungs-Werkstückträger kann an unterschiedlichen Positionen in einer Sinteranlage eingesetzt werden. Die Beladung sowie Entladung des Fertigungs-Werkstückträger mit zumindest zwei übereinander angeordneten Werkstücken kann manuell oder automatisch erfolgen. Es ist beispielsweise möglich, den Mehrfachgreifer zum Be- und Entladen heranzuziehen. Ebenso kann ein Roboterarm mit einem einzelnen Greifelement, insbesondere in Kombination mit einem Saugelement, die Werkstücke einzeln greifen.

Des Weiteren betrifft die Erfindung ein Verfahren zum Verbinden von elektronischen Baugruppen und/oder zum Fertigen von Werkstücken nach Anspruch 13, insbesondere zur Fließfertigung.

Es wird vorgeschlagen, dass eine Vorkonfektionierung von elektronischen Baugruppen und/oder Werkstücken durch einen Mehrfachgreifer, durch welchen zumindest zwei elektronische Baugruppen und/oder Werkstücke gleichzeitig auf einem Fertigungs-Werkstückträger in der Beladestation erfolgt. Dies erfolgt als Vorbereitung zu einer Bearbeitung, insbesondere Fügung, in einer Fertigungsstation, insbesondere umfassend ein Vorheizmodul, ein Löt- oder Sintermodul als Fügemodul und/oder ein Abkühlmodul. In der Vorkonfektionierung in der Beladestation erfolgt ein automatisiertes Umsetzen der elektronischen Baugruppen und/oder der Werkstücke durch den Mehrfachgreifer von einem Transport-Werkstückträger auf den Fertigungs-Werkstückträger. Anschließend erfolgt ein automatisiertes Verfahren des Fertigungs-Werkstückträgers von der Beladestation zu zumindest einer Fertigungsstation, ein Entladen der elektronischen Baugruppen und/oder der Werkstücke durch einen Mehrfachgreifer von dem Fertigungs-Werkstückträger in den Transport-Werkstückträger in einer Entladestation nach Durchlauf der elektronischen Baugruppen und/oder der Werkstücke durch die Fertigungsstation, und anschließend ein automatisiertes Rückführen des Fertigungs-Werkstückträgers zu der Beladestation, insbesondere unter Umgehung der Fertigungsstation.

Dies ist, wie bereits bezüglich der Anlage erläutert zu verstehen. Es ist weiterhin denkbar, dass der Fertigungs-Werkstückträger nicht zu der Beladestation, sondern zu einer Entladestation, nach Durchlaufen der Fertigungsstation, geführt wird.

Alternativ kann der Transport-Werkstückträger als Fertigungs-Werkstückträger verwendet werden, insofern ist kein Umsetzen der Bauteile zwischen den verschiedenen Werkstückträgertypen erforderlich und auf einen Rücktransport des Fertigungs-Werkstückträgers kann verzichtet werden.

Für das Verfahren geltende weiterhin dieselben Merkmale sowie Vorteile wie anhand der erfindungsgemäßen Anlage erläutert. Mit dem erfindungsgemäßen Verfahren wird ein automatisierter, insbesondere vollautomatisierter, Ablauf beim Verbinden von elektronischen Baugruppen und/oder beim Fertigen von Werkstücken ermöglicht. Des Weiteren kann auf eine händische Überprüfung einzelner Verfahrensschritte verzichtet werden. Dadurch kann insbesondere ein Reinraum, bevorzugt ein ISO 5 Reinraum, ausgebildet werden.

Das Verfahren kann beispielsweise zur Ausbildung von Lötverbindungen oder Sinterverbindungen von elektronischen Baugruppen und/oder Werkstücken eingesetzt werden. Derartige Sinterverbindungen können eine Alternative zu herkömmlichen Lötverbindungen darstellen und insbesondere in der Leistungselektronik Anwendung finden. Bezüglich der Sinterverbindungen sei auf die Ausführungen bezüglich der Anlage verwiesen.

Zur Ausbildung einer Fließfertigung kann das vorgestellte Verfahren kontinuierlich und wiederholt durchgeführt werden. So kann eine Vielzahl von elektronischen Baugruppen und/oder Werkstücken dem Verfahren unterzogen werden. Insbesondere können dafür mehrere Fertigungs-Werkstückträger in der Beladestation, in bevorzugt gleichen Zeitabständen, vorkonfektioniert bzw. beladen werden.

In der Regel kann ein Transport-Werkstückträger als Fertigungs-Werkstückträger eingesetzt werden, wobei ein separates Rücktransportsystem des Fertigungs-Werkstückträgers zum Anfang der Anlage verzichtet werden kann.

In einer bevorzugten Ausführungsform des Verfahrens kann in der Vorkonfektionierung in der Beladestation ein automatisiertes Umsetzen der elektronischen Baugruppen und/oder der Werkstücke durch den Mehrfachgreifer von einem bauteilspezifischen Transport-Werkstückträger auf einen anlagespezifischen Fertigungs-Werkstückträger erfolgen. Bevorzugt wird dafür der Transport-Werkstückträger in die Beladestation eingefahren, sodass ein Umsetzen innerhalb der Beladestation unter kontrollierbaren Bedingungen stattfinden kann. Derselbe Transport-Werkstückträger kann anschließend zum wieder Aufnehmen der elektronischen Baugruppen und/oder der Werkstücke dienen, nachdem diese die Fertigungsstation durchlaufen haben. Die Umsetzung der elektronischen Baugruppen und/oder der Werkstücke von dem Fertigungs-Werkstückträger auf den Transport-Werkstückträger kann in einer Entladestation durchgeführt werden. Der Fertigungs-Werkstückträger kann Bauteile mehrerer Transport-Werkstückträger aufnehmen.

In einer bevorzugten Ausführungsform des Verfahrens kann in einer Entladestation nach Durchlaufen der elektronischen Baugruppen und/oder der Werkstücke durch die Fertigungsstation, insbesondere vor einem automatisierten Rückführen des Fertigungs-Werkstückträgers von der Beladestation zur Entladestation, ein Entladen der elektronischen Baugruppen und/oder der Werkstücke durch den Mehrfachgreifer von dem Fertigungs-Werkstückträger auf den Transport-Werkstückträger erfolgen. Bevorzugt können in insbesondere gleichen Zeitabständen Fertigungs-Werkstückträger in der Entladestation eintreffen, die jeweils entladen werden. Das Entladen der elektronischen Baugruppen und/oder der Werkstücke von einem Fertigungs-Werkstückträger kann auf einen Transport-Werkstückträger erfolgen, oder auch auf mehrere Transport-Werkstückträger.

In einer weiteren bevorzugten Ausführungsform kann in der Vorkonfektionierung zumindest ein automatisiertes Aufbringen zumindest einer Prozessabdeckung, insbesondere ein Auflegen zumindest einer Maske und/oder zumindest einer Folie, auf die elektronischen Baugruppen und/oder die Werkstücke erfolgen. Bei der Prozessabdeckung kann es sich um eine Maske bzw. Abdeckmaske handeln, die auf die elektronischen Baugruppen und/oder Werkstücke, die auf dem Fertigungs-Werkstückträger angeordnet sind, automatisiert aufgelegt werden kann. Die Aufbringung kann über eine automatisierte Vorrichtung bzw. einen Automatisierungsroboter erfolgen. Bevorzugt kann die Prozessabdeckung zwischen einer Parkposition, insbesondere zum Zwischenlagern der Prozessabdeckung, und zwischen der Position auf dem Fertigungs-Werkstückträger hin und her bewegt bzw. verschoben werden. Des Weiteren gelten ebenso die bezüglich der Anlage genannten Merkmale.

In einer bevorzugten Ausführungsform des Verfahrens kann in der Beladestation in einer ersten Arbeitsposition auf die elektronischen Baugruppen und/oder die Werkstücke, die auf dem Fertigungs-Werkstückträger angeordnet sind, eine Maske als erste Prozessabdeckung automatisiert aufgelegt werden. Des Weiteren kann in einer zweiten Arbeitsposition in der Beladestation eine temperaturfeste Folie auf die Maske als zweite Prozessabdeckung, insbesondere für einen Sinterprozess, automatisiert aufgelegt werden. Es ist auch denkbar, auf die Maske zu verzichten. Optional kann zusätzlich eine weitere Ausgleichsfolie aufgelegt werden. Anschließend kann, insbesondere an einer dritten Arbeitsposition, ein Fixieren der Folie mit der Maske und dem Fertigungs-Werkstückträger automatisiert, bevorzugt mit einem Halterahmen, insbesondere Haltering, erfolgen. Bezüglich der Vorteile sowie weiterer Merkmale ist auf die Ausführungen bezüglich der Anlage verwiesen.

In einer bevorzugten Ausführungsform können in der Entladestation die Arbeitspositionen in umgekehrter Reihenfolge angeordnet sein und in umgekehrter Reihenfolge durchgeführt werden. Da insbesondere dieselben Schritte in der Entladestation komplementär durchgeführt werden, die auch in der Beladestation durchgeführt wurden, können die beiden Module bevorzugt baugleich, jedoch gespiegelt zueinander ausgebildet sein. Ebenso kann die Beladestation gleichzeitig als Entladestation dienen, sofern der Fertigungs-Bauteilträger nach Durchlaufen der Anlage zusammen mit den Bauteilen wieder an den Eingang der Anlage zurückgeführt wird.

In einer bevorzugten Ausführungsform kann das Rückführen des Fertigungs-Werkstückträgers in einer Ebene erfolgen, die unterhalb, oberhalb oder benachbart zu einer horizontalen Ebene angeordnet ist, in der der Fertigungs-Werkstückträger beim Beladen und/oder Entladen und die Fertigungsstation angeordnet ist. Bevorzugt erfolgt die Rückführung durch eine Hubeinheit mit einer Unterflurförderung, wobei der Fertigungs-Werkstückträger über die Hubeinheit vertikal um eine Ebene nach unten oder oben gefahren und anschließend über die Unterflurförderung in Richtung Entladestation befördert wird.

In einer bevorzugten Ausführungsform kann das Rückführen des Fertigungs-Werkstückträgers durch eine erste Transporteinheit erfolgen, und der Transport-Werkstückträger auf einer weiteren Transporteinheit angeordnet sein, die insbesondere automatisiert verfährt, wobei die erste Transporteinheit und die weitere Transporteinheit unabhängig voneinander, und insbesondere unter Umgehung der Fertigungsstation, verfahrbar sind. Unter Umgehung der Fertigungsstation ist eine Umgehung wie bereits bezüglich der Anlage erläutert zu verstehen. Des Weiteren gelten die gleichen Vorteile wie bereits bezüglich der Anlage erläutert.

In einer bevorzugten Ausführungsform kann der Transport-Werkstückträger eine elektronische Baugruppe und/oder ein Werkstück, und der Fertigungs-Werkstückträger mehr als zwei, bevorzugt mehr als fünf, insbesondere sieben oder mehr, im Speziellen vierundzwanzig oder mehr, elektronische Baugruppen und/oder Werkstücke aufnehmen. Somit kann beim Beladen und/oder Entladen der Fertigungs-Werkstückträger an einer Position in der Beladestation verweilen, bis die Transporteinheit den Fertigungs-Werkstückträger mit elektronischen Baugruppen und/oder Werkstücken voll beladen hat.

In einem Fügeprozess unter Prozessatmosphäre, z.B. einem Vakuumsintern oder Vakuumlöten bzw. Diffusionslöten unter Prozessatmosphäre benötigt der notwendige Auf- und Abbau des Vakuums bzw. der Prozessatmosphäre eine Prozesszeit, die zu einer zeitlichen Verzögerung in einer Fließfertigung führt. Die Verzögerung wird bedingt durch ein Öffnen und Schließen von gasdichten Schleusen, dem Auf- und Abbau der Prozessatmosphäre in der oder den Prozesskammern sowie den Aufheiz- und Abkühlvorgängen. Durch eine hohe Anzahl von in einem Werkstückträger sammelbaren Werkstücken kann in der übrigen Fließfertigung weiterhin eine hohe Durchsatzgeschwindigkeit erreicht werden, wobei auch ein relativ zeitintensiver Löt- oder Sinterverfahren unter Prozessatmosphäre parallel eine hohe Zahl Werkstücke gleichzeitig verbinden kann. Es ist weiterhin möglich, dass der Transport-Werkstückträger mehr als eine elektronische Baugruppe und/oder mehr als ein Werkstück aufnehmen kann. So kann eine Taktzeit bei der Fertigung, insbesondere bei einer Fließfertigung, erhöht werden. Die weitere Transporteinheit kann eine höhere Fördergeschwindigkeit des Transports der Transport-Werkstückträger als die erste Transporteinheit der Fertigungs-Werkstückträger aufweisen, insbesondere wenn ein Fertigungs-Werkstückträger Baugruppen mehrerer Transport-Werkstückträger aufnimmt.

In einer bevorzugten Ausführungsform kann in der Beladestation ein Auflegen einer Folie als Prozessabdeckung auf den Fertigungs-Werkstückträger mit den elektronischen Baugruppen und/oder den Werkstücken erfolgen, wobei die Folie entweder eine neue Folie oder eine in einem vorherigen Durchgang des Verfahrens bereits verwendete Folie sein kann. So kann eine bereits verwendete Folie wiederverwendet werden, sodass Material eingespart werden kann. Die Folie kann zur Wiederverwendung von der Entladestation zur Beladestation zurückgeführt werden, insbesondere zusammen mit dem Fertigungs-Werkstückträger zurück zur Beladestation transportiert und dort neu verwendet werden. Ebenso kann die Folie direkt nach dem Entnehmen auf einen Folienstapel aufgelegt werden, wobei der komplette Folienstapel nach Aufnahme einer gewissen Anzahl an Folien zur Beladestation zurückgeführt werden kann. Dies kann über eine Verfahreinheit erfolgen, die bevorzug parallel zu einem Verfahrweg der Fertigungs-Werkstückträger zwischen der Beladestation, der Fertigungsstation und insbesondere der Entladestation verläuft. Vorzugsweise können bereits genutzte Folien durch eine Reinigungseinheit vor einer nächsten Verwendung gereinigt werden.

Es ist auch denkbar, dass nicht eine einzelne Folie auf den Fertigung-Werkstückträger aufgelegt wird, sondern dass pro Werkstück, oder Gruppe von Werkstücken auf dem Fertigungs-Werkstückträger ein Folienstück, d.h. mehrere vereinzelte Folienstücke aufgelegt wird. Die Folienstücke können hintereinander oder gleichzeitig auf die mehreren Werkstücke aufgelegt und in der Entladestation wieder entnommen werden.

In einer bevorzugten Ausführungsform kann die Folie mit einem Folienumsetzer von einem Folienstapel entnommen und auf die elektronischen Baugruppen und/oder die Werkstücke aufgelegt werden, wobei der Folienstapel schrittweise in Richtung einer Oberseite des Folienstapels nach oben verfahren wird, sodass die jeweils oberste Folie mit dem Folienumsetzer erreichbar ist. Für den Folienumsetzer gelten die bereits erläuterten Merkmale und Vorteile bezüglich der Anlage sowie der Folienumsetzereinheit analog. Bevorzugt wird im Rahmen der Entnahme automatisch geprüft, dass nur eine Folie, oder eine vorbestimmte Anzahl von Folien entnommen wird. Dies kann beispielsweise optisch durch Messung einer Transparenz der entnommenen Folie oder des entnommenen Folienstapels und Vergleich mit Referenztransparenzwerten erfolgen. Alternativ oder zusätzlich kann die Dicke der entnommenen Folie bzw. des entnommenen Folienstapels bestimmt werden. Somit kann sichergestellt werden, dass zum einen die richtige Folie entnommen und zum anderen nur eine bzw. eine gewünschte Anzahl von Folien entnommen wird. Beispielsweise kann mittels eines hochpräzisen digitalen Messtasters die Dicke von beliebigen Folienarten sicher und schnell gemessen werden. Dies kann farbunabhängig und für transparente oder opake Folien, auch bei gewellten oder planen Folien eingesetzt werden. So kann beispielsweise eine Messposition am Rand bestimmt werden, und eine Folienstapelhöhe vor und nach der Entnahme oder die Dicke der Folie auf einer Referenzebene bestimmt werden. So kann beispielsweise ein Messtaster mit 1µm Genauigkeit, wie z.B. ein Keyence GT2 digitaler Messtaster eingesetzt werden. Bei Verwendung von Messtastern kann von einer hohen Präzision bzw. hoher Wiederholgenauigkeit ausgegangen werden. Wenn das Messobjekt auf keinen Fall verkratzt werden darf, können schonende Modelle oder verschiedene Spindelspitzen verwendet werden. Es sind hohe Lebensdauer mit über 20 Millionen Zyklen im Dauereinsatz und automatische Berechnung mit mehreren Messtastern möglich.

In einer bevorzugten Ausführungsform kann der Folienstapel nach einer gewissen Anzahl an entnommenen Folien um einen Hub von 5 mm bis 15 mm, insbesondere 10 mm, nach oben verfahren werden, wobei insbesondere nach 5 bis 10 entnommenen Folien der Folienstapel nach oben verfahren wird. So kann der Folienumsetzer gezielt eine jeweils oberste Folie des Folienstapels greifen, auch wenn der Folienstapel über einen Zeitraum eine unterschiedliche Anzahl an Folien aufweist.

In einer bevorzugten Ausführungsform kann vor dem Auflegen der Folie auf den Fertigungs-Werkstückträger mit den elektronischen Baugruppen und/oder den Werkstücken ein automatisiertes Reinigen der Folie mittels einer Reinigungseinheit erfolgen. Bevorzugt kann jede Folie vor dem Auflegen auf den Fertigungs-Werkstückträger mit den elektronischen Baugruppen und/oder Werkstücken der Reinigungseinheit zugeführt werden. Die Reinigungseinheit befindet sich dafür bevorzugt innerhalb eines geschlossenen Raumes, insbesondere eines Reinraums, in dem das Verfahren durchgeführt wird.

In einer bevorzugten Ausführungsform kann in der Reinigungseinheit die Folie elektrostatisch entladen werden und anschließend können Verunreinigungen durch Abblasen mit Druckluft und / oder Unterdruck entfernt werden. Die Reinigungseinheit kann beispielweise eine berührungslose Oberflächenreinigung durchführen. So können Verschmutzungen von dreidimensionalen oder strukturierten Oberflächen vorteilhaft beseitigt werden. Beispielsweise können durch eine pulsierende und hochturbulente Luftströmung Verunreinigungen entfernt werden. Insbesondere können unter Verwendung von Druckluft und/oder Unterdruck bis zum Vakuum und/oder ionisierter Luft, insbesondere in dieser Reihenfolge, positive sowie negative Ladungen in die Folie eingebracht werden. Dadurch kann vorteilhafterweise ein Haften zwischen einzelnen Folien weiter unterstützend vermieden werden.

In einer bevorzugten Ausführungsform können zumindest zwei oder auch mehrere Folienstapel nebeneinander angeordnet sein, wobei ein zweiter oder ein weiterer Folienstapel an eine Position eines ersten oder vorhergehenden Folienstapels bewegt wird, sobald der erste bzw. vorhergehende Folienstapel keine Folien mehr enthält, sodass ein unterbrechungsfreier Verfahrensablauf gewährleistet wird. Auch können die verschiedenen Folienstapel unterschiedliche Folien für verschiedene Werkstücke aufnehmen, so dass eine Fließfertigung von pro Werkstückträger verschiedenen Werkstücken möglich ist. Während Folien von dem ersten Folienstapel entnommen werden, kann der zweite Folienstapel nachgefüllt werden, oder andersherum. Ein Folienstapel kann beispielsweise Folien enthalten, die für eine Produktion bzw. Fertigung mit dem Verfahren über einen Zeitraum von 24 Stunden ausreichen. Ebenso sind andere Zeiträume beziehungsweise anders dimensionierte Folienstapel denkbar. Denkbar ist auch, dass in einem Folienstapel eine vorbestimmte Reihenfolge verschiedener Folien synchron zu einer geplanten Bearbeitungsreihenfolge von z.B. verschiedenen Werkstücken enthalten ist.

In einer bevorzugten Ausführungsform des Verfahrens kann in der Entladestation ein Entfernen der Folie durch eine Folienablösereinheit erfolgen. Für das Verfahren mit einer Folienablösereinheit gelten dieselben Vorteile und Merkmale wie bezüglich der Ausführungsformen der Folienablösereinheit erläutert.

**In** einer bevorzugten Ausführungsform des Verfahrens kann eine lagerichtige Ausrichtung der Baugruppen und/oder der Werkstücke zumindest in dem Fertigungs-Werkstückträger optisch erfasst und protokolliert werden. Hierzu kann eine Inspektionseinrichtung vorgesehen sein, die mittels zumindest einer Inspektionskamera eine exakte Lage und Ausrichtung eines Werkstücks im Fertigungs-Werkstückträger erfassen und in Kombination mit einem Automatisierungsroboters korrigieren kann. Durch die Inspektionseinrichtung kann ein Automatisierungsroboter, der ein Einsetzen oder Korrektur der Lage der Werkstücke in dem Fertigungs-Werkstückträger vornimmt, korrigiert werden. Insbesondere kann bei einem Umsetzen von Werkstücken von einem Transport-Werkstückträger in einem Fertigungs-Werkstückträger eine Drehausrichtung und exakte Lage überprüft und korrigiert werden. Denn beim Verbinden der Werkstücke, insbesondere Sintern oder Diffusionslöten ist eine exakte Ausrichtung höchstwesentlich und kann durch die optische Inspektionseinrichtung sichergestellt und protokolliert werden. Hierzu können auf dem Fertigungs-Werkstückträger eine oder mehrere optische Referenzmarken zur vereinfachten Erfassung durch die Inspektionseinrichtung vorgesehen sein.

Gegenstand der Erfindung ist weiterhin ein Verfahren zum Beladen eines Werkstückträger mit einem Stapel von Werkstücken oder Ebenen von Werkstücken. Es wird vorgeschlagen, dass das Verfahren die folgenden Schritte umfasst: Beladen des Fertigungs-Werkstückträger mit zumindest einem ersten Werkstück oder einer ersten Ebene von Werkstücken, anschließendes Auflegen einer Folie und/oder eines Druckkissens bzw. Ausgleichsfolie auf das erste Werkstück bzw. die erste Ebene von Werkstücken, anschließend erneutes Beladen mit zumindest einem zweiten Werkstück bzw. einer zweiten Ebene von Werkstücken oberhalb der Folie bzw. des Druckkissens bzw. Ausgleichsfolie und oberhalb des bereits angeordneten ersten Werkstücks, anschließendes Auflegen einer weiteren Folie und/oder eines Druckkissens bzw. Ausgleichsfolie auf das zweite Werkstück bzw. die zweite Ebene von Werkstücken. Die beschriebenen Schritte können beliebig oft wiederholt werden, sodass mehrere Werkstücke übereinander angeordnet werden können. Durch dieses Verfahren können mehrere übereinander angeordnete Werkstücke gemeinsam gesintert werden, wodurch Zeit sowie Kosten eingespart werden können.

Vorteilhaft kann vor dem Beladen zunächst eine Folie auf den Werkstückträger aufgesetzt werden. Auch kann sowohl oberhalb als auch unterhalb jedes Drucckissens bzw. Ausgleichsfolie eine Trennfolie angeordnet sein. Ein Druckkissen / bzw. Ausgleichsfolie kann aus Silikon oder einem vergleichbaren hitzebeständigen, kompressiblen Material bestehen. Bei Druck- und Temperaturbeaufschlagung können Kissenbestandteile auf dem Werkstückträger und/oder den Werkstücken anhaften und diese verschmutzen. Um dies zu verhindern, kann eine Kontaktfläche des Druckkissens mit dem Werkstückträger und/oder mit dem Werkstück durch eine Folie geschützt werden.

In einer weiteren Ausführungsform des Verfahrens kann in der Beladestation eine Zentriervorrichtung angeordnet sein, wobei die Zentriervorrichtung eine Ausrichtung sowie Zentrierung des Fertigungs-Werkstückträgers ausführt. Dadurch kann der Fertigungs-Werkstückträger zu den Werkstücken/Bauteilen exakt ausgerichtet werden.

In der Entladestation können sinngemäß die Schritte zum Beladen eines mehrlagigen Sinterstapels von Werkstücken zum Entladen gegenläufig vorgenommen werden. So kann zuerst eine Folie und/oder ein Druckkissen bzw. Ausgleichsfolie von einem oberen Stapel von Werkstücken aus einem Fertigungs-Werkstückträgers entnommen werden, anschließend das obere Werkstück bzw. die obere Ebene von Werkstücken entnommen werden. Anschließend kann eine weitere Folie und/oder ein weiteres Druckkissens bzw. eine weitere Ausgleichsfolie entnommen und ein weiteres Werkstück bzw. eine weitere Ebene von Werkstücken aus dem Fertigungs-Werkstückträgers entnommen werden, bis der gesamte Werkstückträger geleert ist.

In einer bevorzugten Ausführungsform des Verfahrens können die unterschiedlichen Schritte an zwei beliebigen Arbeitspositionen innerhalb der Beladestation einer erfindungsgemäßen Anlage durchgeführt werden. Der Fertigungs-Werkstückträger wird insbesondere über die Transporteinheit zwischen den zwei Arbeitspositionen hin und her bewegt. Insbesondere erfolgt an der ersten Arbeitsposition das Beladen des Fertigungs-Werkstückträger mit dem zumindest einen Werkstück, und an der zweiten Arbeitsposition das Auflegen der Folie. Bei Durchführung des erfindungsgemäßen Verfahrens kann der Fertigungs-Werkstückträger dabei zwischen den zwei Arbeitsposition hin und her bewegt werden, um abwechselnd zumindest ein Werkstück und zumindest eine Folie aufzulegen.

In einer bevorzugten Ausführungsform des Verfahrens können mehrere erste Werkstücke auf dem Fertigungs-Werkstückträger nebeneinander angeordnet werden, bevor eine erste Folie und/oder ein Druckkissen bzw. eine Ausgleichsfolie aufgelegt wird. In einem darauf folgenden Schritt können mehrere zweite Werkstücke auf die erste Folie oder ein Druckkissen bzw. Ausgleichsfolie aufgelegt werden, wobei die zweiten Werkstücke direkt oberhalb der ersten Werkstücke angeordnet werden, sodass sich die Werkstücke während des Sinterverfahrens, d.h. während der Druckaufbringung, gegeneinander abstützen. Auf einer sogenannten gestapelten Anordnung können mehrere Lagen von Werkstücken, bevorzugt getrennt durch Folie und/oder Druckkissen bzw. Ausgleichsfolie auf einen Werkstückträger übereinander gesintert werden, wodurch Zeit und Kosten enorm reduziert werden können. Zwischen den Lagen der Werkstücke kann eine Folie und/oder ein Druckkissen bzw. eine Ausgleichsfolie angeordnet werden. Das Umsetzen und Stapel der Lagen von Werkstücken erfolgt zweckmäßigerweise mit einem Mehrfachgreifer.

In einer bevorzugten Ausführungsform eines Beladeverfahrens kann vor Auflegen der Folie eine Ausrichtung des zumindest ersten Werkstücks, insbesondere mehrerer Werkstücke, bevorzugt alle aufgegriffenen Werkstücke, durch den Mehrfachgreifer und/oder eine Ausrichteeinheit erfolgen, sodass das zumindest eine Werkstück/Bauteil in einer horizontalen Ebene quer und/oder längs zu einer Achse des Mehrfachgreifers ausgerichtet wird. Die Ausrichtung durch den Mehrfachgreifer kann beispielsweise mit Greifelementen erfolgen, wie bezüglich der Vorrichtung beschrieben. Des Weiteren kann die Ausrichteeinheit wie bezüglich der Vorrichtung beschrieben ausgebildet sein.

In einer weiteren bevorzugten Ausführungsform eines Beladeverfahrens kann eine Ausrichtung des Fertigungs-Warenträgers bzw. einer in einem Transportrahmen aufgenommenen Baseplate des Fertigungs-Werkstückträgers durch eine Zentriervorrichtung erfolgten. Somit kann, bevorzugt vor dem Beladen des Fertigungs-Werkstückträgers, dieser, bzw. eine in einem Transportrahmen des Fertigungs-Werkstückträgers aufgenommenen Baseplate, exakt ausgerichtet werden. Dies dient zur lageexakten Ausrichtung des Fertigungs-Werkstückträgers bzw. der Baseplate gegenüber einer Transporteinheit bzw. einer Verfahreinheit der Transporteinheit.

Die beiden vorgenannten Beladeverfahren dienen einer exakten lagerichtigen Ausrichtung und Positionierung von Werkstücken bzw. elektronischen Baugruppen auf dem Fertigungs-Werkstückträger. Dies ist für die weitere Bearbeitung in einer nachfolgenden Fertigungsstation essentiell. So kann in einer Fertigungsstation ein Pressenvorgang mit einer Mehrzahl von Pressenstempeln durchgeführt werden, z.B. ein Sinter- oder Diffusionslötverfahren, wobei eine exakte Positionierung und Ausrichtung der Baugruppen bzw. Werkstücken gegenüber der Pressenstempel entscheidend für die Verbindungsqualität ist. Eine Ausrichtung der Werkstücke auf dem Fertigungs-Werkstückträger und eine weitere Ausrichtung des Fertigungs-Werkstückträgers bzw. einer darin umfassten Baseplate gegenüber der Transporteinheit bzw. einer Verfahreinheit der Transporteinheit stellt in der Beladestation einer späteren Ausrichtung der Werkstücke bzw. der elektronischen Baugruppen gegenüber den Pressenstempeln sicher.

Allgemein kann gesagt werden, dass die erfindungsgemäßen Vorteile mit all den unterschiedlichen Ausführungen, die insbesondere bei Sinter- oder Lötanlagen eingesetzt werden, erreicht werden können.

Zum einen kann durch den Einsatz zumindest eines Mehrfachgeifers, insbesondere zumindest einen Vierfachgreifer, ein zeit- und kostensparendes Umsetzen von Werkstücken oder elektronischen Baugruppen erzielt werden. Dier Mehrfachgreifer kann in der Beladestation und/oder in der Entladestation eingesetzt werden. Insbesondere wird ein Mehrfachgreifer zumindest in der Beladestation eingesetzt, um die Werkstücke oder elektronischen Baugruppen von einem Transport-Werkstückträger auf einen Fertigungs-Werkstückträger umzusetzen. Vorteilhaft kann in der Entladestation derselbe oder ein weiterer Mehrfachgreifer zum Entladen eingesetzt werden.

Weiterhin kann mit der Folienumsetzereinheit und/oder mit der Folienablöseeinheit ein Auflegen, Entfernen sowie Reinigen der Folie durch zeitsparendes Auflegen und Entfernen sowie kostensparendes Wiederverwenden der Folie verbessert werden. Dafür kann auch eine Vorrichtung und ein Verfahren zum Abschneiden einer Folie von zumindest einer Rolle unterstützend verwendet werden.

Mit der Folienablöseeinheit und weiteren Verfahren zur Folienentfernung kann demnach eine Folienentfernung durch Abschälen, insbesondere eine Sinterfolienentfernung, erreicht werden und ein Verkleben mit Substrat, wie den Werkstücken und/oder den elektronischen Baugruppen, oder ein Verhaken miteinander vermieden werden.

Durch eine Stapelbeladung mehrerer Werkstücke und/oder elektronsicher Bauteile übereinander zur Ausbildung eines Prozessstapels von Werkstücken bzw. elektronischen Baugruppen kann ebenso Zeit und Material eingespart werden.

Diese vorgenannten Ausführungen können einzeln oder gemeinsam in der betreffenden erfindungsgemäßen Anlage eingesetzt bzw. umgesetzt werden. Daher können mit der erfindungsgemäßen Anlage die jeweiligen Vorteile und Merkmale umgesetzt werden. Insgesamt wird daher ein gemeinsames erfinderisches Konzept dargelegt.

Die beschriebenen Merkmale sowie Vorteile gelten ebenso für die erfindungsgemäße Anlage sowie für das erfindungsgemäße Verfahren. Dabei können die Merkmale verschieden untereinander kombiniert werden.

### ZEICHNUNGEN

Weitere Vorteile ergeben sich aus den vorliegenden Zeichnungen und Zeichnungsbeschreibungen. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigt:
- **Fig. 1**: eine Ausführungsform einer erfindungsgemäßen Anlage zum Verbinden von elektronischen Baugruppen und/oder Fertigen von Werkstücken mit mehreren Modulen;
- **Fig. 2**: die Anlage aus Fig. 1 in einer Draufsicht;
- **Fig. 3**: eine Ausführungsform eines Moduls einer erfindungsgemäßen Anlage, das als Beladestation ausgebildet ist;
- **Fig. 4**: das Modul aus Fig. 3 in einer Draufsicht mit der Darstellung unterschiedlicher Arbeitspositionen und eine Ausführungsform einer weiteren Transporteinheit;
- **Fig. 5**: ein Ablaufplan möglicher unterschiedlicher Arbeitsschritte in der Beladestation aus Fig. 4;
- **Fig. 6**: eine Ausführungsform eines Moduls einer erfindungsgemäßen Anlage, das als Entladestation ausgebildet ist;
- **Fig. 7**: das Modul aus Fig. 6 in einer Draufsicht mit der Darstellung unterschiedlicher Arbeitspositionen und eine Ausführungsform einer Transporthubeinheit;
- **Fig. 8**: ein Ablaufplan möglicher unterschiedlicher Arbeitsschritte in der Entladestation aus Fig. 7;
- **Fig. 9**: eine Ausführungsform einer Folienumsetzereinheit mit zwei Folienumsetzern mit Darstellung von zwei Folienstapeln;
- **Fig. 10**: die Folienumsetzereinheit aus Fig. 9 in einer Draufsicht;
- **Fig. 11**: ein Ablaufplan möglicher unterschiedlicher Arbeitsschritte in der Folienumsetzereinheit aus Fig. 10;
- **Fig. 12**: eine Ausführungsform eines Höhenausgleichssystems eines Folienstapels und eines Folienumsetzers.;
- **Fig. 13**: eine weitere Ausführungsform einer Beladestation in einer Draufsicht
- **Fig. 14**: mit einer Folienumsetzereinheit und einer optischen Inspektionseinheit; eine weitere Ausführungsform einer Entladestation mit einer optischen Inspektionseinheit;
- **Fig. 15a ,b**: eine Draufsicht auf eine Ausführungsform eines Fertigungs-Werkstückträger mit optischen Referenzmarken;
- **Fig. 16**: perspektivisch eine Kombination eines Fertigungs-Werkstückträger mit Werkstücken, Prozessabdeckung und Halterahmen;
- **Fig. 17**: eine weitere Ausführungsform einer erfindungsgemäßen Anlage zum Verbinden von elektronischen Baugruppen und/oder Fertigen von Werkstücken mit mehreren Modulen;
- **Fig. 18**: die Anlage aus Fig. 17 in einer Frontansicht;
- **Fig. 19**: eine weitere Ausführungsform eines Moduls einer erfindungsgemä-ßen Anlage, das als Beladestation ausgebildet ist;
- **Fig. 20**: das Modul aus Fig. 19 in einer Draufsicht mit der Darstellung unterschiedlicher Arbeitspositionen;
- **Fig. 21**: eine weitere Ausführungsform eines Moduls einer erfindungsgemä-ßen Anlage, das als Entladestation ausgebildet ist;
- **Fig. 22**: das Modul aus Fig. 21 in einer Draufsicht mit der Darstellung unterschiedlicher Arbeitspositionen;
- **Fig. 23**: eine Beladestation einer weiteren Ausführungsform für eine Sinterbearbeitung;
- **Fig. 24**: eine Entladestation einer weiteren Ausführungsform für eine Sinterbearbeitung;
- **Fig. 25**: eine Ausführungsform einer Folienablöseeinheit;
- **Fig. 26**: eine weitere Ansicht der Ausführungsform aus Fig. 25;
- **Fig. 27**: eine weitere Ausführungsform einer Folienablöseeinheit;
- **Fig. 28**: eine weitere Ansicht der Ausführungsform aus Fig. 27;
- **Fig. 29**: eine Ausführungsform eines Kontaktelements;
- **Fig. 30**: eine weitere Ansicht der Ausführungsform aus Fig. 29;
- **Fig. 31**: eine weitere Ausführungsform einer Folienablöseeinheit;
- **Fig. 32**: eine weitere Ausführungsform einer Folienablöseeinheit;
- **Fig.** 33: eine Ausführungsform eines Mehrfachgreifers;
- **Fig. 34**: eine Ausführungsform eines Fertigungs-Werkstückträgers;
- **Fig. 35**: eine weitere Ausführungsform eines Mehrfachgreifers;
- **Fig. 36**: eine weitere Ausführungsform eines Mehrfachgreifers;
- **Fig. 37**: eine weitere Ansicht der Ausführungsform aus Fig. 36;
- **Fig. 38**: eine Ausführungsform einer Beladestation mit Mehrfachgreifer;
- **Fig. 39**: eine Ausführungsform einer Entladestation;
- **Fig. 40**: eine Ausführungsform eines Fertigungs-Werkstückträgers mit übereinander gelagerten Werkstücken bzw. elektronischen Bauelementen;
- **Fig.41**: eine weitere Ausführungsform eines Fertigungs-Werkstückträgers mit übereinander gelagerten Werkstücken bzw. elektronischen Bauelementen;
- **Fig. 42**: eine weitere Ausführungsform eines Fertigungs-Werkstückträgers mit übereinander gelagerten Werkstücken bzw. elektronischen Bauelementen;
- **Fig. 43**: einen Ausschnitt eine Ausführungsform einer Beladestation mit einem Mehrfachgreifer und einer Ausrichteeinheit;
- **Fig. 44**: eine Ausführungsform eines Mehrfachgreifers während dem Betrieb;
- **Fig. 45**: eine Schnittdarstellung durch einen Greifarm eines Mehrfachgreifers;
- **Fig. 46**: einen Ausschnitt eine Ausführungsform einer Beladestation mit einem Mehrfachgreifer und einer Ausrichteeinheit im Betrieb;
- **Fig. 47**: einen Ausschnitt eines Mehrfachgreifers mit einer Ausrichteeinheit;
- **Fig. 48**: einen Ausschnitt einer Beladestation mit einer Zentriervorrichtung;
- **Fig. 49**: eine Draufsicht auf eine Beladestation mit einer Zentriervorrichtung;
- **Fig. 50**: eine Schnittdarstellung durch eine Beladestation mit einer Zentriervorrichtung;
- **Fig. 51**: eine weitere Ansicht einer Beladestation mit einer Zentriervorrichtung;
- **Fig. 52**: die Ansicht aus Fig. 51 ohne Werkstückträger
- **Fig. 53**: eine Detailansicht der Zentriervorrichtung;
- **Fig. 54**: eine weitere Detailansicht der Zentriervorrichtung.

In den Figuren sind gleiche oder gleichartige Komponenten mit gleichen Bezeichnungen beziffert.

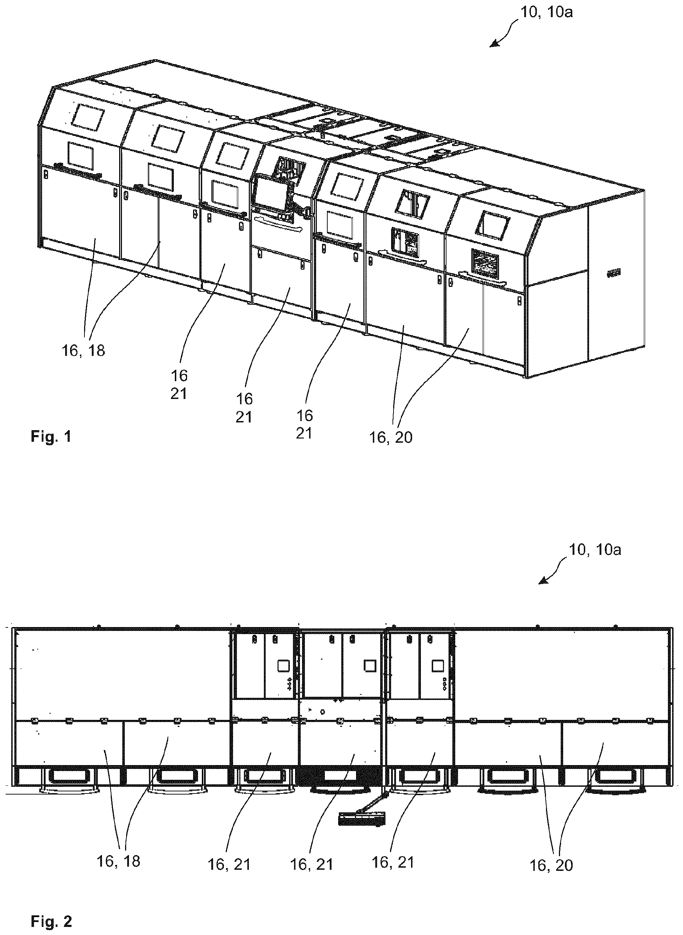

**Fig. 1** zeigt eine Ausführungsform einer erfindungsgemäßen Anlage 10 zum Verbinden von elektronischen Baugruppen 12 und/oder Werkstücken 14. Die Anlage 10 weist mehrere Module 16 auf. Eine derartige Anlage 10 kann beispielsweise eine Sinter- oder Lötanlage 10a ausbilden. In diesem Zusammenhang kann unter Sintern, wie bereits erwähnt, ebenso das Herstellen oder Verändern von Werkstoffen unter hohem Druck sowie Temperatur, wie auch das Verbinden von mehreren Elementen als Fügeprozess verstanden werden. Durch eine derartige Anlage 10 können beispielsweise temperaturbeständige Sinterverbindungen oder Lötverbindungen hergestellt werden. In dieser Ausführungsform zeigt die Anlage 10 fünf Module 16. Das erste Modul 16 ist als Beladestation 18 ausgebildet. Daran schließt sich eine Fertigungsstation 21 mit beispielsweise einem Vorheizmodul, einem Sintermodul und einem Abkühlmodul an. Das Modul 16 am rechten Ende der Anlage 10 ist als Entladestation 20 ausgebildet. Zur Ausbildung eines Reinraums, insbesondere eines ISO 5 Reinraums, ist die Anlage bevorzugt als geschlossene Kammer und/oder gasdicht ausgebildet. Bevorzugt sind daher die Module 16 untereinander verbunden, jedoch gegenüber äußeren Einflüssen in einem gemeinsamen Gehäuse geschützt.

**Fig. 2** zeigt die Anlage 10 aus Fig. 1 in einer Draufsicht. Dabei sind die einzelnen Kammern der Module 16 erkennbar. Die Anlage 10 ist insgesamt länglich ausgebildet, sodass ein Fertigungs-Werkstückträger 22 mit elektronischen Baugruppen 12 und/oder Werkstücken 14 in einer Richtung, insbesondere auf einer geraden Linie bzw. einem geradlinigen Fahrweg, die Anlage 10 durchlaufen kann. Die elektronischen Baugruppen 12 und/oder Werkstücke 14 können beispielsweise von der in der Darstellung linken Seite der Anlage 10 dieser zugeführt werden. Anschließend können die elektronischen Baugruppen 12 und/oder Werkstücke 14 auf der in der Darstellung rechten Seite aus der Anlage 10 wieder entnommen werden.

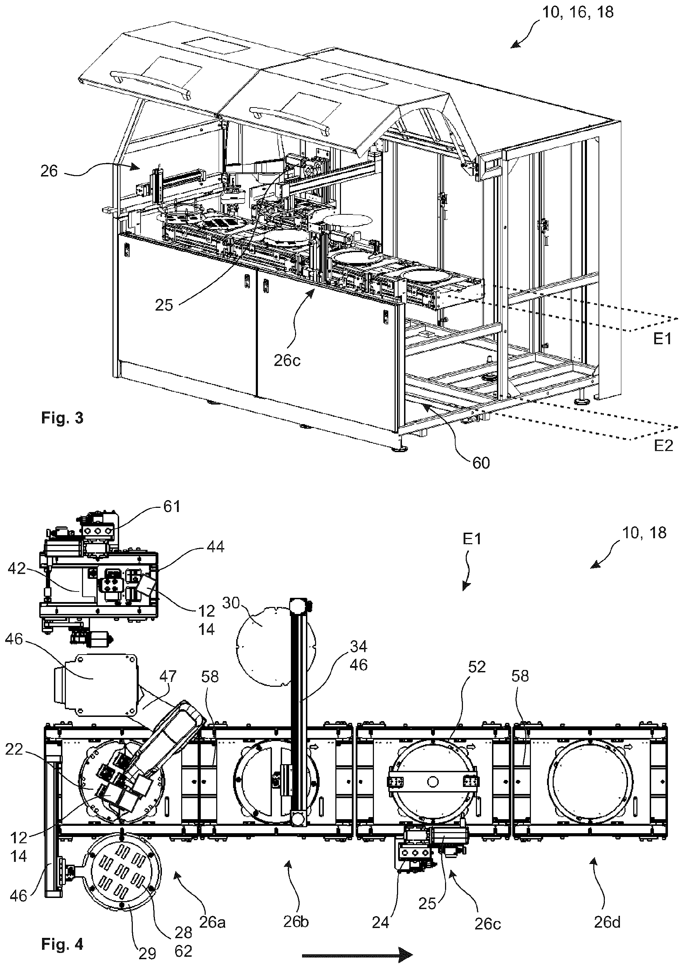

**Fig. 3** zeigt ein Modul 16 einer erfindungsgemäßen Anlage 10, das als Beladestation 18 ausgebildet ist. Das Gehäuse der Beladestation 18 ist auf der Vorderseite geöffnet dargestellt. Dadurch sind einzelne Arbeitspositionen 26 der Beladestation 18 erkennbar. Diese sind in einer oberen bzw. mittleren Ebene E1 innerhalb der Beladestation 18 angeordnet. Unterhalb dieser Ebene E1 ist eine Unterflurfördereinheit 60 einer Transporteinheit 24 erkennbar, die in Ebene E2 angeordnet ist. Mit dieser können die Fertigungs-Werkstückträger 22 rückgeführt werden. Dies bedeutet, dass die Fertigungs-Werkstückträger 22 die Arbeitspositionen 26 in einer gegenläufigen Richtung bezüglich einer Transportrichtung der Transporteinheit 24 durchlaufen. In dieser Darstellung ist eine Hubeinheit 25 der Transporteinheit 24 in Ebene E1 erkennbar. Diese ist mit der Unterflurfördereinheit 60 verbunden. Um die Fertigungs-Werkstückträger 22 von der unteren Ebene E2, in der die Unterflurfördereinheit 60 angeordnet ist, in die obere Ebene E1, in der die Arbeitspositionen 26 angeordnet sind, zu befördern, kann die Hubeinheit 25 eingesetzt werden. Die Hubeinheit 25 kann durch einen Hub von Ebene E1 in Ebene E2, oder andersherum, die Fertigungs-Werkstückträger 22 befördern. In dieser Ausführungsform ist die Hubeinheit 25 an der Arbeitsposition 26c angeordnet. Folglich können die Fertigungs-Werkstückträger 22 an diese Arbeitsposition 26c geführt werden. In einer davon abweichen Ausführungsform kann durch die Hubeinheit 25 der Fertigungs-Werkstückträger 22 an jede beliebige Arbeitsposition 26a- 26d rückgeführt werden. Somit ist ein geschlossener Transportkreislauf der Fertigungs-Werkstückträger 22 durch die Fertigungsstation 21 gegeben.

In **Fig. 4** ist die Beladestation 18 aus Fig. 3 in einer Draufsicht mit der Darstellung unterschiedlicher Arbeitspositionen 26 und mit einer Ausführungsform einer zweiten Transporteinheit 42 dargestellt. Dargestellt ist die obere Ebene E1 in einer Draufsicht. Aus den Figs. 3 und 4 ist ersichtlich, dass die Arbeitspositionen 26a-26d auf dieser oberen Ebene E1 angeordnet sind.

In Arbeitsposition 26a erfolgt ein Auflegen der elektronischen Baugruppen 12 und/oder Werkstücke 14 von einem Transport-Werkstückträger 44 auf einen Fertigungs-Werkstückträger 22. Dies kann auch als Vorkonfektionierung bezüglich des Verfahrens 100 bezeichnet werden. Die elektronischen Baugruppen 12 und/oder Werkstücken14 können mit einem Automatisierungsroboter 46, insbesondere einem Roboterarm 47, von dem Transport-Werkstückträger 44, der sich auf einer zweiten Transporteinheit 42 befindet, auf den Fertigungs-Werkstückträger 22 umgesetzt werden. Die zweite Transporteinheit 42 kann sich innerhalb der Anlage 10 befinden, jedoch unabhängig von den Arbeitspositionen 26 sowie insbesondere unabhängig von der Beladestation 18 bewegen. Dadurch kann die zweite Transporteinheit 42 beispielsweise von der Beladestation 18 zu einer Entladestation 20 (in dieser Darstellung nicht dargestellt) automatisiert Verfahren, um dort die elektronischen Baugruppen 12 und/oder die Werkstücke 14 wieder aufzunehmen. Die zweite Transporteinheit 42 kann ein oder mehrere elektronische Baugruppen 12 und/oder Werkstücke 14 aufnehmen. Die zweite Transporteinheit 42 umfasst eine Hubeinheit 61, durch die ein entleerter Transport-Werkstückträger 44 von einer ersten Transportebene E1 auf eine zweite Transportebene E2 abgesenkt werden kann. Hier können die leeren Transport-Werkstückträger 44 durch die Anlage 10 bis zur Entladestation 20 unter Umgehung von atmosphärendichten Anlagemodulen 16 verfahren werden, um dort wieder Werkstücke 14 aus den Fertigungs-Werkstückträgern 22 aufzunehmen. Hierzu kann die Entladestation 20 eine weitere Hubeinheit 61 aufweisen, um die Transport-Werkstückträger von Ebene E2 auf Ebene E1 heraufzuheben.

Des Weiteren erfolgt in der Arbeitsposition 26a ein Auflegen einer Prozessabdeckung 62, insbesondere das Auflegen einer Maske 28. Die Prozessabdeckung 62 kann Aussparungen aufweisen, sodass an gezielten Positionen der Aussparungen Sinterverbindungen bzw. Lötverbindungen hergestellt werden können. Die Prozessabdeckung 62 kann sich zunächst auf einer Parkposition 29 befinden. Von dieser Parkposition 29, die neben der Arbeitsposition 26a angeordnet ist, kann die Prozessabdeckung 62 auf den Fertigungs-Werkstückträger 22 mit den elektronischen Baugruppen 12 und/oder den Werkstücken 14 automatisiert bewegt werden. Dies kann beispielsweise durch eine Art Schiene sowie einen Greifer bzw. Rahmen erfolgen, die automatisiert gesteuert werden. Ebenso kann das Aufsetzen der Prozessabdeckung 62 über einen Automatisierungsroboter 46 erfolgen. Dabei kann es sich um denselben Automatisierungsroboter 46 handeln, der auch zum Aufsetzen der elektronischen Baugruppen 12 und/oder der Werkstücke 14 verwendet wird. Des Weiteren kann ein zweiter, davon unabhängiger Automatisierungsroboter 47 (nicht dargestellt) eingesetzt werden. Nach Durchführung dieser Schritte wird der Fertigungs-Werkstückträger 22, mit den elektronischen Baugruppen 12 und/oder den Werkstücken 14 sowie mit der Prozessabdeckung 62, automatisiert zu der nächsten Arbeitsposition sechsten 26b bewegt. Dies kann über eine Verfahreinheit, beispielsweise eine Art Fließband, erfolgen.

In der Arbeitsposition 26b erfolgt in dieser Ausführungsform ein Auflegen einer Folie 30 auf den bereits zum Teil vorkonfektionierten Fertigungs-Werkstückträger 22. Die Folie 30 kann sich ebenso neben der Arbeitsposition 26b in einer Art Parkposition befinden, bevor diese zur Arbeitsposition 26b verschoben wird. Dies kann ebenso über eine Schiene mit einem Greifer oder eine andersartige Aufbringungsvorrichtung erfolgen. Anschließend wird der weiter vorkonfektionierte Fertigungs-Werkstückträger 22 mit der Folie 30 zu der nächsten Arbeitsposition 26c automatisiert bewegt.

In Arbeitsposition 26c wird durch einen Haltering 52 die Folie 30 auf dem Fertigungs-Werkstückträger 22 fixiert. Dies erfolgt ebenso automatisiert, beispielsweise über eine computergesteuerte Aktuatorvorrichtung oder über einen weiteren Automatisierungsroboter 46. In der Arbeitsposition 26c ist außerdem die Hubeinheit 25 der Transporteinheit 24 erkennbar. Die Hubeinheit 25 kann die Fertigungs-Werkstückträger 22 mit aufgebrachter Folie 30 sowie der Prozessabdeckung 62 von einem weiteren Modul 16, beispielsweise der Entladestation 20, zu der Beladestation 18 zu der Arbeitsposition 26c zurückführen. Es ist ebenso denkbar, dass der Fertigungs-Werkstückträger 22 über die Transporteinheit 24 zu einer anderen Arbeitsposition 26 zurückgeführt wird (hier nicht dargestellt).

Die Arbeitsposition 26d dient als Pufferposition. Dort könnte ein weiterer Arbeitsschritt erfolgen, der notwendig ist, bevor der vorkonfektionierte Fertigungs-Werkstückträger 22 in ein weiteres Modul 16, insbesondere der Fertigungsstation 21, automatisiert Verfahren wird.

Über die Hubeinheit 25 und eine Unterflurfördereinheit 60 (in dieser Draufsicht nicht sichtbar) kann der Fertigungs-Werkstückträger 22 in eine Ebene E2 unterhalb der in Fig. 4 dargestellten Ebene verfahren und an zumindest eine der Arbeitspositionen 26a-26d rückgeführt werden.

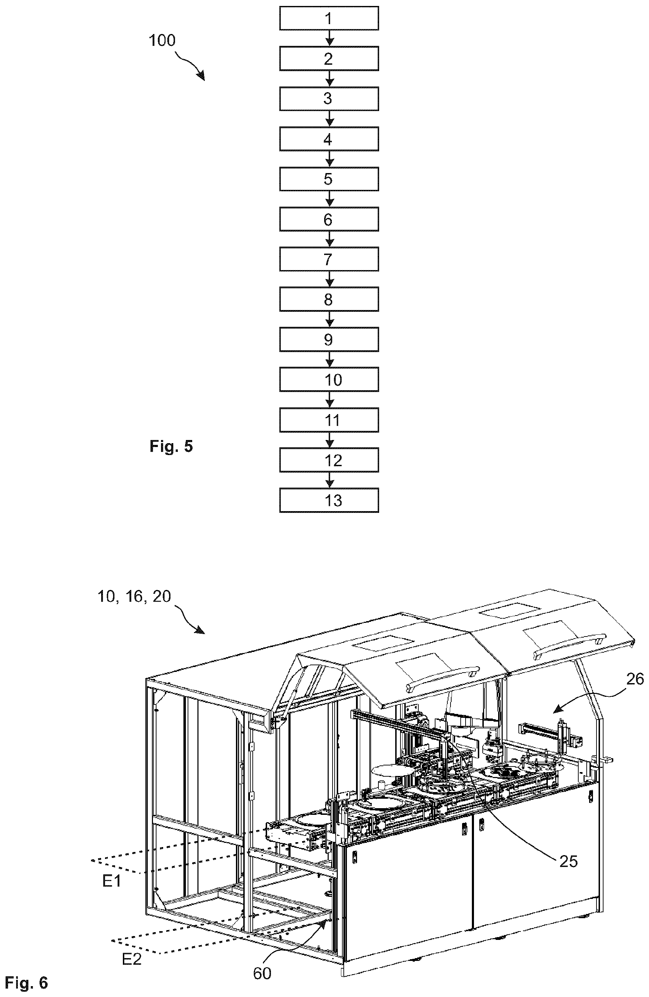

**Fig. 5** zeigt eine Ausführungsform eines möglichen Ablaufs der unterschiedlichen Arbeitsschritte 1 bis 13 eines Verfahrens 100 in der Beladestation 18 aus Fig. 4. In Schritt 1 wird zunächst der Fertigungs-Werkstückträger 22 über eine Hubeinheit 25 von der Unterflurfördereinheit 60 von der Entladestation 20 geholt. Auf dem Fertigungs-Werkstückträger 22 kann bei der Rückführung eine Prozessabdeckung 62 sowie ein Haltering 52 angeordnet sein. Daher kann in Schritt 1 der Fertigungs-Werkstückträger 22 zunächst zu der Arbeitsposition 26c geführt werden. Die Durchführung der kompletten Arbeitsschritte in Schritt 1 kann beispielsweise eine Zeit von 19 Sekunden dauern. In Schritt 2 kann schließlich an Arbeitsposition 26c der Haltering 52 entnommen werden. Dies kann beispielsweise 4 Sekunden dauern. In Schritt 3 kann ein Transport des Fertigungs-Werkstückträgers 22 von der Arbeitsposition 26c zu der Arbeitsposition 26a erfolgen, mit einer Zeitdauer von beispielsweise 15 Sekunden. In Schritt 4 kann schließlich die Prozessabdeckung 62 automatisiert gegriffen und seitlich auf einer Parkposition 29 abgelegt werden. Dies kann beispielsweise 4 Sekunden dauern. In Schritt 5 können die elektronischen Baugruppen 12 und/oder die Werkstücke 14 mit einem Automatisierungsroboter 46 in den Fertigungs-Werkstückträger 22 abgelegt werden. Dabei können beispielsweise alle 5 Sekunden 7 elektronische Baugruppen 12 und/oder Werkstücke 14 bewegt werden. Die Durchführung der Arbeitsschritte in Schritt 5 kann daher beispielsweise 35 Sekunden betragen. In Schritt 6 kann die zweite Transporteinheit 42 zu einer Entladestation 20 automatisiert Verfahren. Dies kann Beispielsweise auch Unterflur erfolgen, insbesondere mit einer Zeitdauer von beispielsweise 100 Sekunden. In Schritt 7 kann die Prozessabdeckung 62 zurück auf den Fertigungs-Werkstückträger 22 gelegt werden, mit einer Zeitdauer von beispielsweise 4 Sekunden. In Schritt 8 kann der Fertigungs-Werkstückträger 22 von der Arbeitsposition 26a zur Arbeitsposition 26b verfahren werden, mit einer Zeitdauer von beispielsweise 7 Sekunden. In Schritt 9 kann eine Folie 30, insbesondere eine temperaturfeste Folie, auf den Fertigungs-Werkstückträger 22 gelegt werden, mit einer Zeitdauer von beispielsweise 4 Sekunden. In Schritt 10 kann der Fertigungs-Werkstückträger 22 von der Arbeitsposition 26b auf die Arbeitsposition 26c bewegt werden, insbesondere mit einer Zeitdauer von beispielsweise 7 Sekunden. In Schritt 11 kann der Haltering 52 zurück auf den Fertigungs-Werkstückträger 22 gelegt werden, insbesondere mit einer Zeitdauer von beispielsweise 4 Sekunden. In Schritt 12 kann der Fertigungs-Werkstückträger 22 von der Arbeitsposition 26c zur Arbeitsposition 26d bewegt werden, insbesondere mit einer Zeitdauer von beispielsweise 7 Sekunden. Die Arbeitsposition 26d kann eine Pufferposition ausbilden. In Schritt 13 kann der Fertigungs-Werkstückträger 22 schließlich von der Arbeitsposition 26d in ein weiteres Modul 16, beispielsweise ein Vorheizmodul der Fertigungsstation 21, transportiert werden. Dies kann in einem Zeitrahmen von beispielsweise 10 Sekunden durchgeführt werden. Die Gesamtzeit der Durchführung der Schritte 1-13 kann daher in einem Zeitraum von beispielsweise 80-120 Sekunden, insbesondere in einem Zeitraum von 100-110 Sekunden erfolgen. Selbstverständlich kann die Durchführung auch in einem davon abweichenden Zeitraum erfolgen, wobei der Zeitraum um einiges länger bzw. auch um einiges kürzer sein kann. Bevorzugt wird zu dem Zeitraum die Zeit für die Durchführung der Schritte 6 sowie 13 nicht addiert, da diese Schritte parallel zur Durchführung der Schritte 1-5 sowie 7-12 erfolgen können.

**Fig. 6** zeigt ein Modul 16 einer erfindungsgemäßen Anlage 10, das als Entladestation 20 ausgebildet ist. Die Arbeitspositionen 26 der Entladestation 20 sind in umgekehrter Reihenfolge bezüglich der Arbeitspositionen 26a-26d der Beladestation 18 in Fig. 3 angeordnet. Dargestellt ist ebenso die obere Ebene E1, in welcher die Arbeitsposition 26a-26d angeordnet sind, sowie die untere Ebene E2, die zur Rückführung des Fertigungs-Werkstückträgers 22, insbesondere mithilfe einer Unterflurfördereinheit 60, dient. Die Entladestation 20 kann funktionell komplementär zur Beladestation 18 arbeiten.

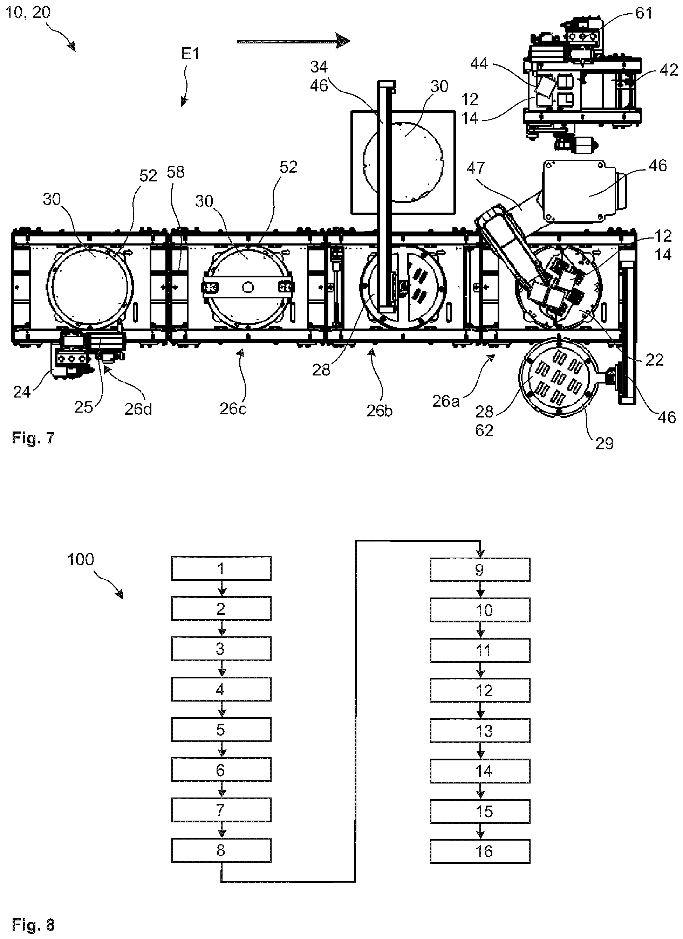

In **Fig. 7** ist das Modul 16 aus Fig. 6 in einer Draufsicht mit der Darstellung unterschiedlicher Arbeitspositionen 26 in der oberen Ebene E1 und eine Ausführungsform einer zweiten Transporteinheit 42 dargestellt. Die Arbeitspositionen 26a-26d sind gespiegelt, d.h. funktionell komplementär zu den Arbeitspositionen 26a-26d in der Beladestation 18 angeordnet. Folglich können die Arbeitsschritte, die in der Beladestation 18 nacheinander durchgeführt wurden, in entgegengesetzter Reihenfolge in der Entladestation 20 durchgeführt werden. Durch eine weitere Hubeinheit 61 werden leere Transport-Werkstückträger, die von der Beladestation 18 zur Entladestation 20 transportiert wurden, von Ebene E2 auf Ebene E1 heraufgehoben, auf der verarbeitete Werkstücke 14 mittels des Automatisierungsroboters 62 von einem Fertigungs-Werkstückträger 22 umgesetzt werden.

**Fig. 8** zeigt einen möglichen Ablauf unterschiedlicher Arbeitsschritte einer Ausführungsform eines erfindungsgemäßen Verfahrens 100, durchgeführt in der Entladestation 20 aus Fig. 7 mit den Schritten 1 bis 16. In Schritt 1 kann der Fertigungs-Werkstückträger 22 von der Fertigungsstation 21, insbesondere einem Modul 16, das als Abkühlmodul ausgebildet ist, in die Entladestation 20 eingefahren werden. Dies kann automatisiert erfolgen, und beispielsweise in einem Zeitraum von 10 Sekunden durchgeführt werden. Der Fertigungs-Werkstückträger 22 befindet sich dann an der Arbeitsposition 26d, die als Pufferstation ausgebildet sein kann. In Schritt 2 kann der Fertigungs-Werkstückträger 22 von der Arbeitsposition 26d zur Arbeitsposition 26c transportiert werden, beispielsweise in einem Zeitraum von 7 Sekunden. In Schritt 3 kann der Haltering 52 automatisiert entnommen werden. Beispielsweise kann der Haltering 52 angehoben werden, was einen Zeitraum von insbesondere 4 Sekunden benötigt. In Schritt 4 kann der Fertigungs-Werkstückträger 22 von der Arbeitsposition 26c zur Arbeitsposition 26b verfahren werden, beispielsweise in einen Zeitraum von 7 Sekunden. In Schritt 5 kann die Prozessabdeckung 62 auf dem Fertigungs-Werkstückträger 22 gegriffen werden, beispielsweise durch eine Halteeinheit, insbesondere in einem Zeitraum von 3 Sekunden. Anschließend bzw. parallel kann in Schritt 6 die Folie 30, insbesondere die PDFE-Folie, gegriffen und abgezogen werden, insbesondere in einem Zeitraum von 4 Sekunden. Dies kann beispielsweise durch einen Folienumsetzer 34 erfolgen. In Schritt 7 kann die Prozessabdeckung 62 schließlich losgelassen werden, insbesondere benötigt dies einen Zeitraum von 3 Sekunden. In Schritt 8 kann der Fertigungs-Werkstückträger 22 von der Arbeitsposition 26b zur Arbeitsposition 26a verschoben werden, insbesondere automatisiert und in einem Zeitraum von 7 Sekunden. In Schritt 9 kann die Prozessabdeckung 62 schließlich gegriffen und seitlich auf einer Parkposition 29 abgelegt werden, insbesondere in einen Zeitraum von 4 Sekunden. In Schritt 10 können die elektronischen Baugruppen 12 und/oder die Werkstücke 14 mit einem Automatisierungsroboter 46 von dem Fertigungs-Werkstückträger 22 auf einen Transport-Werkstückträger 44 umgesetzt werden. Dabei können beispielsweise alle 5 Sekunden sieben elektronische Baugruppen 12 und/oder Werkstücke 14 bewegt werden, insbesondere in einem Zeitraum von 35 Sekunden. In Schritt 11 kann die Prozessabdeckung 62 schließlich zurück auf den Fertigungs-Werkstückträger 22 gelegt werden. Dies kann ebenso in der Arbeitsposition 26a erfolgen, und beispielsweise in einen Zeitraum von 4 Sekunden. In Schritt 12 kann der Fertigungs-Werkstückträger 22 von der Arbeitsposition 26a auf die Arbeitsposition 26c transportiert werden. Dies kann bevorzugt automatisiert erfolgen und in einem Zeitraum von beispielsweise 14 Sekunden. In dieser Arbeitsposition 26c kann in Schritt 13 der Haltering 52 zurück auf den Fertigungs-Werkstückträger 22 gelegt werden, insbesondere in einen Zeitraum von 4 Sekunden. Anschließend kann in Schritt 14 der Fertigungs-Werkstückträger 22 von der Arbeitsposition 26c auf die Arbeitsposition 26d transportiert werden, insbesondere in einem Zeitraum von 7 Sekunden. Anschließend kann in Schritt 15 der Fertigungs-Werkstückträger 22 auf die Transporteinheit 24 abgelegt werden, insbesondere über die Hubeinheit 25 auf die Unterflurfördereinheit 60 abgelegt werden. Dies kann einen Zeitraum von beispielsweise 19 Sekunden benötigen. In Schritt 16 kann über die Unterflurfördereinheit 60 schließlich eine Rückführung des Fertigungs-Werkstückträger 22 zur Beladestation 18 erfolgen. Der Fertigungs-Werkstückträger 22 kann zur Arbeitsposition 26c der Beladestation 18 rück geführt werden, an welcher zunächst der Haltering 52 entnommen werden kann. Das anschließende Verfahren 100, insbesondere mit den Schritten 1-13, wurde bereits anhand der Fig. 5 erläutert.

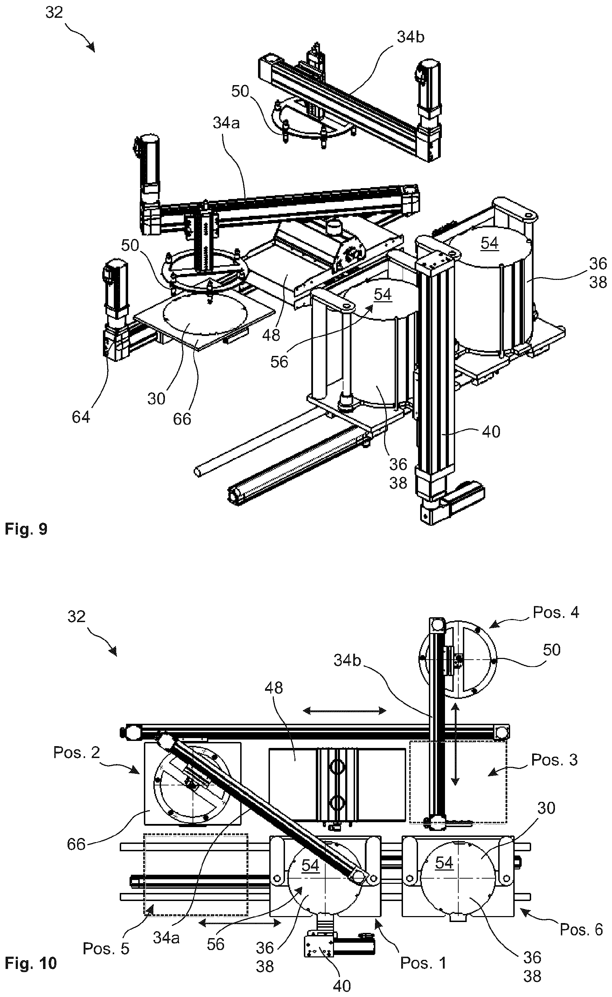

In **Fig. 9** ist eine Ausführungsform einer Folienumsetzereinheit 32 mit zwei Folienumsetzern 34 mit Darstellung von zwei Folienstapeln 36 dargestellt. Über einen Folienumsetzer 34 kann jeweils die oberste Folie 30 von einer Oberseite 54 eines Folienstapels 36 entnommen werden. Die Oberseite 54 dient als Entnahmefläche 56. Die Folienstapel 36 sind jeweils als ein Folienmagazin 38 ausgebildet.

Ist das erste Folienmagazin 38 (links in der Darstellung) leer, kann ein zweites Folienmagazin 38 an die Position des ersten Folienmagazins 38 verschoben werden. Das zweite Folienmagazin 38 kann die gleichen, aber auch anderen Typen von Folien aufnehmen. Dadurch kann ein kontinuierlicher Ablauf gewährleistet werden. Während Folien 30 aus dem zweiten Folienmagazin 38 entnommen werden, kann das erste Folienmagazin 38 nachgefüllt werden. Die Folienumsetzereinheit 32, insbesondere mit den Folienumsetzern 34 und den Folienmagazinen 38, kann beispielsweise in eine bestehende beliebige Anlage nachgerüstet werden. Ebenso kann das Absetzen und/oder Entnehmen der Folien 30 in der Arbeitsposition 26b der Beladestation 18 und/oder der Entladestation 20 der erfindungsgemäßen Anlage 10 durch eine derartige Folienumsetzereinheit 32 erfolgen.

In Fig. 9 ist ebenso eine Reinigungseinheit 48 dargestellt. Über den ersten Folienumsetzer 34a wird zunächst eine Folie 30 vom ersten Folienmagazin 38 entnommen und auf die Reinigungseinheit 48 aufgelegt. Nach dem Reinigen der Folie 30 wird die Folie 30 von der Reinigungseinheit 48 mit dem zweiten Folienumsetzer 34b entnommen und auf einen Fertigungs-Werkstückträger 22 aufgelegt. Bei der Reinigungseinheit 48 kann eine Linearreinigungseinheit 64 umfassen sein, oder es kann sich um ein berührungslos arbeitendes Oberflächenreinigungssystem handeln. Bei einer erfindungsgemäßen Anlage 10 bzw. bei einem erfindungsgemäßen Verfahren 100 kann durch eine Reinigungseinheit 48 eine Folie 30, insbesondere an die Arbeitsposition 26c der Beladestation 18 aus Figs. 3 und 4, zugeführt werden.

Über eine Folien-Hebeeinheit 40 kann der Folienstapel 36 vertikal nach oben geschoben werden. Dadurch kann sich die oberste Folie 30 des Folienstapels 36 zu jeder Situation an der im Wesentlichen gleichen Position befinden. Dadurch wird sichergestellt, dass der Folienumsetzer 34a die oberste Folie 30 des Folienstapels 36 unabhängig von der Anzahl der enthaltenen Folien 30 im Folienstapel 36 sicher entnehmen kann. Des Weiteren kann der Folienumsetzer 34 ein Höhenausgleichsystem 50 umfassen, durch welches Abweichungen der Position der obersten Folie 30 im Folienstapel 36 ausgeglichen werden können. Der Folienumsetzer 34 kann beispielsweise mit einem Greifer ausgebildet sein, wobei ein Aufnehmen der Folie 30 pneumatische und/oder über Vakuum, insbesondere über einen Vakuumsauger, erfolgen kann. Dadurch kann besonders vorteilhaft ein Auflegen sowie Reinigen der Folie 30 automatisiert, insbesondere vollautomatisiert, erfolgen. Ein händischer Eingriff ist zum Auflegen oder Entfernen der Folie 30 nicht notwendig, wodurch besonders vorteilhaft ein Reinraum, insbesondere ein ISO 5 Reinraum, ausgebildet werden kann.

**Fig. 10** zeigt die Folienumsetzereinheit 32 aus Fig. 9 in einer Draufsicht. Dieselben Bauteile sind mit denselben Bezugszeichen gekennzeichnet, sodass darauf nicht weiter eingegangen werden muss. In dieser Ansicht ist vorteilhaft erkennbar, dass sich die beiden Folienstapel 36 neben der Reinigungseinheit 48 befinden. Im oberen Bereich der Darstellung, d.h. neben der Reinigungseinheit 48, kann eine Folie 30 mithilfe des Folienumsetzer 34b auf einen Fertigungs-Werkstückträger 22 mit elektronischen Baugruppen 12 und/oder Werkstücken 14 (in dieser Darstellung nicht dargestellt) aufgelegt werden. Ein Fertigungs-Werkstückträger 22 könnte sich folglich neben der Reinigungseinheit 48 im oberen Bereich des Bildes befinden, wenn diese in einer Beladestation 18 angeordnet ist. Zur Sicherstellung, dass nur eine Folie und die richtige Folie entnommen wurde, kann an Pos. 3 ein Prüfen über ein mechanisches Dickenmesssystem, z.B. einen hochpräzischen digitalen Messtaster die Dicke der entnommenen Folie bestimmt werden. Dabei kann unabhängig vom Typ der Folie bestimmt werden, ob keine, eine oder mehrere Folien entnommen worden sind. Dabei kann der Folientaster an einem Randbereich die Foliendicke bestimmen, um die prozessrelevanten Bereiche z.B. beim Sintern unberührt zu lassen.

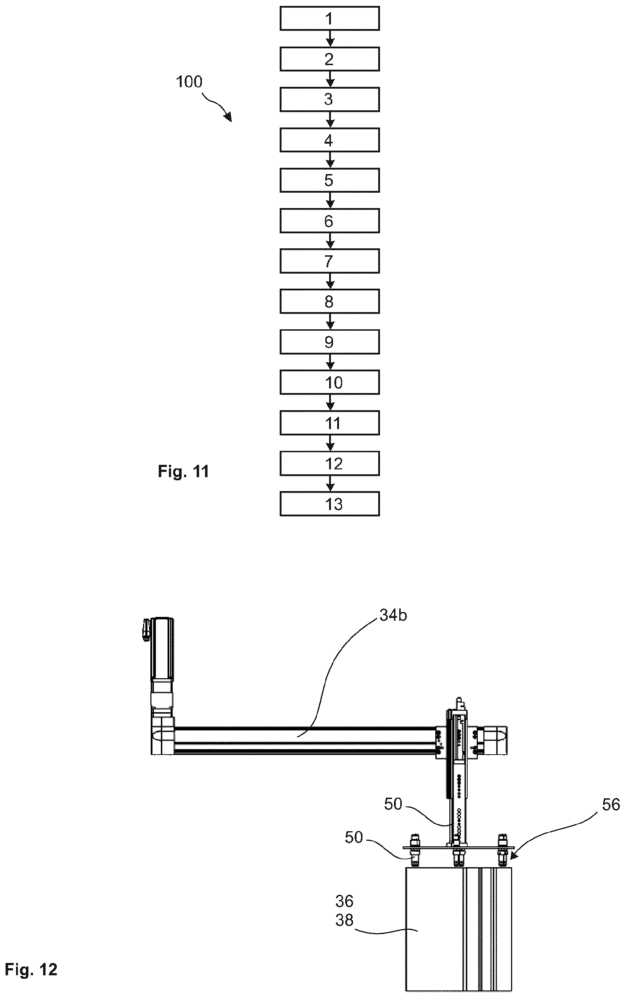

**Fig. 11** zeigt einen möglichen Ablauf unterschiedlicher Arbeitsschritte 1 bis 13 der Folienumsetzereinheit 32 aus Fig. 10. In Schritt 1 können einzelne Folien 30 von einem Folienstapel 36 an Position 1 entnommen und auf einen Folienträger 66 an Position 2 aufgelegt werden. In Schritt 2 kann der Folienträger 66 mit einer Folie 30 von Position 2 durch die Reinigungseinheit 48 auf Position 3 fahren. In Schritt 3 können schließlich die Folie 30 auf einen Fertigungs-Werkstückträger 22 (nicht dargestellt) aufgelegt werden, der sich an Position 4 befindet. In Schritt 4 kann der Folienträger 66, nun ohne eine Folie 30, von der Position 3 wieder zurück auf die Position 2 gefahren werden. In einem fünften Schritt können sich die Schritte 1-4 wiederholen. In Schritt 6 kann ein Anheben des Folienstapels 36 erfolgen, der sich an Position 1 befindet. Dies kann mit einer Folien-Hebeeinheit 40 erfolgen. Die Folien-Hebeeinheit 40 kann beispielsweise nach einem Verbrauch von 10 Folien 30, oder auch nach einem Absenken der Position der obersten Folie 30 um beispielsweise 10 mm, den kompletten Folienstapel 36 um dementsprechend 10 mm nach oben verfahren. Ein weiterer Höhenunterschied können direkt am Folienumsetzer 34 über ein Höhenausgleichsystem 50, beispielsweise durch einen Vakuumsauger-Halter, ausgeglichen werden. In Schritt 7 kann ein Nachfüllen bzw. Befüllen des Folienstapels 36 erfolgen, der sich an Position 6 befindet. Der Folienstapel 36 ist bevorzugt als Folienmagazin 38 ausgebildet. Das Nachfüllen kann insbesondere bei laufendem Betrieb der Folienumsetzereinheit 32, bzw. der Anlage 10 erfolgen. In Schritt 8 kann das leere Folienmagazin 38, dass sich an Position 1 befindet, auf Position 5 gefahren werden. In Schritt 9 kann das nun nachgefüllte Folienmagazin 38, dass sich auf Position 6 befindet, auf Position 1 gefahren werden. In Schritt 10 kann schließlich das andere Folienmagazin 38, dass sich nun an Position 5 befindet, bei laufendem Betrieb nachgefüllt werden. In Schritt 11 kann ein erneut leeres Folienmagazin 38, dass sich an Position 1 befindet, auf Position 6 verfahren werden. In Schritt 12 kann das nun nachgefüllte Folienmagazin 38 von Position 5 zu Position 1 gefahren werden. In einem Schritt 13 kann eine Wiederholung der Schritte 5-12 erfolgen. Die aufgezeigten Schritte 1-13 können Teil des erfindungsgemäßen Verfahrens 100 sein.

In **Fig. 12** ist eine Darstellung des Höhenausgleichssystems 50 des Folienstapels 36 und des Folienumsetzers 34 gezeigt. Dabei kann über den Toleranzbereich des Folienumsetzers 34 und den Hub des Folienstapels 36 sichergestellt werden, dass jeweils lediglich die oberste Folie 30 an der Entnahmefläche 56 des Folienstapels 36 durch den Folienumsetzer 34 aufgenommen wird. In dieser Darstellung ist das Höhenausgleichsystem 50 in Form von Vakuumsauger-Halter erkennbar. Die Vakuumsauger-Halter können beispielsweise einen Federausgleich von 10-30 mm, insbesondere 20 mm, ausgleichen.

Dies dargestellten Ausführungsformen der Anlage 10, der Folienumsetzereinheit 32 sowie des Verfahrens 100 lassen sich selbstverständlich untereinander kombinieren, sodass beispielsweise unterschiedliche Ausgestaltungen der Folienumsetzereinheit 32 mit unterschiedlichen Ausgestaltungen der Anlage 10, oder auch des Verfahrens 100, kombiniert werden können.

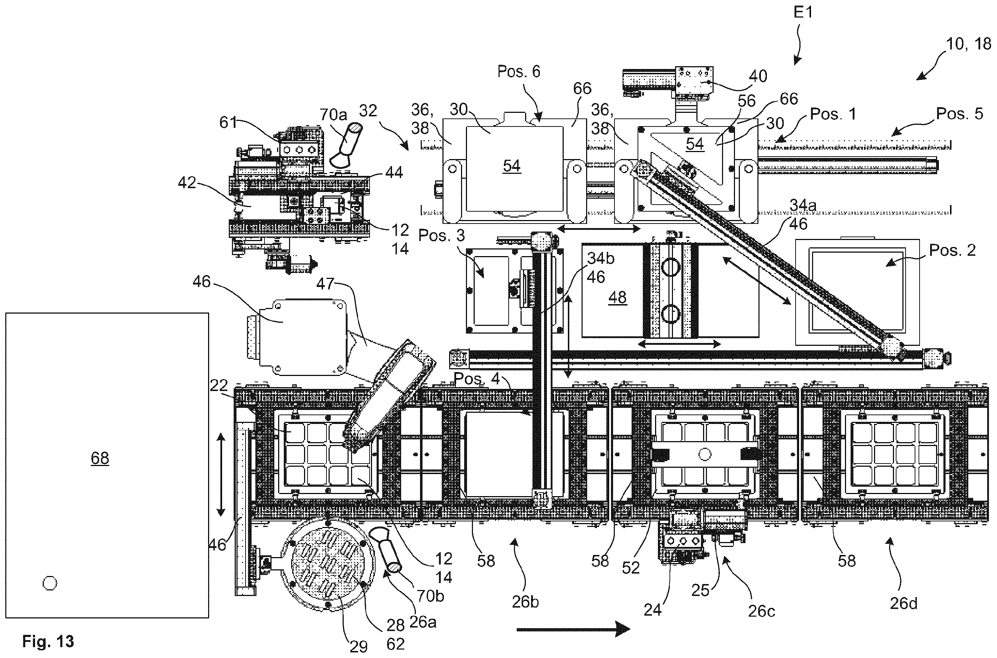

Die **Fig. 13** zeigt eine weitere Ausführungsform der in Fig. 4 dargestellten Beladestation 18, in der eine, wie in Fig. 10 dargestellte Folienumsetzereinheit 32 integriert ist. Zur Vermeidung von Wiederholungen wird in Bezug auf die gleichen Bezugszeichen auf die Beschreibung zur Fig. 4 und zur Fig. 10 verwiesen.

In der Beladestation der Fig. 13 werden rechteckförmige Fertigungs-Werkstückträger 22 mit Kapazität für zwölf Werkstücke 14 eingesetzt, auf die eine Abdeckmaske 28 in Arbeitsposition 26a und eine Abdeckfolie 30 an der Arbeitsposition 26b aufgelegt werden kann.

Am Eingang der Beladestation 18 ist ein Stapelmagazin 68 von Fertigungs-Werkstückträger 22 angeordnet, aus der zumindest bei einer Erstbeschickung der Anlage 10 leere Fertigungs-Werkstückträger 22 entnommen werden können bzw. bei Fertigungsende eingelagert werden können. Ein Automatisierungsroboter 46 setzt Werkstücke 14 von einem Transport-Werkstückträger 44 mittels eines Greifarms 47 auf einen Fertigungs-Werkstückträger 22 um, so dass Werkstücke von zwölf Transport-Werkstückträger 44 in einem Fertigungs-Werkstückträger 22 gesammelt werden können. Insoweit kann die Anlage in einem um den Faktor Zwölf langsameren Takt als die übrige Fertigungsstraße arbeiten.

Über der Hubeinheit 61 ist eine Inspektionskamera 7a angeordnet, die eine Drehlage und X/Y-Positionierung des Werkstücks 14 auf dem Transport-Werkstückträgers 44 erfasst. Mittels dieser Information kann der Dreharm 47 des Automatisierungsroboters 46 das Werkstück 14 aufnehmen und auf dem Fertigungs-Werkstückträger 22 in exakter Drehlage und X/Y-Ausrichtung absetzen. Dazu ist über der Arbeitsposition 26a auf dem dortigen Fertigungs-Werkstückträger 22 eine weitere Inspektionskamera 26b ausgerichtet, die die exakte Absetzungslage des Automatisierungsroboters 46 steuert und eine korrekte Ausrichtung der Werkstücke 14 auf dem Fertigungs-Werkstückträger 22 gewährleistet.

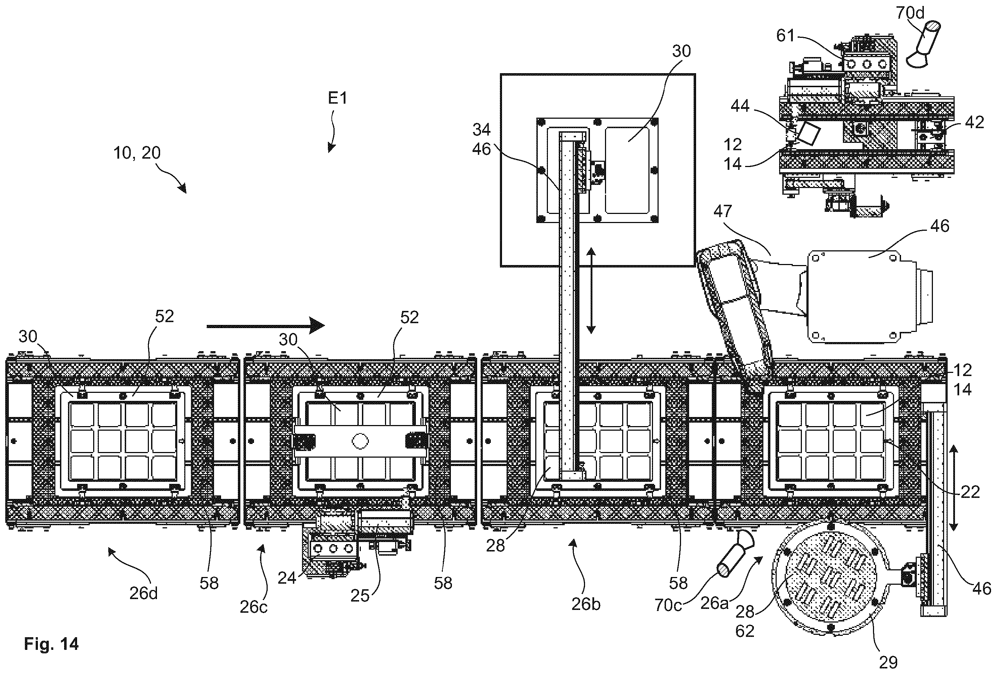

Komplementär zur Beladestation 18 der Fig. 13 stellt **Fig. 14** die zugehörige Entladestation 20 dar. Auch diese gleicht als weitere Ausführungsform 20 der in Fig. 7 beschriebenen Entladestation 20, so dass entsprechend auf die dortige Beschreibung Bezug genommen wird. Eine optische Inspektionseinrichtung umfasst mittels einer Inspektionskamera 70c über der Arbeitsposition 26a und einer weiteren Inspektionskamera 70d über der Hubeinheit 61 die Drehlage und X/Y-Ausrichtung der Werkstücke 14 auf dem Fertigungs-Werkstückträger 22 und ermöglicht eine Drehlage- und Positionsgenaues Umsetzen der Werkstücke auf einen Transport-Werkstückträger 44.

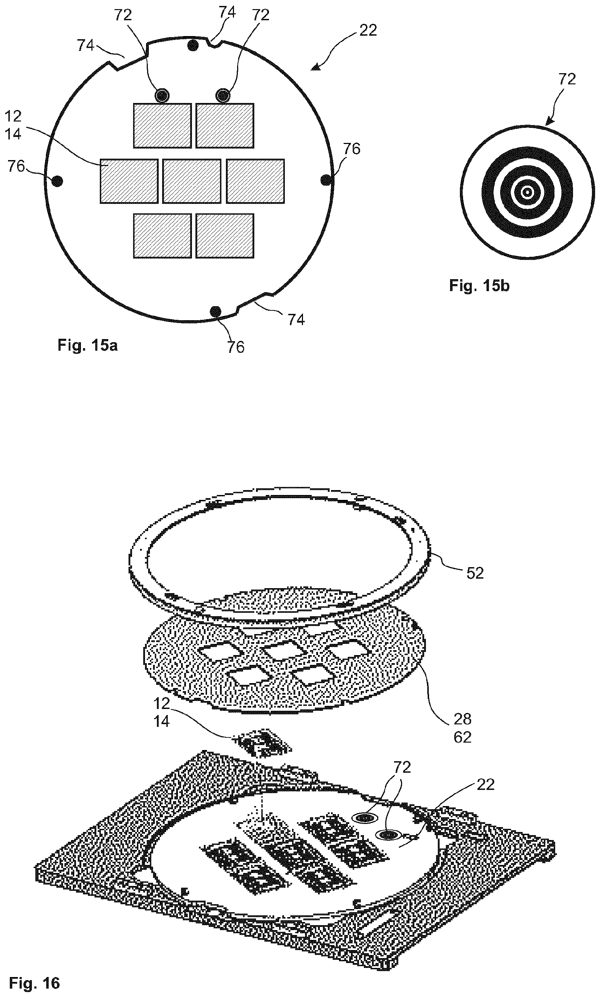

In der **Fig. 15a** ist eine Draufsicht auf eine Ausführungsform eines Einsatzes eines Fertigungs-Werkstückträger 22 mit optischen Referenzmarken 72 für eine optische Inspektionseinrichtung dargestellt. Der Einsatz des Fertigungs-Werkstückträger 22 kann in einer Matrixanordnung sieben Werkstücke 14 aufnehmen. Es sind Befestigungselemente 76, beispielsweise Ausnehmungen oder Zapfen für eine Befestigung in einem tablettartigen Rahmen des Fertigungs-Werkstückträgers 22 vorgesehen. Am äußeren Randbereich des Einsatzes sind formschlüssige Randabschnitte 74 zum formschlüssig-lagerichtigen Einsatz im Rahmen des Fertigungs-Werkstückträgers 22 vorgesehen.

Der Fertigungs-Werkstückträger 22 weist zwei optische Referenzmarken 72 auf, die mittels der optischen Inspektionseinrichtung erfasst und eine Ausrichtung des Fertigungs-Werkstückträgers auch bei einer geringen Auflösung einer Inspektionskamera 70 oder schwierigen Lichtverhältnissen ermöglichen. Im Detail ist eine optische Referenzmarke 72 in **Fig. 15b** dargestellt. Diese besteht aus einer Sequenz konzentrischer Konturen, in diesem Fall konzentrischer Ringe. Deren definierter Abstand und Breiten ermöglicht sowohl eine exakte Identifikation der XIY-Platzierung, sowie die relative Lage zweier Referenzmarken 72 auf dem Fertigungs-Werkstückträger 22 gegeneinander eine Bestimmung der Drehlage des Fertigungs-Werkstückträgers 22.

Schließlich zeigt die **Fig. 16** perspektivisch eine Kombination eines Rahmens und des in Fig. 15a dargestellten Einsatzes des Fertigungs-Werkstückträgers 22 mit aufgenommen Werkstücken. Diese werden mit einer Prozessabdeckung 62 in Form einer Maske 28 für ein Vakuum-Sinterverfahren abgedeckt, die mittels eines Halterings 52 mit dem Fertigungs-Werkstückträgers 22 verbunden ist. Anschließend kann noch eine Folie 30 zur Abdeckung aufgelegt, und ggf. ebenfalls durch den Haltering 52 fixiert werden. Die Folie 30 verhindert beispielsweise beim Sintern ein Anheften eines elastischen Sinterkissens auf einer Oberfläche der Werkstücke.

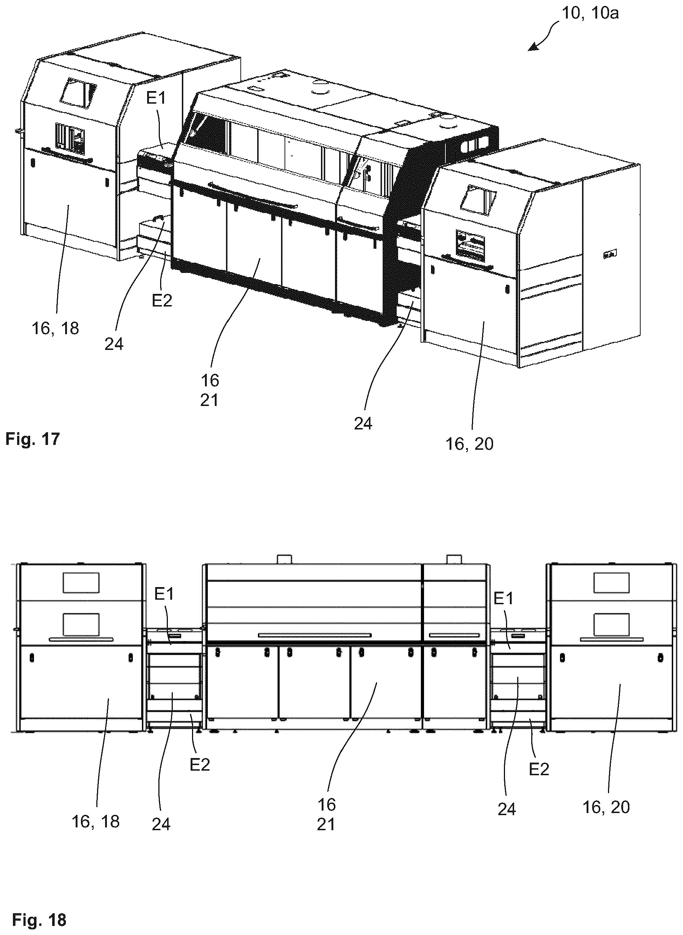

**Fig. 17** zeigt eine weitere Ausführungsform einer erfindungsgemäßen Anlage 10 zum Verbinden von elektronischen Baugruppen 12 und/oder Fertigen von Werkstücken 14 mit mehreren Modulen. Die Anlage 10 weist mehrere Module 16 auf. Eine derartige Anlage 10 kann beispielsweise eine Lötanlage 10a ausbilden. Durch eine derartige Anlage 10 können beispielsweise temperaturbeständige Lötverbindungen hergestellt werden. In dieser Ausführungsform zeigt die Anlage 10 drei Module 16. Das erste Modul 16 ist als Beladestation 18 ausgebildet. Daran schließt sich eine Fertigungsstation 21 an. Das Modul 16 am rechten Ende der Anlage 10 ist als Entladestation 20 ausgebildet. Zur Ausbildung eines Reinraums, insbesondere eines ISO 5 Reinraums, ist die Anlage bevorzugt als geschlossene Kammer und/oder gasdicht ausgebildet. Bevorzugt sind daher die Module 16 untereinander verbunden, jedoch gegenüber äußeren Einflüssen in einem gemeinsamen Gehäuse geschützt. Im Unterschied zur Ausführungsform gemäß Fig. 1 sind die Module 16 nicht direkt miteinander verbunden, sondern über mehrere Transporteinheiten 24. In den unterschiedlichen Ebenen E1, E2 sind jeweils bevorzugt als geschlossene Kammer und/oder gasdicht ausgebildete Einheiten Verbindungen ausgeformt, in welchen die Transporteinheiten 24 verlaufen. Eine der Transporteinheiten 24 kann beispielsweise eine Unterflurfördereinheit 60 ausbilden.

**Fig. 18** zeigt die Anlage aus Fig. 17 in einer Frontansicht. Dabei sind die einzelnen Verbindungsbereiche zwischen den Modulen 16, in welchen die Transporteinheit der 24 verlaufen, sichtbar. Im Gegensatz zur Ausführungsform gemäß Figs. 1 und 2 kann die Ausführungsform gemäß Figs. 17 und 18 speziell als Lötanlage ausgebildet sein. Der Unterschied zu einer Anlage gemäß den Figs. 1 und 2 liegt darin, dass in einer Lötanlage auf die Arbeitsposition verzichtet werden kann, welche zur Auflegung von Folien als Folienumsetzereinheit 32 ausgebildet ist. In den weiteren Ausführungen kann die Ausführungsform gemäß Figs. 17 und 18 mit der gemäß Figs. 1 und 2 übereinstimmen.

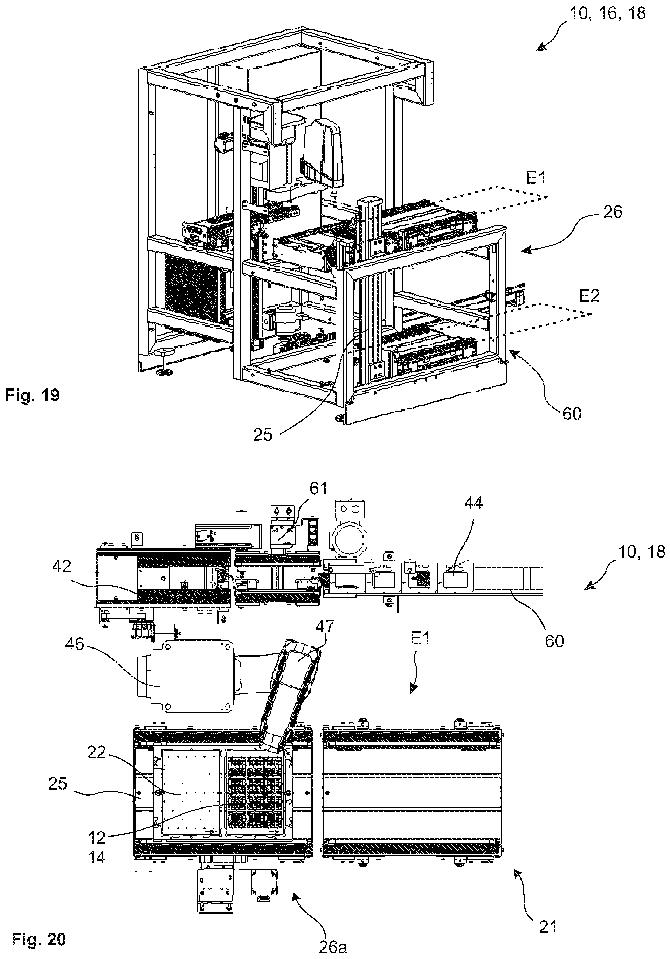

**Fig. 19** zeigt eine weitere Ausführungsform eines Moduls 16 einer erfindungsgemäßen Anlage 10, das als Beladestation 18 ausgebildet ist. Die Beladestation 18 ist ohne Gehäuse dargestellt, wodurch das Innere sichtbar ist. In dieser Darstellung ist eine Hubeinheit 25 der Transporteinheit 24 in Ebene E1 erkennbar. Diese ist mit der Unterflurfördereinheit 60 verbunden, die unterhalb der Ebene E1 auf der Ebene E2 angeordnet ist. Um die Fertigungs-Werkstückträger 22 von der unteren Ebene E2, in der die Unterflurfördereinheit 60 angeordnet ist, in die obere Ebene E1, in der die Arbeitspositionen 26 angeordnet sind, zu befördern, kann die Hubeinheit 25 eingesetzt werden. Die Hubeinheit 25 kann durch einen Hub von Ebene E1 in Ebene E2, oder andersherum, die Fertigungs-Werkstückträger 22 befördern. Dieser Vorgang wurde bereits ausführlich bezüglich Fig. 3 beschrieben. Im Unterschied zur Ausführungsform gemäß Fig. 3 zeigt die Ausführungsform gemäß Fig. 19 eine Beladestation 18 für eine Lötanlage nach Figs. 17 und 18. In einer derartigen Ausführungsform kann auf die Folienumsetzereinheit verzichtet werden.

**Fig. 20** zeigt das Modul 16 aus Fig. 19 in einer Draufsicht mit der Darstellung unterschiedlicher Arbeitspositionen. In der Arbeitsposition 26a erfolgt ein Auflegen der elektronischen Baugruppen 12 und/oder Werkstücke 14 auf einen Fertigungs-Werkstückträger 22. Dies kann auch als Vorkonfektionierung bezüglich des Verfahrens 100 bezeichnet werden. Die elektronischen Baugruppen 12 und/oder Werkstücken14 können mit einem Automatisierungsroboter 46, insbesondere einem Roboterarm 47, auf den Fertigungs-Werkstückträger 22 umgesetzt werden. Die kann auch durch Deckenmontage erfolgen. Im Gegensatz zur Ausführungsform gemäß Figs. 4 zeigt die Ausführungsform gemäß Fig. 20 keine Arbeitsposition 26b zum Auflegen einer Folie. Die Ausführungsform gemäß Fig. 20 zeigt dadurch insbesondere eine Lötanlage. Nach der Arbeitsposition 26a kann eine weitere Fertigungsstation 21 angeordnet sein, beispielsweise in Form eines Transportbandes, das als Puffer bzw. Pufferstation dient. Im oberen Bildbereich ist eine zweite Transporteinheit 42 angeordnet, die eine Hubeinheit 61 aufweist. An dieser zweiten Transporteinheit 42 ist eine Unterflurfördereinheit 60 angeordnet, auf welcher die Transport-Werkstückträger 44 angeordnet sind. In den weiteren Ausführungsformen kann die Darstellung Merkmale wie die Ausführungsform gemäß Figs. 4 aufweisen, mit Ausnahme der Folienumsetzereinheit 32.

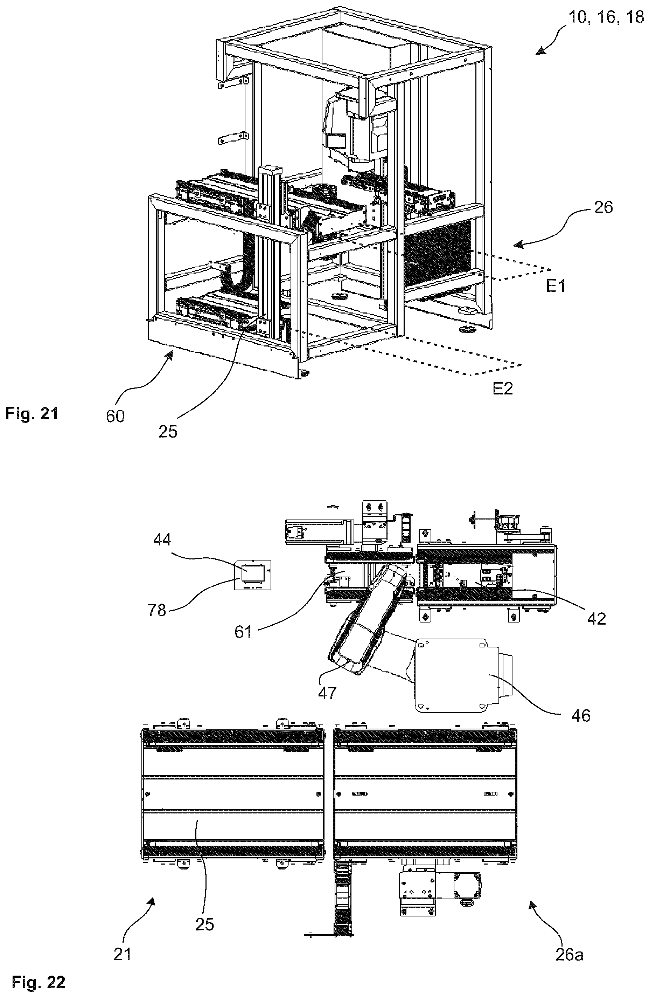

**Fig. 21** zeigt eine weitere Ausführungsform eines Moduls 16 einer erfindungsgemäßen Anlage 10, das als Entladestation 20 ausgebildet ist. Die Entladestation 20 ist ohne Gehäuse dargestellt, wodurch das Innere sichtbar ist. In dieser Darstellung ist eine Hubeinheit 25 der Transporteinheit 24 in Ebene E1 erkennbar. Diese ist mit der Unterflurfördereinheit 60 verbunden, die unterhalb der Ebene E1 auf der Ebene E2 angeordnet ist.

**Fig. 22** zeigt das Modul 16 aus Fig. 21 in einer Draufsicht mit der Darstellung der Arbeitsposition 26a. Vor der Arbeitsposition 26 ist eine weitere Fertigungsstation 21 angeordnet, die beispielsweise als Kühlstation ausgebildet sein kann. Mit dem Roboterarm 47 können die Werkstücke 14 von der Arbeitsposition 26a auf die zweite Transporteinheit 42 transportiert werden. Die zweite Transporteinheit 42 umfasst eine Hubeinheit 61 zum Transport der Transport-Werkstückträger 44. Des Weiteren ist ein Magazin 78 umfasst, dass die leeren Transport-Werkstückträger 44 aufnehmen kann.

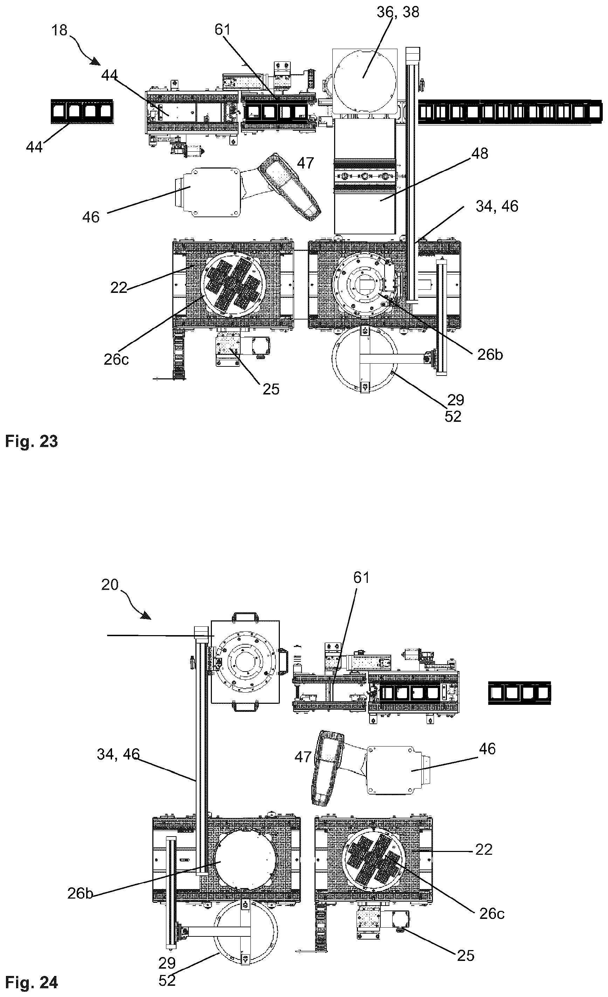

Die **Figs. 23** und **24** zeigen zwei weitere Ausführungsformen einer Beladestation 18 und einer Entladestation 20 als Anbaumodul 16 einer Anlage 10. Grundsätzlich entsprechen diese in Ihrem funktionellen Ablauf und strukturellem Aufbau den in den Figs. 13 und 14 im Detail erläuternden Be- und Entladestationen 18, 20.

Eine mögliche Arbeitsreihenfolge der Beladestation 18 der Fig. 23 sieht bei Verwendung einer einzelnen Oberfolie 30 für eine Sinterverbindung wie folgt aus:
- Zunächst kann ein Fertigungs-Werkstückträger 22 mit einer Hubeinheit 25 von einer Unterflurfördereinheit 60 auf eine Arbeitsebene in Position 26c angehoben werden;
- Hiernach werden durch den Roboterarm 47 des Automatisierungsroboters 46 eine Mehrzahl von Werkstücken 14, z.B. 10 bis 14, insbesondere 12 DCB-PCBs (Direct Bonded Copper Printed Circuit Boards) aus einem Transport-Warenträger 44 in den Fertigungs-Werkstückträger 22 umgesetzt;
- Hiernach wird der bestückte Fertigungs-Werkstückträger 22 von Position 26c in Position 26b verfahren;
- Anschließend kann der Haltering 52, der bisher auf dem Fertigungs-Werkstückträger 22 gelagert war, in eine Parkposition 29 versetzt werden;
- Eine Folie 30, z.B. eine PTFE-Folie für Sinterbearbeitung, wird als Oberfolie aus dem Folienstapel 35 aus der Folienumsetzereinheit 32 entnommen, durch die Folien-Reinigungseinheit 48 gereinigt und anschließend auf den bestückten Fertigungs-Werkstückträger 22 aufgebracht;
- Hiernach wird der Haltering 52 aus der Parkposition 29 zur Fixierung der Folie 30 auf dem Fertigungs-Werkstückträger 22 aufgesetzt und befestigt;
- Anschließend wird der Werkstückträger 22 in ein Vorheizmodul zur Vorbereitung auf das Sinterverfahren verfahren.

Alternativ kann bei Verwendung einer Unterfolie 30 und einer Oberfolie 30 nach Anheben des Fertigungs-Werkstückträger 22 aus der Unterflurfördereinheit 60 bereits in Position 26b nach Verbringen des Halterings 29 in die Parkposition 52 die Unterfolie 30 zunächst auf den Fertigungs-Werkstückträger 22 gelegt werden, wonach in Position 26c die Bestückung der Werkstücke 14 erfolgt.

In spiegelbildlicher Weise kann die Entladestation 20 der Fig. 24, die sich im Sinne der Fließfertigung sequentiell hinter dem Sintermodul 21 befindet, arbeiten, und folgende Arbeitsschritte bei Verwendung einer Oberfolie 30 für eine Sinterverbindung ausführen:
- Einfahren eines Fertigungs-Werkstückträgers 22 von einer Fertigungsstation 21, beispielsweise einem Kühlmodul 16 in die Entladestation 20;
- Anheben des Halterings 52 und Verbringen in eine Parkposition 29 in einer Position 26b des Entlademoduls 20;
- Greifen und Abziehen der Folie 30 vom bestückten Fertigungs-Werkstückträger 22 mittels eines Folienumsetzers 34;
- Zurücklegen des Halterings 52 aus der Parkposition 29 auf den Fertigungs-Werkstückträger 22;
- Verschieben des Fertigungs-Werkstückträgers 22 von der Position 26b in die Position 26c;
- Umsetzen der Werkstücke 14 mittels des Roboterarms 47 vom Fertigungs-Werkstückträger 22 auf einen Transport-Werkstückträger 44, wobei jeder Umsetzvorgang weniger als 6 Sekunden, insbesondere 5,5 Sekunden benötigt;
- Verfahren des Fertigungs-Werkstückträger 22 durch die Hubeinheit 25 auf die Unterflurfördereinheit 60 zum Rücktransport zur Beladestation 18.

Bei Verwendung einer Unterfolie 30 und einer Oberfolie 30 kann nach Verschieben des Fertigungs-Werkstückträgers 22 von der Position 26b in die Position 26c die Unterfolie 30 durch einen Automatisierungsroboter 46 anschließend abgezogen werden.

Beim Rücktransport aus der Beladestation 20 in die Entladestation 18 können gebrauchte Folien auf den Fertigungs-Werkstückträger 22 aufgelegt, zurücktransportiert und wieder auf den Folienstapel 36 gesetzt werden, oder auf einen weiteren Folienstapel innerhalb der Entladestation 20 gesetzt werden, der händisch wieder in die Beladestation 18 zur Wiederverwendung verbracht werden kann.

Die oder eine zweite Reinigungseinheit 48 kann nach Entnahme der gebrauchten Folie 30 in der Entladestation 20 eine Reinigung der Folie 30 bereits in der Entladestation 20 vornehmen.

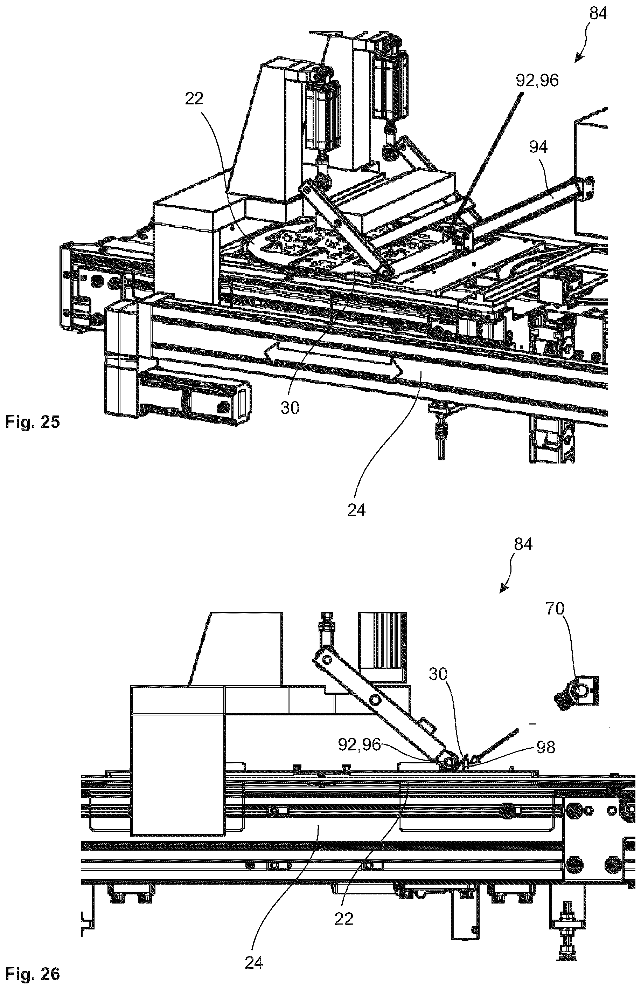

**Fig. 25** zeigt eine Ausführungsform einer Folienablöseeinheit 84. Die Folienablöseeinheit 84 weist ein Kontaktelement 92 in Form einer Rolle 96 auf. Mit dem Kontaktelement 92 wird eine über dem Fertigungs-Werkstückträger 22 angeordnete Folie 30 auf der Oberfläche des Fertigungs-Werkstückträger 22 mit den Werkstücken 14 gehalten. In diese Ausführung ist das Kontaktelement 92 als Rolle 96 ausgebildet und kann bei einer relativen Bewegung (in der dargestellten Pfeilrichtung) des Fertigungs-Werkstückträger 22 bezüglich der Folienablöseeinheit 84 über die Oberfläche der Folie 30 abrollen. Nachdem bei einer relativen Verschiebung des Fertigungs-Werkstückträgers 22 die Folie 30 das Kontaktelement 92 passiert hat, kann es mit dem Greifelement 94 gegriffen und nach oben weggezogen, d. h. weg von dem Fertigungs-Werkstückträger 22 bewegt werden. Dadurch kann die Folie 30 kontrolliert von dem Fertigungs-Werkstückträger 22 mit den Werkstücken 14 entfernt werden. Die Folienablöseeinheit 84 kann an einer Arbeitsposition 26 der Entladestation 20 angeordnet werden, wobei insbesondere über die Transporteinheit 24 der Fertigungs-Werkstückträger 22 relativ zu der Folienablöseeinheit 84 bewegt werden kann. Dadurch kann die Folienablöseeinheit 84 an einer festen Position verbleiben. Durch Verschwenken des Greifelements 94 kann die Folie 30 nach oben abgezogen werden.

**Fig. 26** zeigt eine weitere Ansicht der Ausführungsform aus Fig. 25. In dieser Ansicht ist erkennbar, dass im Bereich vor dem Kontaktelement 92 ein Folienheber 98 angeordnet ist, über welchen die Folie 30 geführt wird. Dadurch kann die Folie 30 vereinfacht durch das Greifelement 94 gegriffen werden. Das Anheben der Folie 30 kann beispielsweise auch durch einen Luftstrom, Druck- oder Saugluft, der vor dem Folienheber 98 angeordnet ist, unterstützt werden. Ein derartiger Luftstrom kann die Folie 30 beispielsweise zwischen dem Kontaktelement 92 und dem Folienheber 98 anheben, sodass die Folie 30 über den Folienheber 98 geführt werden kann. Es ist ebenso denkbar, dass die Folie 30 dadurch angehoben wird, dass diese in mechanischen Kontakt mit dem Folienheber 98 kommt und sich dadurch aufwölbt. Da die Folie 30 hinter dem Folienheber 98 (in der Darstellung links von dem Folienheber 98) durch das Kontaktelement 92 nach unten gedrückt wird, kann die Folie 30 kontrolliert von dem Fertigungs-Werkstückträger 22 abgelöst werden. Dieser Vorgang kann in einer weiteren Ausführungsform durch eine Inspektionskamera 70 kontrolliert werden.

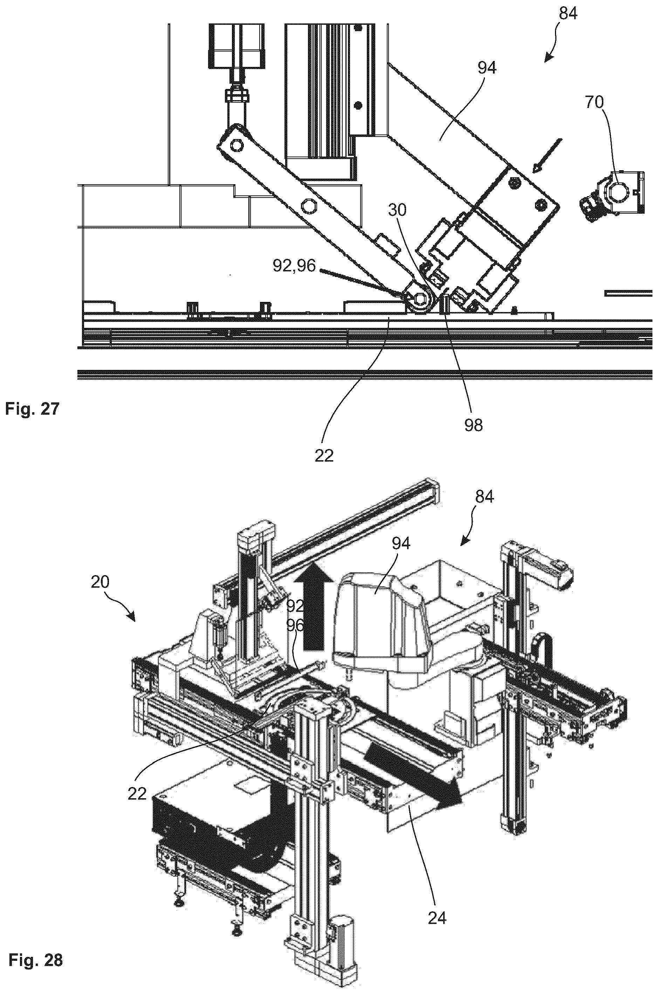

**Fig. 27** zeigt eine weitere Ausführungsform einer Folienablöseeinheit 84. Zusätzlich zur Darstellung gemäß Fig. 26 ist das Greifelement 94 dargestellt, welches die Folie 30 oberhalb des Folienheber 98 klemmend fixiert. Das Greifelement 94 kann in Richtung der Folie 30 bzw. in Richtung des Fertigungs-Werkstückträgers 22 geschwenkt bzw. gefahren werden, sobald die Folie 30 am Folienheber 98 kontaktiert ist. Dies kann beispielsweise mithilfe der Inspektionskamera 70 gesteuert werden.

**Fig. 28** zeigt eine weitere Ansicht der Ausführungsform aus Fig. 27. Wenn das Greifelement 94 die Folie 30 gegriffen hat, bewegt sich das Greifelement 94 bevorzugt gleichzeitig nach oben (Pfeilrichtung in der Darstellung), während sich der Fertigungs-Werkstückträger 22, insbesondere durch die Transporteinheit 24, horizontal (Pfeilrichtung in der Darstellung) bewegt. Insbesondere erfolgen beide Bewegungen mit derselben Geschwindigkeit. Dadurch kann ein kontinuierliches Ablösen der Folie 30 von dem Fertigungs-Werkstückträger 22 erreicht werden. In Fig. 28 ist dafür beispielhaft eine Arbeitsposition der Entladestation 20 dargestellt. Das Greifelement 94 befindet sich oberhalb der Transporteinheit 24. Das Kontaktelement 92 ist bevorzugt parallel zu einer Oberfläche des Fertigungs-Werkstückträger 22 angeordnet, und verläuft insbesondere quer zur Bewegungsrichtung der Transporteinheit 24.

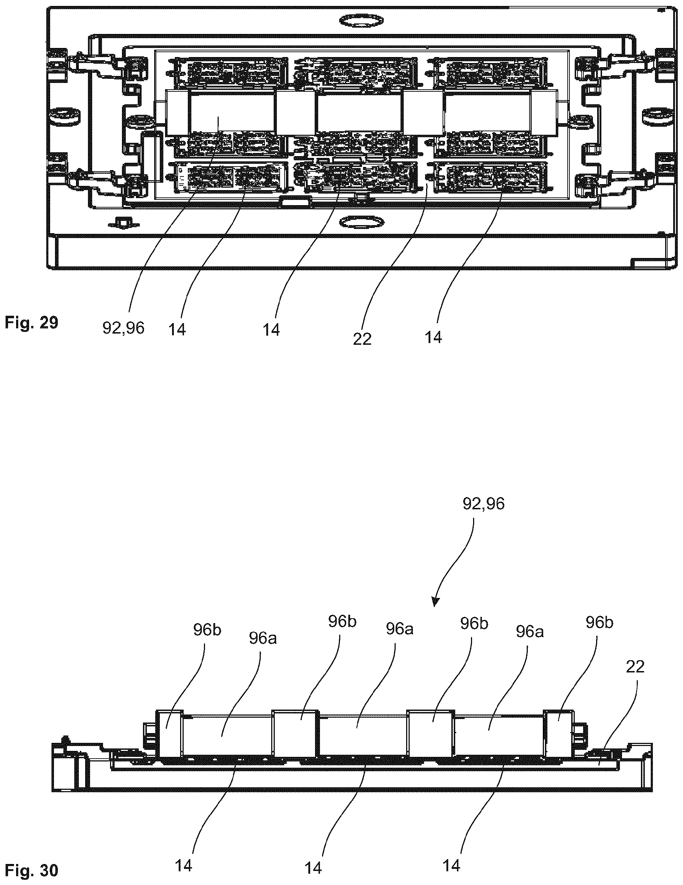

**Fig. 29** zeigt eine Ausführungsform eines Kontaktelements 92. In einer derartigen Ausführungsform weist das Kontaktelement 92 die Form einer Rolle 96 auf, und ist mit Vertiefungen 96a sowie Erhöhungen 96b versehen, wie in Fig. 30 dargestellt. Die Rolle 96 kann eine Negativform der Kontur der Werkstücke 14 auf dem Werkstückträger 22 ausbilden. Wird der Werkstückträger 22 unterhalb der Rolle 96, insbesondere über die Transporteinheit 24, bewegt, rotiert die Rolle 96 über die Folie 30 (nicht dargestellt) und den darunter angeordneten Werkstücken 14 sowie dem darunter angeordneten Werkstückträger 22. Die Bereiche mit den Vertiefungen 96a treffen dabei auf die Werkstücke 14, die Bereiche mit den Erhöhungen 96b treffen auf die dazwischen angeordneten Zwischenräume, und können insbesondere direkt mit dem Werkstückträger 22 in Kontakt kommen. Eine derartige Walze kann quasi eine Gegenform zu der Kontur der Werkstücke 14 auf dem Werkstückträger 22 ausbilden, wodurch das Kontaktelement 92 exakt über den Fertigungs-Werkstückträger 22 geführt werden kann. Weiterhin kann ein andrücken der Folie 30 (nicht dargestellt) auch dann gewährleistet werden, wenn der Fertigungs-Werkstückträger 20 mit den darauf angeordneten Werkstücken 14 eine nicht ebene Oberfläche ausbildet.

**Fig. 30** zeigt eine weitere Ansicht der Ausführungsform aus Fig. 29, wobei die abwechselnd angeordneten Vertiefungen 96a und Erhöhungen 96b erkennbar sind.

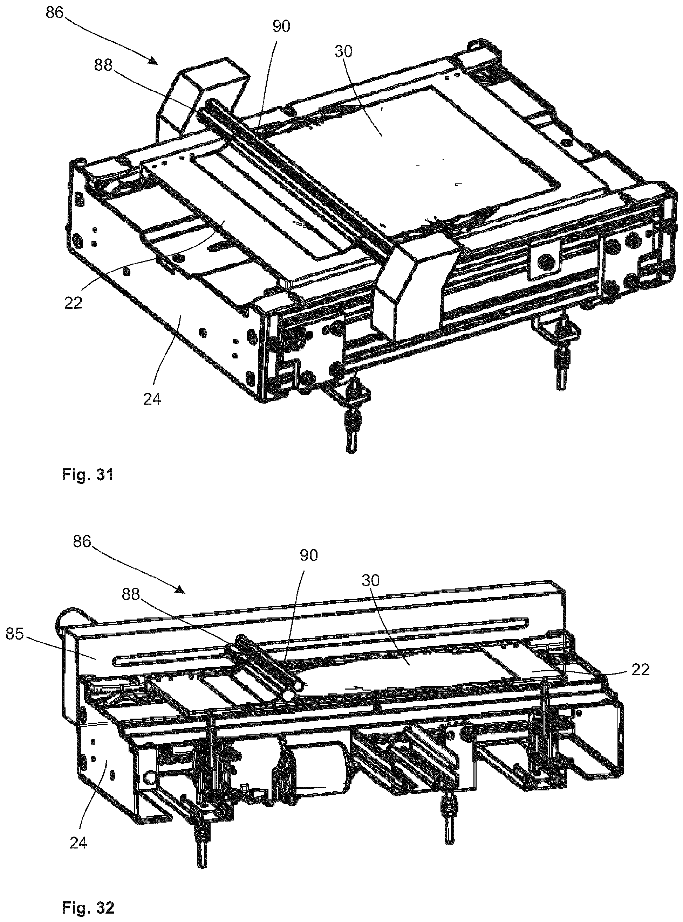

**Fig. 31** zeigt eine weitere Ausführungsform einer Folienablöseeinheit 84. Diese weist eine Abschäleinheit 86 mit einem Abschälelement 88 und einem Halteelement 90 auf. Das Abschälelement 88 und das Halteelement 90 sind in dieser Ausführungsform an einer Haltestruktur gelagert, und können relativ zum der Transporteinheit 24 bewegt werden. Die Haltestruktur kann entlang von Schienenelementen geführt werden. In einer derartigen Ausführungsform bewegt sich bevorzugt die Abschäleinheit 86 relativ zum Fertigungs-Werkstückträger 22 mit der Folie 30, wobei insbesondere die Abschäleinheit 86 bewegt wird, während der Fertigungsträger 22 unbewegt verbleibt. Bevorzugt fädelt sich das Abschälelement 88 unterhalb der Folie 30 ein, während das Halteelement 90 oberhalb der Folie 30 angeordnet ist. Die Folie 30 kann dadurch zwischen dem Abschälelement 88 und dem Halteelement 90 geführt und von dem Fertigungs-Werkstückträger 22 mit den Werkstücken 14 abgelöst werden. Durch das Abschälelement 88 werden gleichzeitig die Werkstücke 14 auf dem Fertigungs-Werkstückträger 22 niedergehalten.

**Fig. 32** zeigt eine weitere Ausführungsform einer Folienablöseeinheit 84. Hierbei ist ersichtlich, dass das Abschälelement 28 und das Halteelement 90 etwas versetzt übereinander angeordnet sind, sodass die Folie 30 dazwischen geführt werden kann. Die Abschäleinheit 86 kann relativ schnell bewegt werden, wodurch sich die Folie 33 vom Fertigungs-Werkstückträger 22 ablöst. In der dargestellten Ausführungsform ist die Haltestruktur in einer Lineareinheit 85 gehalten und kann dadurch parallel zu der Transporteinheit 24 bewegt werden.

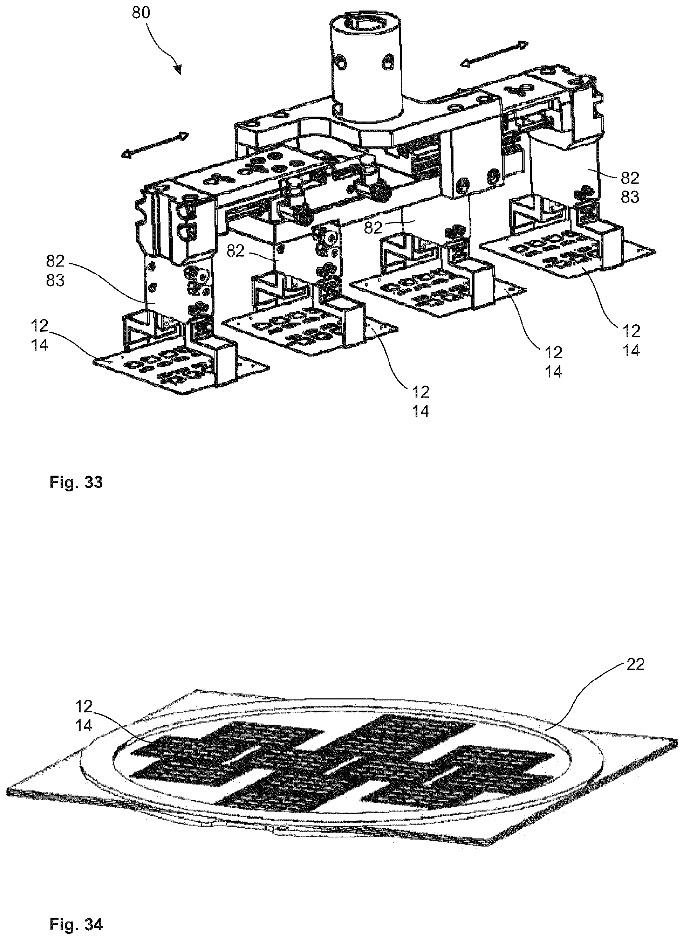

**Fig. 33** zeigt eine Ausführungsform eines Mehrfachgreifers 80. Der Mehrfachgreifer 80 weist in dieser Ausführungsform vier Greifarme 82 auf, die entlang einer Linie angeordnet sind. Die beiden äußeren Greifarme 83 können entlang der virtuellen Linie bewegt werden (dargestellt durch die beiden Pfeile), sodass der Abstand zwischen den beiden inneren Greifarmen 82 und den beiden äußeren Greifarmen 83 verändert werden kann. Im Bereich der Pfeile kann ein pneumatisch angetriebener Schlitten, insbesondere Minischlitten, ausgebildet sein, der die Bewegung der beiden äußeren Greifarme 83 ermöglicht. Insbesondere können alle vier Greifarme 82 pneumatische gesteuert werden und beispielsweise als Parallelgreifer ausgebildet sein. Um die Werkstücke 14 oder elektronische Baugruppen 12 aufzunehmen kann an jedem Greifarm 82 eine Aufnahme vorgesehen sein. Die Aufnahme kann aus zwei Greifelementen bestehen, die ein Werkstück 14 bzw. eine Baugruppe 12 von zwei Seiten klemmbar fixieren kann. Ein teleskopierbarer und/oder schwenkbarer Abschnitt kann teleskopierbar und/oder schwenkbar an einem Grundkörper des Mehrfachgreifers 80 angeordnet sein. Dadurch können sich die Greifarme 82, 83 relativ zueinander sowie relativ zum Grundkörper bewegen. In dieser Ausführungsform weist der Mehrfachgreifer 80 einen linienförmigen Grundkörper auf.

**Fig. 34** zeigt eine Ausführungsform eines Fertigungs-Werkstückträgers 22. Vier der darauf angeordneten Werkstücke 14 bzw. elektronischen Baugruppen 12 können mit dem dargestellten Mehrfachgreifer 80 zeitgleich gegriffen werden. Durch die pneumatische Ansteuerung können nicht nur auf einer virtuellen Linie angeordnete Werkstücke 14 bzw. elektronische Baugruppen 12, sondern auch andersartig angeordnete Werkstücke 14 bzw. elektronische Baugruppen 12 gegriffen, aufgelegt oder angehoben werden.

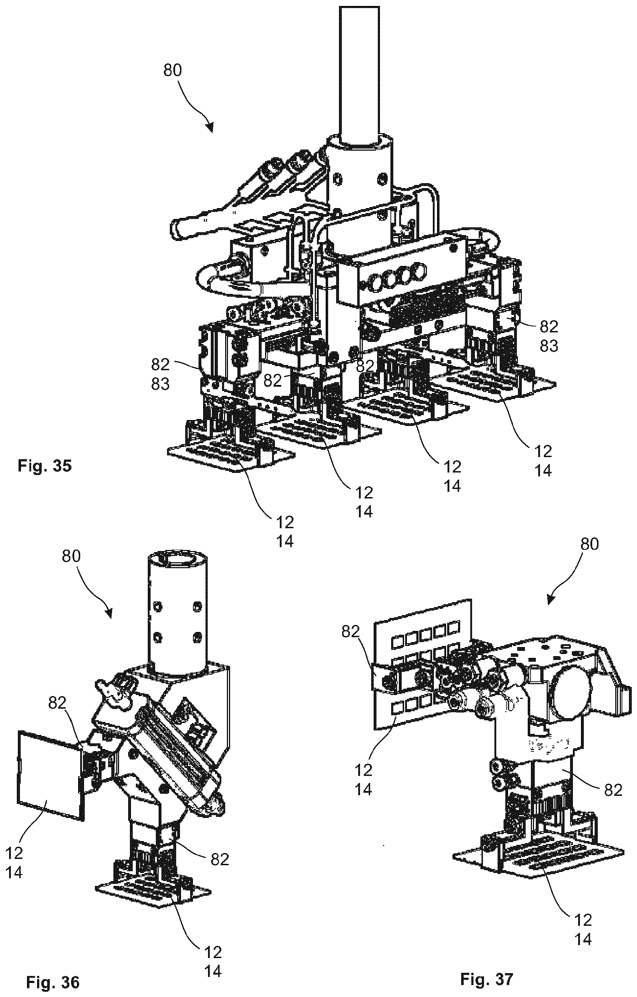

**Fig. 35** zeigt eine weitere Ausführungsform eines Mehrfachgreifers 80. In dieser Ausführungsform ist das pneumatische System erkennbar.

**Fig. 36** zeigt eine weitere Ausführungsform eines Mehrfachgreifers 80. Dieser Mehrfachgreifer 80 besitzt zwei Greifarme 82, die gegeneinander verschwenkt werden können. **Fig. 37** zeigt eine weitere Ansicht der Ausführungsform aus Fig. 36.

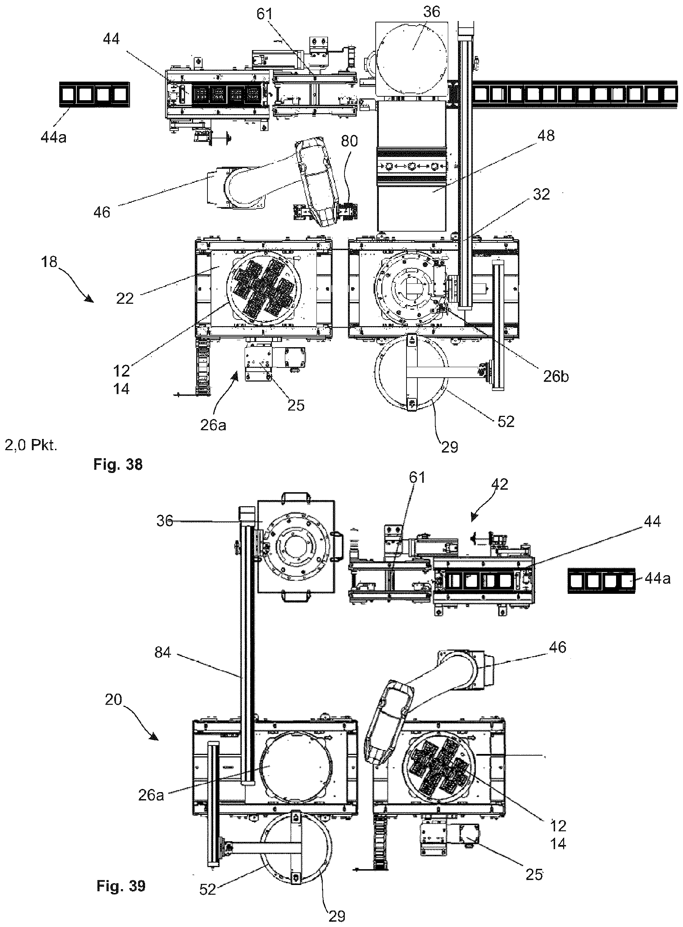

**Fig. 38** zeigt eine Ausführungsform einer Beladestation 18 mit Mehrfachgreifer 80. Mithilfe des flexiblen Mehrfachgreifers 80 können mehrere Werkstücke 14 bzw. mehrere elektronische Baugruppen 12 gleichzeitig von mehreren Transport-Werkstückträgern 44 entnommen und auf einen Fertigungs-Werkstückträger 22 aufgesetzt werden. In der Darstellung ist erkennbar, dass die Transport-Werkstückträger 44 entlang einer virtuellen Linie nebeneinander angeordnet sind. Mit dem Mehrfachgreifer 80 können von einer derartigen Anordnung zumindest vier Werkstücke 14 bzw. elektronische Baugruppen 12 entnommen und mit einer beliebigen Anordnung auf den Werkstückträger 22 aufgesetzt werden. Bezüglich der weiteren dargestellten Ausführungen wird auf Fig.13 verwiesen.

**Fig. 39** zeigt eine Ausführungsform einer Entladestation 20. In dieser Ausführungsform ist an dem Automatisierungsroboter 96 kein Mehrfachgreifer 80 angeordnet. Daher werden die Werkstücke 14 bzw. elektronischen Baugruppen 12 einzeln von dem Fertigungs-Werkstückträger 22 auf den Transport-Werkstückträger 44 umgeladen. Es ist ebenso denkbar, in der Entladestation 20 einen Mehrfachgreifer 80 einzusetzen, wie dies bezüglich der Beladestation 18 in Fig. 38 gezeigt ist. Bezüglich der weiteren dargestellten Ausführungen wird auf Fig.14 verwiesen.

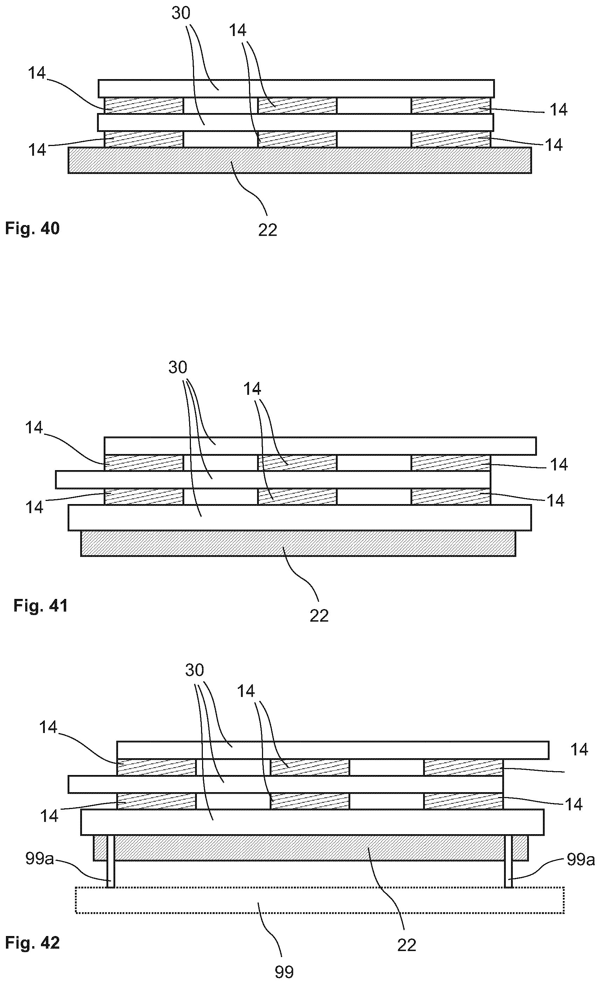

**Fig. 40** zeigt eine Ausführungsform eines Fertigungs-Werkstückträgers 22 mit übereinander gelagerten Werkstücken 14. In dieser Ausführungsform sind drei erste Werkstücke 14 unterhalb einer ersten Folie 30 angeordnet. Direkt oberhalb der ersten drei Werkstücke 14 sind drei zweite Werkstücke 14 oberhalb der Folie 30 platziert, wobei zusätzlich ein Druckkissen bzw eine bzw. Ausgleichsfolie umfasst sein kann. Oberhalb der zweiten Werkstücke 14 ist eine weitere Folie 30 angeordnet. Die ersten und zweiten Werkstücke 14 sind direkt übereinander angeordnet, sodass sich diese bei einem Sinterprozess gegeneinander abstützen können. Insbesondere entsprechen der Umfang sowie die Geometrie der ersten Werkstücke dem Umfang und der Geometrie der zweiten Werkstücke, sodass sich die ersten und zweiten Werkstücke über die komplette Breite gegeneinander abstützen können. Zwischen den Lagen der Werkstücke 14 kann eine Folie 30 und/oder ein Druckkissen bzw. eine Ausgleichsfolie angeordnet sein. Durch die dazwischen angeordnete Folie 30 verkleben die Werkstücke 14 nicht miteinander, und ein Verhaken wird verhindert. Die eingesetzten Folie 30 können als Schutzfolie oder als Ausgleichsfolie ausgebildet sein. Die Werkstücke 14 können vorteilhaft mit einem Mehrfachgreifer (80) umgesetzt werden.

**Fig. 41** zeigt eine weitere Ausführungsform eines Fertigungs-Werkstückträgers 22 mit übereinander gelagerten Werkstücken 14. Im Gegensatz zur Darstellung nach Fig. 40 ist unterhalb der ersten Werkstücke 14 eine weitere Folie angeordnet, die den Fertigungs-Werkstückträger vor einem Verkleben mit einem Druckkissen schützt. Diese kann als Schutzfolie oder als Ausgleichsfolie ausgebildet sein.

**Fig. 42** zeigt eine weitere Ausführungsform eines Fertigungs-Werkstückträgers 22 mit übereinander gelagerten Werkstücken 14. Um die unterste Folie 30 während des Entladens und des Ablösens der Folie 30 zu halten, kann eine Vakuumsaugeinheit 99 angesetzt werden, die über Durchgänge 99a mit der Folie 30 verbunden ist und diese ansaugt.

Bei dem dargestellten Fertigungs-Werkstückträger 22 mit übereinander angeordneten Werkstücken 14 können unterschiedliche Foliendicken und Werkstoffe eingesetzt werden. Es kann beispielsweise PTFE oder PFA als Schutzfolie verwendet werden. Darauf kann eine dickere Druckausgleichfolie aufgelegt werden. Anaschließend können eine zusätzliche Schutzfolie und erst anschließend die Werkstücke aufgelegt werden. Alternativ kann auch mit einer Maske gesintert werden (nicht dargestellt).

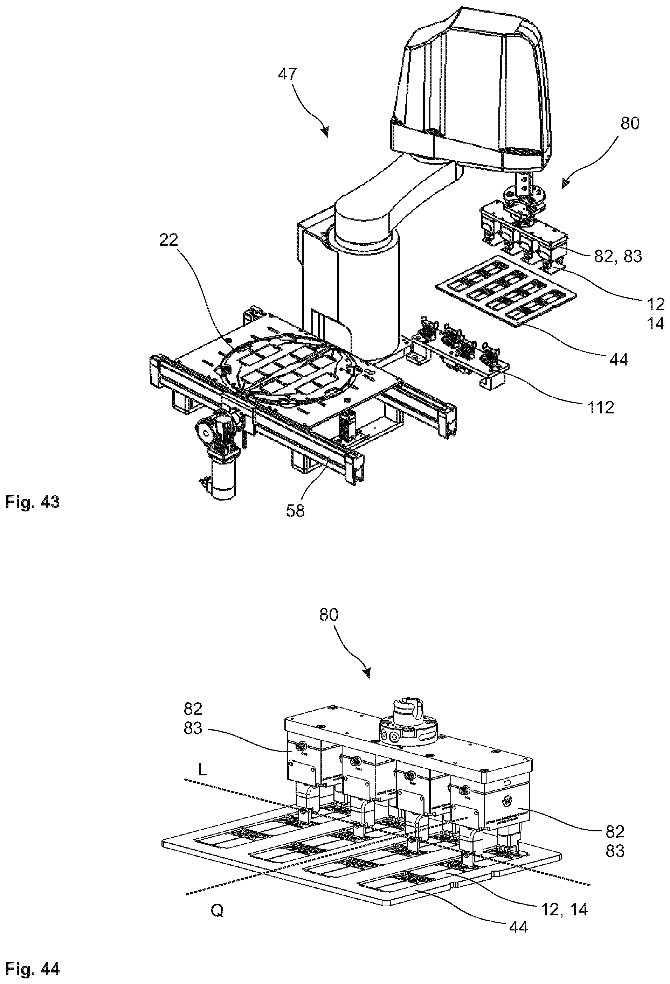

**Fig. 43** zeigt einen Ausschnitt eine Ausführungsform einer Beladestation 18 mit einem Mehrfachgreifer 80 und einer Ausrichteeinheit 112. Durch die Ausrichtelemente des Mehrfachgreifer 80 sowie der Ausrichteeinheit 112 kann ein präzises Umladen, d.h. Eingreifen sowie ausgerichtetes Ablegen, der Werkstücke/Bauteile von dem Transport-Werkstückträger auf den Fertigungs-Werkstückträger erfolgen. Dieser Vorgang wird im Folgenden beschrieben. Wenn im Folgenden von Werkstücken die Rede ist, sind ebenso elektronische Baugruppen darunter zu verstehen.

Die Werkstücke 14 werden zunächst mit dem Mehrfachgreifer 80 von dem Transport-Werkstückträger 44 aufgenommen. Dabei wird je ein Werkstück 14 mit einem Greifarm 82 gehalten. Dies erfolgt über die Greifelemente, welche bezüglich der nachfolgenden Figuren näher beschrieben werden.

**Fig. 44** zeigt eine Ausführungsform eines Mehrfachgreifers 80 während dem Betrieb. In der dargestellten Ausführungsform nimmt jeder Greifarm 82 ein Werkstück 14 aus dem Transport-Werkstückträger 44 auf. Die unterschiedlichen Greifarme 82 sind entlang einer Längsachse L an dem Mehrfachgreifer 80 angeordnet. Bevorzugt können die Greifarme 82 entlang der Längsachse L relativ zueinander bewegt werden, dies ist in den zuvor beschriebenen Figuren näher erläutert. Um weitere Werkstücke 14 aus dem Transport-Werkstückträger 44 aufzunehmen, wird der komplette Mehrfachgreifer 80 entlang einer Querachse Q bewegt, sodass die nächste Reihe an Werkstücken 14 aufgenommen werden kann.

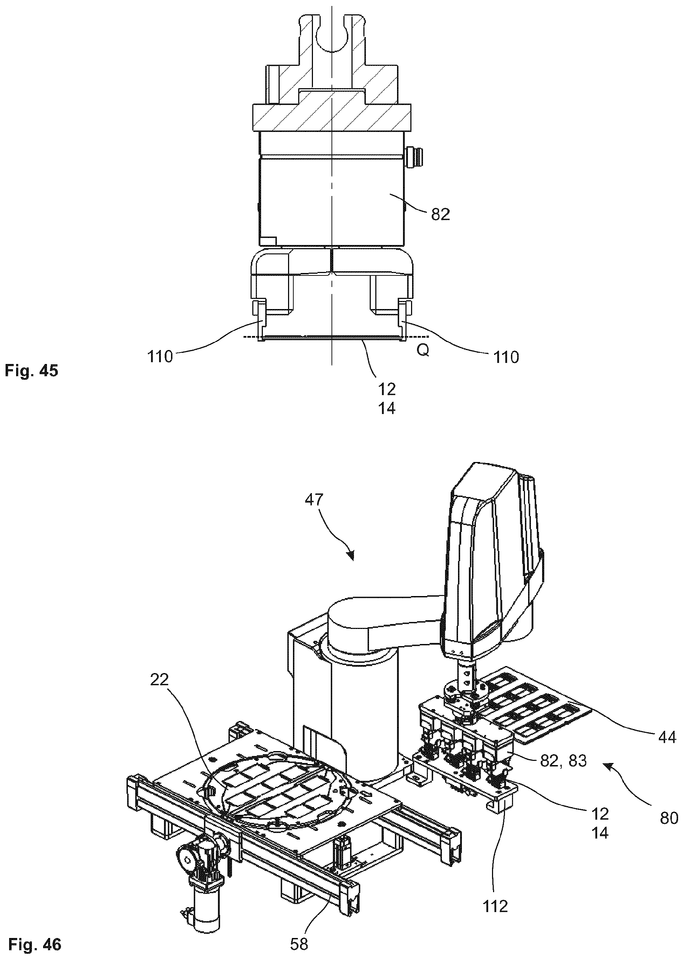

**Fig. 45** zeigt eine Schnittdarstellung durch einen Greifarm 82 eines Mehrfachgreifers 80. Die beiden Greifelemente 110 sind an zwei gegenüberliegenden Seiten an dem Greifarm 82 angeordnet, und halten das Werkstück 14. Dabei halten die Greifelemente 110 das Werkstück 14 ebenso an zwei gegenüberliegenden Seitenkanten, sodass das Werkstück 14 klemmend gehalten wird. In der dargestellten Ausführungsform sind die Greifelemente 110 auf der Querachse Q angeordnet. In einer anderen Ausführungsform können die Greifelemente 110 ebenso auf der in Fig. 44 dargestellten Längsachse gegenüberliegend angeordnet sein, d. h. um 90° gedreht. Durch die Greifelemente 110 kann eine erste Ausrichtung der Werkstücke 14 erfolgen, da zwischen den Greifelemente 110 und dem Werkstück 14 ein flächiger Kontakt entsteht. Dadurch wird das Werkstück 14 zumindest auf der Längsachse L oder auf der Querachse Q ausgerichtet.

**Fig. 46** zeigt einen Ausschnitt eine Ausführungsform einer Beladestation 22 mit einem Mehrfachgreifer 80 und einer Ausrichteeinheit 112 im Betrieb. In der dargestellten Situation ist der Mehrfachgreifer 80 direkt über der Ausrichteeinheit 112 angeordnet. Dadurch können Greifelemente der Ausrichteeinheit 112, wie im Folgenden erläutert, mit den Werkstücken 14 kontaktiert werden. Dadurch kann eine weitere Ausrichtung der Werkstücke 14 auf der Längsachse L bzw. der Querachse Q erfolgen. Bevorzugt erfolgt durch den Mehrfachgreifer 80 und dessen Greifelemente 110 eine erste Ausrichtung der Werkstücke 14 in die Längsachse L, und durch die Ausrichteeinheit 112 eine weitere Ausrichtung der Werkstücke 14 entlang der Querachse Q, wobei die Längsachse L und die Querachse Q in einer horizontalen Ebene angeordnet sind.

In einer nicht dargestellten Ausführungsform kann die Ausrichteeinheit 112 als eine Art Anschlagkante ausgebildet sein, gegen welche der Mehrfachgreifer 80 mit den Werkstücken 14 kontaktiert. Durch den Kontakt der Werkstücke 14 mit einer gerade ausgebildeten Kante kann ebenso eine Ausrichtung der Werkstücke 14 erfolgen, welche an dem Mehrfachgreifer 80 gehalten sind. Dabei sollten insbesondere die Seitenkanten der Werkstücke 14 mit der Anschlagkante in Kontakt kommen, welche nicht durch Greifelemente unterziehen kontaktiert sind.

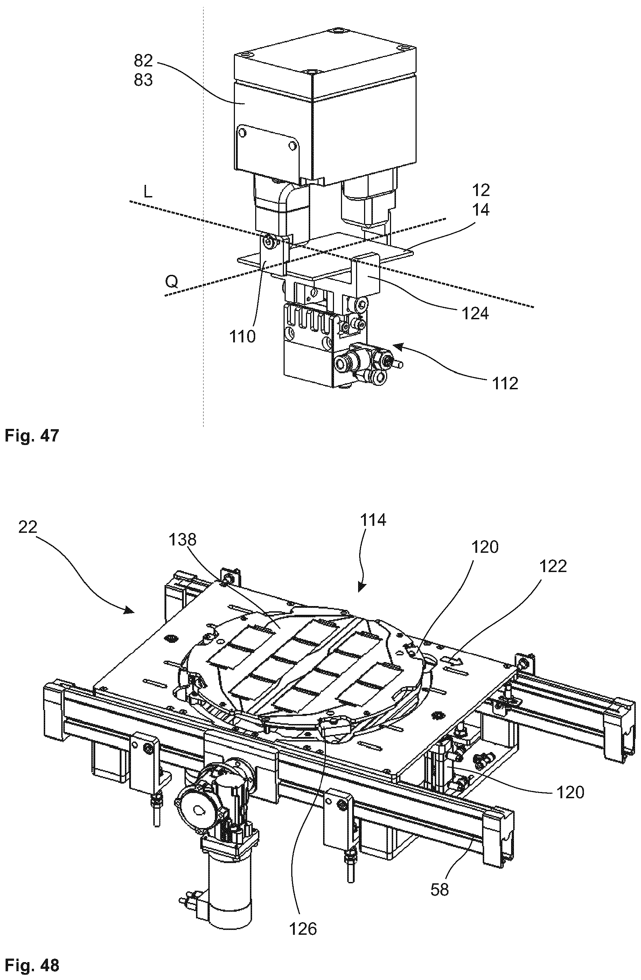

**Fig. 47** zeigt einen Ausschnitt eines Mehrfachgreifers 80 mit einer Ausrichteeinheit 112. In der dargestellten Ausführungsform ist ersichtlich, dass das Werkstück 14 von allen vier Seitenkanten mit Greifelemente 110 des Greifarms 82, bzw. mit Greifelemente 124 der Ausrichteeinheit 112 kontaktiert ist. Das Werkstück 14 kann dadurch exakt in die beiden Achsen L und Q ausgerichtet werden. Durch ein paralleles Greifen durch die Greifelemente 110 können die Werkstücke 14 in Längsrichtung mittig zum Mehrfachgreifer 80 zentriert werden.

Mit anderen Worten werden die Werkstücke 14 mit dem Mehrfachgreifer 80 als eine Art Parallelgreifer in Längsrichtung entlang der Längsachse L zentriert gegriffen und ausgerichtet. Durch die 90° gedrehten Parallelgreifer 124 der Ausrichteeinheit 112 werden die Werkstücke 14 zusätzlich quer zu der Längsachse L, d.h. in Richtung der Querachse Q, ausgerichtet. Durch ein derartiges Vorgehen werden die Werkstücke 14 an dem Mehrfachgreifer 80 zentriert und können exakt in den Fertigungs- Werkstückträger 22 eingelegt werden.

Nach dem Greifen der Werkstücke 14 mit dem Mehrfachgreifer 80 und dem Zentrieren mit der Ausrichteeinheit 112 kann über einen Roboterarm 47 ein Transport zu der Beladestation 18 erfolgen.

**Fig. 48** zeigt einen Ausschnitt einer Beladestation 18 mit einer Zentriervorrichtung 116. Der dargestellte Fertigungs-Werkstückträger 22 umfasst einen Transportrahmen 122 und eine darin verschieblich eingesetzte Baseplate 138. Der Transportrahmen 122 weist eine im Wesentlichen kreisförmige Ausnehmung auf, in der die Baseplate 138 aufgenommen ist. Die im Fertigungs-Werkstückträger 22 integrierte Baseplate 136 sollte bevorzugt gegenüber dem Transportrahmen 122 exakt zentriert und ausgerichtet sein, um ein zielgenaues Ablegen der Werkstücke 14 in den Aufnahmen und dient bevorzugt einer exakten Positionierung aufgenommener Werkstücke 14 in einem nachfolgenden Pressprozess gegenüber Pressstempeln in der Fertigungsstation 21 zu gewährleisten. Dazu kann der Fertigungs-Werkstückträger 22 bzw. die in diesem aufgenommene Baseplate 138 über eine Zentriervorrichtung 114 ausgerichtet werden, Die Zentriervorrichtung 114 umfasst beispielsweise eine Zentrierplatte 116, auf welcher die Baseplate 138 des Fertigungs-Werkstückträger 22 verschieblich gelagert ist. Dadurch kann die Baseplate 138 des Fertigungs-Werkstückträger 22 relativ zu der Zentrierplatte 116 und zum Transportrahmen 122 bewegt werden. Die Zentrierplatte 116 kann beispielsweise kreisförmig ausgebildet sein, und bezüglich einem darum angeordneten Rahmenelement angehoben werden. Dadurch kann die Zentrierplatte 116 verschoben werden.

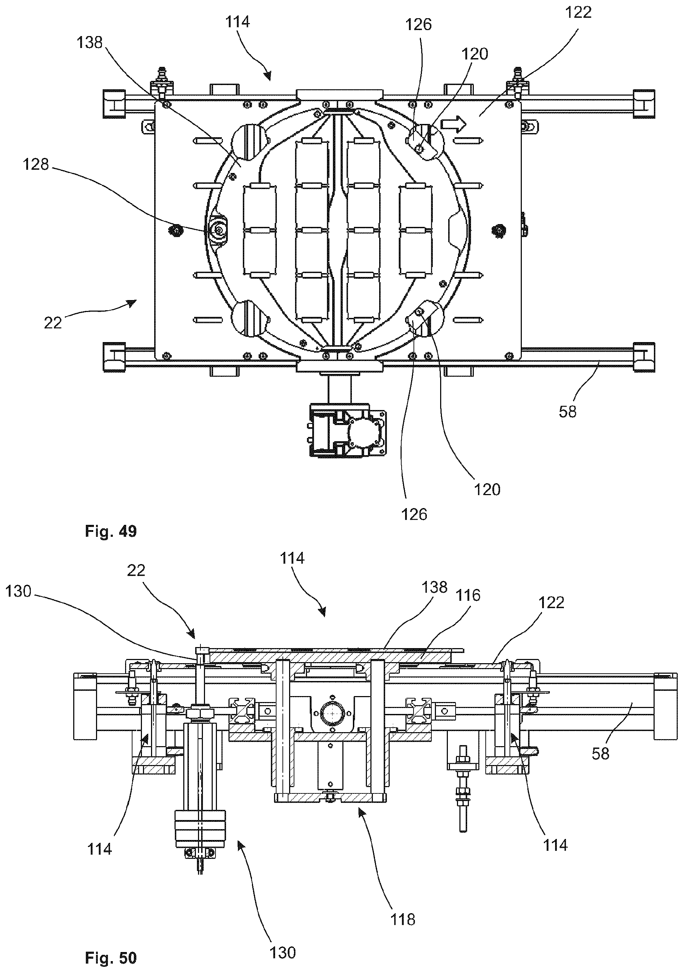

**Fig. 49** zeigt eine Draufsicht auf eine Beladestation 18 mit einer Zentriervorrichtung 114. Die Zentriervorrichtung 114 weist dieser Ausführungsform zwei Zapfen 120 auf, gegen die sich die Baseplate 138 des Fertigungs-Werkstückträger 22 abstützen kann. Über ein Kontaktelement 128, das insbesondere als Exzenter ausgebildet sein kann, wird der Fertigungs-Werkstückträger 22 an die Zapfen 120 angedrückt und dadurch zentriert.

**Fig. 50** zeigt eine Schnittdarstellung durch eine Beladestation 18 mit einer Zentriervorrichtung 114. In dieser Darstellung ist die Zentrierplatte 116 unter dem Fertigungs-Werkstückträger 22 erkennbar. Das Andrückelement 130 weist unterhalb der Zentrierplatte 116 einen Mechanismus zum Ansteuern auf. Ebenso ist eine Hubeinheit 118 erkennbar, die ein Anheben und Absenken der Zentrierplatte 116 bewirken kann. Der Transportrahmen122 ist als Rahmenelement um die Zentrierplatte 116 angeordnet, bezüglich dem die Baseplate 136 auszurichten ist, und ist ein Teilelement des Fertigungs-Werkstückträgers 22.

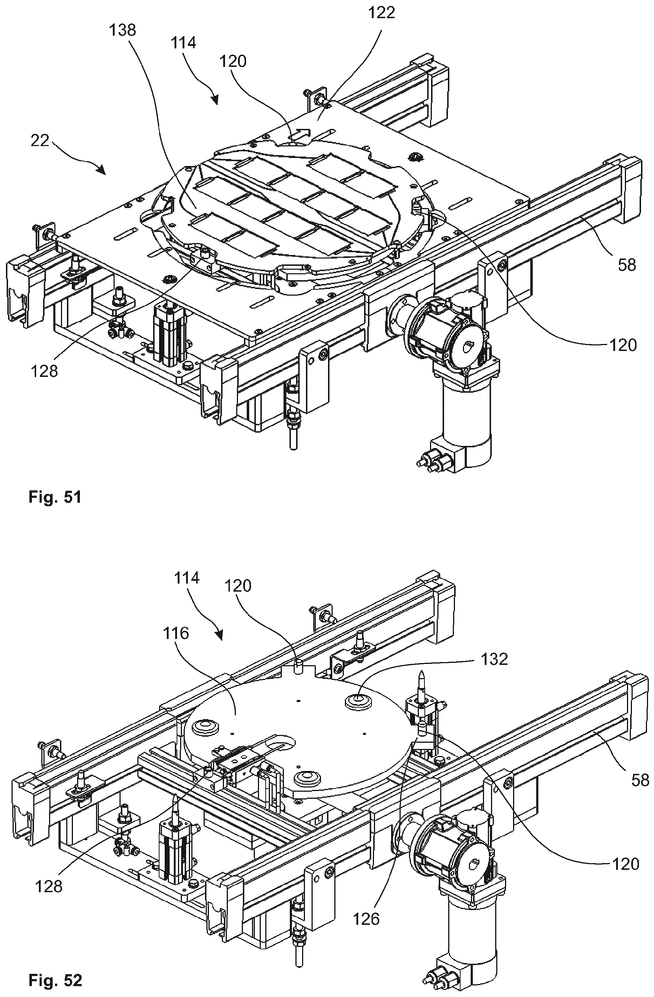

**Fig. 51** zeigt eine weitere Ansicht einer Beladestation 18 mit einer Zentriervorrichtung 116. **Fig. 52** zeigt die Ansicht aus Fig. 51 ohne Werkstückträger 22. Es ist erkennbar, dass die Zapfen 120 auf eine Art Steg 126 der Zentrierplatte 116 angeordnet sind. Das Andrückelement 130 weist ebenso ein Kontaktelement 128 auf, das als eine Art Zapfen ausgebildet ist. Dieses Kontaktelement 128 kann sich jedoch relativ zu der Zentrierplatte 116 bewegen. Dadurch kann eine relative Verschiebung der Baseplate 138 des Fertigungs- Werkstückträgers 22 zu der Zentrierplatte 116 und zum Transportrahmen 122 erfolgen. In der Darstellung sind ebenso drei Auflager 132 erkennbar, die beispielsweise als Kugelrollen-Auflage ausgebildet sein können, so dass die Baseplate 138 dreh- und verschieblich durch die Zentrierplatte 116 gelagert wird, um im Transportrahmen 122 ausgerichtet zu werden.

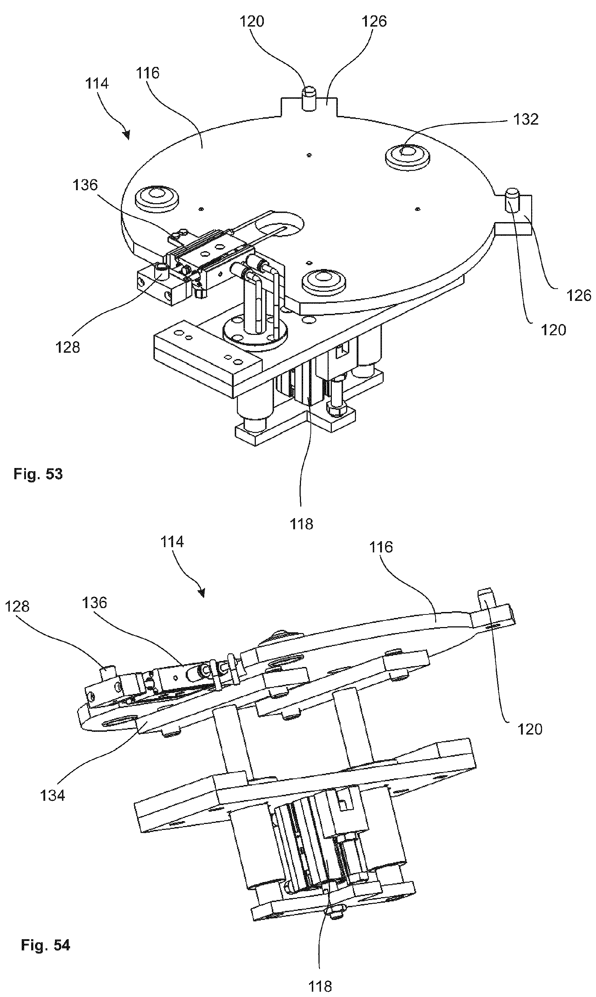

**Fig. 53** zeigt eine Detailansicht der Zentriervorrichtung 114. Die Zapfen 120 sind an der Zentrierplatte 116 angeordnet. In dieser Ausführungsform weist die Zentrierplatte 116 Stege 126 auf, an welchen die Zapfen 120 angeordnet sind. Eine andere Ausführung ist ebenso denkbar. Beispielsweise können die Zapfen 120 an einer anderen Position am Rand der Zentrierplatte 116 angeordnet werden. Das Andrückelement weist ein Kontaktelement 128 auf, das ebenso als Zapfen ausgeformt ist. Hier ist eine andere Ausgestaltung denkbar. Beispielsweise in Form eines quadratisch geformten Vorsprungs bzw. eines elliptischen Vorsprungs. Über die Hubeinheit 118 kann die Zentrierplatte 116 nach oben sowie nach unten bewegt werden.

**Fig. 54** zeigt eine weitere Detailansicht der Zentriervorrichtung 114. In dieser Ausführungsform ist ein Nivellierelement 134 erkennbar, das zur Ausrichtung der Zentrierplatte 116 dient. Das Andrückelement weist einen pneumatischen Zylinder 136 auf, der zum Andrücken sowie Zentrieren des Andrückelements, d. h. in dieser Ausführungsform des Kontaktelements 128, an der im Transportrahmen 122 aufgenommenen Baseplate 138 des Fertigungs- Werkstückträger 22 dient.

Mittels der Ausrichtung von Werkstücken 14 bzw. elektronischen Baugruppen beim Umsetzen von einem Transport-Werkstückträger 44 auf den Fertigungs-Werkstückträger 22 und bevorzugt zuvor durchgeführten Ausrichtung des Fertigungs-Werkstückträgers 22 bzw. einer Baseplate 138 gegenüber einem Transportrahmen 122 des Fertigungs-Werkstückträgers 22 wird eine exakte Ausrichtung und Positionierung der Werkstücke 14 bzw. elektronischen Baugruppen in der weiteren Bearbeitung in der Fertigungsstation 21 erreicht.

Die dargestellten Ausführungsformen bezüglich des Mehrfachgreifers 80 können selbstverständlich mit den dargestellten Ausführungsformen der Zentriervorrichtung 114 und/oder der Ausrichteeinheit 112 beliebig kombiniert werden. Insbesondere können unterschiedliche Mehrfachgreifer 80 mit einer unterschiedlichen Anzahl an Greifarmen 82 bzw. unterschiedlich angeordneten sowie ausgestalteten Greifelementen 110 kombiniert werden.

### Bezugszeichenliste

- 10: Anlage
- 10a: Sinter- oder Lötanlage
- 12: elektronische Baugruppe
- 14: Werkstück
- 16: Modul
- 18: Beladestation
- 20: Entladestation
- 21: Fertigungsstation
- 22: Fertigungs-Werkstückträger
- 24: Transporteinheit
- 25: Hubeinheit
- 26: Arbeitsposition
- 26a-26d: Arbeitsposition
- 28: Maske
- 29: Parkposition
- 30: Folie / Einzelfolienelement / Ausgleichsfolie (Druckkissen)
- 32: Folienumsetzereinheit
- 34: Folienumsetzer
- 34a, 34b: Folienumsetzer
- 36: Folienstapel aus Einzelfolienelementen
- 38: Folienmagazin
- 40: Folien-Hebeeinheit
- 42: zweite Transporteinheit
- 44: Transport-Werkstückträger
- 46: Automatisierungsroboter
- 47: Roboterarm
- 48: Reinigungseinheit
- 50: Höhenausgleichssystem
- 52: Haltering
- 54: Oberseite
- 56: Entnahmefläche
- 58: Verfahreinheit
- 60: Unterflurfördereinheit
- 61: Hubeinheit
- 62: Prozessabdeckung
- 64: Lineareinheit
- 66: Folienträger
- 68: Stapelmagazin von Fertigungs-Werkstückträger
- 70: Inspektionskamera
- 72: Optische Referenzmarke
- 74: Formschlüssiger Randabschnitt
- 76: Befestigungselement
- 78: Magazin
- 80: Mehrfachgreifer
- 82: Greifarm
- 83: äußerer Greifarm
- 84: Folienablöseeinheit
- 85: Lineareinheit
- 86: Abschäleinheit
- 88: Abschälelement
- 90: Halteelement
- 92: Kontaktelement
- 94: Greifelement
- 96: Rolle
- 96a: Vertiefung
- 96b: Erhöhung
- 98: Folienheber
- 99: Vakuumsaugeinheit
- 99a: Durchgang

- 100: Verfahren

- 110: Greifelement
- 112: Ausrichteeinheit
- 114: Zentriervorrichtung
- 116: Zentrierplatte
- 118: Hubeinheit
- 120: Zapfen
- 122: Transportrahmen des Fertigungs-Werkstückträgers
- 124: Greifelement
- 126: Steg
- 128: Kontaktelement
- 130: Andrückelement
- 132: Auflager
- 134: Nivellierelement
- 136: Pneumatikzylinder
- 138: Baseplate des Fertigungs-Werkstückträgers

- E1: obere Ebene
- E2: untere Ebene
- L: Längsachse
- Q: Querachse

## Patentansprüche

1. Anlage (10) zum Verbinden von elektronischen Baugruppen (12) und/oder zum Fertigen von Werkstücken (14), insbesondere eine Sinter- oder Lötanlage (10a), umfassend mehrere Module (16) zum Verbinden der elektronischen Baugruppen (12) und/oder zum Fertigen der Werkstücke (14), wobei zumindest ein Modul (16) als Beladestation (18) und ein Modul (16) als Entladestation (20) ausgebildet ist, oder ein Modul als Beladestation (18) und als Entladestation (20) ausgebildet ist, wobei zumindest ein weiteres Modul (16) als Fertigungsstation (21) ausgebildet ist, und ein Fertigungs-Werkstückträger (22) zur Aufnahme der elektronischen Baugruppen (12) und/oder der Werkstücke (14) vorgesehen ist, der über eine Transporteinheit (24) von der Beladestation (18) über die Fertigungsstation (21) zur Entladestation (20) automatisiert bewegbar ist, wobei die Anlage (10) insbesondere für eine Fließfertigung ausgebildet ist, wobei ein Mehrfachgreifer (80) vorgesehen ist, durch welchen zumindest zwei elektronische Baugruppen (12) und/oder Werkstücke (14) auf den Fertigungs-Werkstückträger (22) gleichzeitig aufsetzbar sind, **dadurch gekennzeichnet, dass** der Mehrfachgreifer (80) zumindest zwei unabhängig voneinander bewegbare Greifarme (82) aufweist, die jeweils zur Aufnahme von einer elektronischen Baugruppe (12) und/oder einem Werkstück (14) ausgebildet sind, und durch die Greifarme (82) eine Ausrichtung zumindest einer, insbesondere aller elektronischen Baugruppe (12) und/oder zumindest eines, insbesondere aller Werkstücke (14) in eine Achse quer oder längs zu dem Mehrfachgreifer (80) erfolgen kann.

2. Anlage (10) nach Anspruch 1, **dadurch gekennzeichnet, dass** der Mehrfachgreifer (80) vier Greifarme (82) aufweist, die jeweils zur Aufnahme von einer elektronischen Baugruppe (12) und/oder einem Werkstück (14) ausgebildet sind, wobei bevorzugt zumindest ein Greifarm (82) pneumatisch angesteuert ist, sodass dieser relativ zu dem zumindest einen weiteren Greifarm (82) bewegbar und/oder verschwenkbar ist.

3. Anlage (10) nach einem der vorhergehenden Ansprüche, **dadurch gekennzeichnet, dass** der Mehrfachgreifer (80) vier Greifarme (82) aufweist, die parallel zueinander entlang einer Linie angeordnet sind, wobei die beiden äußeren Greifarme (82) entlang der Linie verfahrbar sind, sodass diese relativ zu den beiden inneren Greifarmen (82) verfahrbar sind.

4. Anlage (10) nach einem der vorhergehenden Ansprüche, **dadurch gekennzeichnet, dass** in der Beladestation (18) und/oder Entladestation (20) zumindest ein Automatisierungsroboter (46) zur Führung des Mehrfachgreifers (80) vorgesehen ist, durch den zumindest zwei elektronische Baugruppen (12) und/oder Werkstücke (14) von einem Transport-Werkstückträger (44) auf den Fertigungs-Werkstückträger (22) in der Beladestation (18) automatisiert und zeitgleich auflegbar sind.

5. Anlage (10) nach einem der vorhergehenden Ansprüche, **dadurch gekennzeichnet, dass** zumindest ein Greifarm (82), insbesondere jeder Greifarm (82), zur Aufnahme von einer elektronischen Baugruppe (12) und/oder einem Werkstück (14) zumindest zwei Greifelemente (110) aufweist, die eine Ausrichtung der elektronischen Baugruppe (12) und/oder des Werkstücks (14) in eine Achse bewirkt, wobei die Achse insbesondere durch beide Greifelemente (110) verläuft.

6. Anlage (10) nach einem der vorhergehenden Ansprüche, **dadurch gekennzeichnet, dass** eine Ausrichteeinheit (112) umfasst ist, die eine Ausrichtung der von dem Mehrfachgreifer (80) aufgenommenen elektronischen Baugruppe (12) und/oder des Werkstücks (14) in eine Achse parallel und/oder quer zu dem Mehrfachgreifer (80) bewirkt.

7. Anlage (10) nach Anspruch 6, **dadurch gekennzeichnet, dass** die Ausrichteeinheit (112) eine Ausrichtung der elektronischen Baugruppen (12) und/oder der Werkstücke (14) in einer Achse quer zu der Ausrichtung durch die Greifelemente (110) bewirkt.

8. Anlage (10) nach einem der vorhergehenden Ansprüche, **dadurch gekennzeichnet, dass** in der Beladestation (18) zur Ausrichtung und/oder Zentrierung des Fertigungs-Werkstückträgers (22) bzw. einer in einem Transportrahmen (122) aufgenommenen Baseplate (138) des Fertigungs-Werkstückträgers (22) eine Zentriervorrichtung (114) vorgesehen ist, die eine horizontale und/oder vertikale Ausrichtung und/oder Zentrierung des Fertigungs-Werkstückträgers (22) vor Aufnahme der elektronischen Baugruppen (12) und/oder der Werkstücke (14) bewirkt.

9. Anlage (10) nach Anspruch 8, **dadurch gekennzeichnet, dass** die Zentriervorrichtung (114) eine Zentrierplatte (116) und/oder eine Hubeinheit (118) umfasst, wobei eine Ansteuerung insbesondere pneumatisch erfolgt.

10. Anlage (10) nach Anspruch 8 oder 9, **dadurch gekennzeichnet, dass** zumindest ein Vorsprung oder Zapfen (120) an der Zentrierplatte (116) vorgesehen ist, der mit einem Anschlag (122) an dem Fertigungs-Werkstückträger (22) kontaktierbar ist, sodass eine Ausrichtung und/oder Zentrierung des Fertigungs-Werkstückträgers (22) relativ zu der Zentrierplatte (116) in der horizontalen Ebene erfolgen kann.

11. Anlage (10) nach zumindest einem der vorhergehenden Ansprüche, **dadurch gekennzeichnet, dass** eine weitere Transporteinheit (42) zur Aufnahme des Transport-Werkstückträgers (44) vorgesehen ist, die unabhängig von den Modulen (16) von der Beladestation (18) zu der Entladestation (20), insbesondere unter Umgehung der Fertigungsstation (21), verfahrbar ist.

12. Anlage (10) nach einem der vorhergehenden Ansprüche, weiterhin umfassend einen Fertigungs-Werkstückträger (22), der zur Aufnahme von zumindest zwei Werkstücken (14) ausgebildet ist, **dadurch gekennzeichnet, dass** die zumindest zwei Werkstücke (14) übereinander auf dem Fertigungs-Werkstückträger (22) anordenbar sind, wobei bevorzugt zwischen den zumindest zwei übereinander anordenbaren Werkstücken (14) auf dem Fertigungs-Werkstückträger (22) eine Folie (30) anordenbar ist, und wobei weiterhin bevorzugt unter dem untersten Werkstück (14) auf dem Fertigungs-Werkstückträger (22) eine Folie (30) anordenbar ist.

13. Verfahren (100) zum Verbinden von elektronischen Baugruppen (12) und/oder zum Fertigen von Werkstücken (14) unter Verwendung einer Anlage nach einem der vorgenannten Ansprüche, **gekennzeichnet durch folgende Schritte:**
- Vorkonfektionierung von elektronischen Baugruppen (12) und/oder Werkstücken (14) durch einen Mehrfachgreifer (80), durch welchen zumindest zwei elektronische Baugruppen (12) und/oder Werkstücke (14) gleichzeitig auf einem Fertigungs-Werkstückträger (22) in der Beladestation (18) aufgesetzt werden, wobei in der Vorkonfektionierung in der Beladestation (18) ein automatisiertes Umsetzen der elektronischen Baugruppen (12) und/oder der Werkstücke (14) durch den Mehrfachgreifer (80) von einem Transport-Werkstückträger (44) auf den Fertigungs-Werkstückträger (22) erfolgt.
- Automatisiertes Verfahren des Fertigungs-Werkstückträgers (22) von der Beladestation (18) zu zumindest einer Fertigungsstation (21);
- Entladen der elektronischen Baugruppen (12) und/oder der Werkstücke (14) durch einen Mehrfachgreifer (80) von dem Fertigungs-Werkstückträger (22) in den Transport-Werkstückträger (44) in einer Entladestation (20) nach Durchlauf der elektronischen Baugruppen (12) und/oder der Werkstücke (14) durch die Fertigungsstation (21),
- Automatisiertes Rückführen des Fertigungs-Werkstückträgers (22) zu der Beladestation (18), insbesondere unter Umgehung der Fertigungsstation (21).

14. Verfahren (100) nach Anspruch 13, **dadurch gekennzeichnet, dass** das Rückführen des Fertigungs-Werkstückträgers (22) in einer Ebene erfolgt, die unterhalb, oberhalb oder benachbart in einer Ebene angeordnet ist, in der der Fertigungs-Werkstückträger (22) beim Beladen und/oder Entladen angeordnet ist.

15. Verfahren (100) nach einem der Ansprüche 13 oder 14, **dadurch gekennzeichnet, dass** das Rückführen des Fertigungs-Werkstückträgers (22) durch eine erste Transporteinheit (24) erfolgt, und der Transport-Werkstückträger (44) auf einer weiteren Transporteinheit (42) angeordnet ist, die insbesondere automatisiert verfährt, wobei die erste Transporteinheit (24) und die weitere Transporteinheit (42) unabhängig voneinander, und insbesondere unter Umgehung der Fertigungsstation (21), verfahrbar sind.

16. Verfahren (100) nach einem der Ansprüche 13 bis 15, **dadurch gekennzeichnet, dass** der Transport-Werkstückträger (44) eine elektronische Baugruppe (12) und/oder ein Werkstück (14), und der Fertigungs-Werkstückträger (22) mehr als zwei, bevorzugt mehr als fünf, insbesondere mehr als sieben, und im Speziellen vierundzwanzig oder mehr elektronische Baugruppen (12) und/oder Werkstücke (14) aufnimmt, sodass beim Beladen und/oder Entladen der Fertigungs-Werkstückträger (22) an einer Position in der Beladestation (18) verweilt, bis die Transporteinheit (42) den Fertigungs-Werkstückträger (22) mit elektronischen Baugruppen (12) und/oder Werkstücken (14) voll beladen hat.

17. Verfahren zum Beladen eines Werkstückträgers (22) einer Anlage (10) nach einem der Ansprüche 1 bis 12, wobei eine Ausrichtung des zumindest ersten Werkstücks (14) durch den Mehrfachgreifer (80) und/oder durch eine Ausrichteeinheit (112) erfolgt, sodass das zumindest ein, bevorzugt alle Werkstücke (14) in einer horizontalen Ebene quer und/oder längs zu einer Achse des Mehrfachgreifers (80) ausgerichtet sind.

18. Verfahren zum Beladen eines Werkstückträgers (22) einer Anlage (10) nach Anspruch 17, wobei eine weitere Ausrichtung des Fertigungs-Warenträgers (22) bzw. einer in einem Transportrahmen (122) aufgenommenen Baseplate (138) des Fertigungs-Werkstückträgers (22) durch eine Zentriervorrichtung (114) erfolgt.

19. Verfahren zum Beladen eines Werkstückträgers (22) nach Anspruch 17 oder 18, umfassend die weiteren Schritte:
- Beladen des Fertigungs-Werkstückträgers (22) mit zumindest einem ersten Werkstück (14),
- Auflegen einer Folie (30) und/oder eines Druckkissens auf das erste Werkstück (14),
- erneutes Beladen mit zumindest einem zweiten Werkstück (14) oberhalb der Folie (30) und oberhalb des bereits angeordneten ersten Werkstücks (14),
- Auflegen einer weiteren Folie (30) und/oder eines weiteren Druckkissens auf das zweite Werkstück (14).

20. Verfahren zum Entladen eines Werkstückträgers (22) einer Anlage (10) nach einem der Ansprüche 1 oder 12, und nachfolgend zu einem Verfahren zum Beladen eines Werkstückträgers (22) nach Anspruch 19, umfassend zumindest die Schritte:
- Entnahme einer oberen Folie (30) und/oder eines oberen Druckkissens,
- Entnahme eines oberen Werkstücks (14) oder einer oberen Ebene von Werkstücken (14) aus dem Fertigungs-Werkstückträger (22);
- Entnahme einer weiteren Folie (30) und/oder eines weiteren Druckkissens,
- Entnahme zumindest eines weiteren Werkstücks (14) oder einer weiteren Ebene von Werkstücken (14) aus dem Fertigungs-Werkstückträgers (22).

## Claims

1. A system (10) for connecting electronic assemblies (12) and/or for manufacturing workpieces (14), in particular a sintering or soldering system (10a), comprising a plurality of modules (16) for connecting the electronic assemblies (12) and/or for manufacturing the workpieces (14), wherein at least one module (16) is designed as a loading station (18) or one module (16) as an unloading station (20), wherein at least one further module (16) is designed as a manufacturing station (21), and a manufacturing workpiece carrier (22) is provided for accommodating the electronic assemblies (12) and/or workpieces (14) which is movable by a conveying unit (24) in automated manner from the loading station (18) via the manufacturing station (21) to the unloading station (20), wherein the system (10) is designed in particular for flow production and wherein a multiple gripper (80) is provided by which at least two electronic assemblies (12) and/or workpieces (14) are simultaneously placeable onto the manufacturing workpiece carrier (22), **characterized in that** the multiple gripper (80) has at least two independently movable gripper arms (82) each designed to pick up one electronic assembly (12) and/or one workpiece (14), and an alignment of at least one, in particular of all electronic assemblies (12) and/or of at least one, in particular of all workpieces (14) by the gripper arms (82) can take place in an axis transverse or longitudinal to the multiple gripper (80).

2. The system (10) according to claim 1, **characterized in that** the multiple gripper (80) has four gripper arms (82), which are each designed to pick up one electronic assembly (12) and/or one workpiece (14), wherein preferably at least one gripper arm (82) is pneumatically controlled such that it is movable and/or pivotable relative to the at least one further gripper arm (82).

3. The system (10) according to any of the preceding claims, **characterized in that** the multiple gripper (80) has four gripper arms (82) arranged parallel to one another along a line, wherein the two outer gripper arms (82) are movable along the line such that they are movable relative to the two inner gripper arms (82).

4. The system (10) according to any of the preceding claims, **characterized in that** at least one automation robot (46) is provided in the loading station (18) and/or unloading station (20) for guiding the multiple gripper (80) by which at least two electronic assemblies (12) and/or workpieces (14) are placeable in automated manner and simultaneously from a conveying workpiece carrier (44) onto the manufacturing workpiece carrier (22) in the loading station (18).

5. The system (10) according to any of the preceding claims, **characterized in that** at least one gripper arm (82), in particular every gripper arm (82), has at least two gripping elements (110) for picking up an electronic assembly (12) and/or workpiece (14), which effects an alignment of the electronic assembly (12) and/or workpiece (14) in an axis, wherein the axis passes in particular through both gripping elements (110).

6. The system (10) according to any of the preceding claims, **characterized in that** an aligning unit (112) is comprised that effects an alignment of the electronic assembly (12) and/or workpiece (14) picked up by the multiple gripper (80) in an axis parallel and/or transverse to the multiple gripper (80).

7. The system (10) according to claim 6, **characterized in that** the aligning unit (112) effects an alignment of the electronic assemblies (12) and/or workpieces (14) in an axis transverse to the alignment by means of the gripping elements (110).

8. The system (10) according to any of the preceding claims, **characterized in that** a centering device /114) is provided in the loading station (18) for alignment and/or centering of the manufacturing workpiece carrier (22) or of a baseplate (138) of the manufacturing workpiece carrier (22) accommodated in a conveying frame (122), said device effecting a horizontal and/or vertical alignment and/or centering of the manufacturing workpiece carrier (22) before accommodating the electronic assemblies (12) and/or workpieces (14).

9. The system (10) according to claim 8, **characterized in that** the centering device (114) comprises a centering plate (116) and/or a lifting unit (118), wherein control is in particular pneumatic.

10. The system (10) according to claim 8 or 9, **characterized in that** at least at least one projection or peg (120), which is contactable with a stop (122) on the manufacturing workpiece carrier (22), is provided on the centering plate (116), such that alignment and/or centering of the manufacturing workpiece carrier (22) relative to the centering plate (116) can take place in the horizontal plane.

11. The system (10) according to at least one of the preceding claims, **characterized in that** a further conveying unit (42) is provided for accommodating the conveying workpiece carrier (44) and is movable, independently of the modules (16), from the loading station (18) to the unloading station (20), in particular bypassing the manufacturing station (21).

12. The system (10) according to any of the preceding claims, further comprising a manufacturing workpiece carrier (22) which is designed to carry at least two workpieces (14), **characterized in that** the at least two workpieces (14) are arrangeable one above the other on the manufacturing workpiece carrier (22), wherein a foil/film (30) is preferably arrangeable between the at least two workpieces (14) arrangeable one above the other on the manufacturing workpiece carrier (22), and wherein a foil/film (30) is furthermore preferably arrangeable under the bottom workpiece (14) on the manufacturing workpiece carrier (22).

13. A method (100) for connecting electronic assemblies (12) and/or for manufacturing workpieces (14) using a system according to any of the above claims, **characterized by the following steps:**
- Prefabrication of electronic assemblies (12) and/or workpieces (14) by a multiple gripper (80) by which at least two electronic assemblies (12) and/or workpieces (14) are placed simultaneously on a manufacturing workpiece carrier (22) in the loading station (18), wherein during prefabrication in the loading station (18) the electronic assemblies (12) and/or workpieces (14) are transferred in automated manner by the multiple gripper (80) from a conveying workpiece carrier (44) onto the manufacturing workpiece carrier (22).
- Automated movement of the manufacturing workpiece carrier (22) from the loading station (18) to at least one manufacturing station (21);
- Unloading of the electronic assemblies (12) and/or workpieces (14) by a multiple gripper (80) from the manufacturing workpiece carrier (22) onto the conveying workpiece carrier (44) in an unloading station (20) after passage of the electronic assemblies (12) and/or workpieces (14) through the manufacturing station (21),
- Automated return of the manufacturing workpiece carrier (22) to the loading station (18), in particular bypassing the manufacturing station (21).

14. The method (100) according to claim 13, **characterized in that** return of the manufacturing workpiece carrier (22) takes place in a plane arranged below, above or adjacent in a plane in which the manufacturing workpiece carrier (22) is arranged during loading and/or unloading.

15. A method (100) according to one of claims 13 or 14, **characterized in that** the manufacturing workpiece carrier (22) is returned by a first conveying unit (24), and the conveying workpiece carrier (44) is arranged on a further conveying unit (42) which is moved in particular in automated manner, wherein the first conveying unit (24) and the further conveying unit (42) are movable mutually independently, in particular bypassing the manufacturing station (21).

16. The method (100) according to any of claims 13 to 15, **characterized in that** the conveying workpiece carrier (44) accommodates one electronic assembly (12) and/or one workpiece (14), and the manufacturing workpiece carrier (22) accommodates more than two, preferably more than five, in particular more than seven, especially twenty-four or more, electronic assemblies (12) and/or workpieces (14), such that during loading and/or unloading the manufacturing workpiece carrier (22) pauses at a position in the loading station (18) until the conveying unit (42) has fully loaded the manufacturing workpiece carrier (22) with electronic assemblies (12) and/or workpieces (14).

17. A method for loading a workpiece carrier (22) of a system (10) according to any of claims 1 to 12, wherein an alignment of at least the first workpiece (14) is performed by the multiple gripper (80) and/or by an aligning unit (112), such that the at least one workpiece, preferably all workpieces (14), are aligned in a horizontal plane transversely and/or longitudinally to an axis of the multiple gripper (80).

18. A method for loading a workpiece carrier (22) of a system (10) according to claim 17, wherein a further alignment of the manufacturing workpiece carrier (22) or of a baseplate (138) of the manufacturing workpiece carrier (22) accommodated in a conveying frame (122) is performed by a centering device (114).

19. A method for loading a workpiece carrier (22) according to claim 17 or 18, comprising the further steps:
- loading of the manufacturing workpiece carrier (22) with at least one first workpiece (14),
- placing of a foil/film (30) and/or of a pressure pad onto the first workpiece (14),
- further loading with at least one second workpiece (14) above the foil/film (30) and above the already arranged first workpiece (14),
- placing of a further foil/film (30) and/or of a further pressure pad onto the second workpiece (14).

20. A method for unloading a manufacturing workpiece carrier (22) of a system (10) according to any of claims 1 to 12, and subsequently for a movement for loading a workpiece carrier (22) according to claim 19, comprising at least the steps:
- removal of a top foil/film (30) and/or of a top pressure pad,
- removal of a top workpiece (14) or of a top level of workpieces (14) from the manufacturing workpiece carrier (22);
- removal of a further foil/film (30) and/or of a further pressure pad,
- removal of at least one further workpiece (14) or of a further level of workpieces (14) from the manufacturing workpiece carrier (22);

## Revendications

1. Système (10) pour relier des sous-ensembles électroniques (12) et/ou pour fabriquer des pièces d'œuvre (14), notamment un système de frittage ou de brasage (10a), comprenant plusieurs modules (16) pour relier les sous-ensembles électroniques (12) et/ou fabriquer les pièces d'œuvre (14), sachant qu'au moins un module (16) est conçu comme station de chargement (18) et un module (16) comme station de déchargement (20), ou un module est conçu comme station de chargement (18) et comme station de déchargement (20), sachant qu'au moins un autre module (16) est conçu comme station de fabrication (21), et un porte-pièces pour la fabrication (22) est prévu pour accueillir les sous-ensembles électroniques (12) et/ou les pièces d'œuvre (14), lequel porte-pièces est déplaçable de manière automatisée au moyen d'une unité de transport (24), de la station de chargement (18) vers la station de déchargement (20) via la station de fabrication (21), sachant que le système (10) est conçu notamment pour une fabrication à la chaîne, sachant qu'est prévu un préhenseur multiple (80) par le biais duquel au moins deux sous-ensembles électroniques (12) et/ou pièces d'œuvre (14) peuvent être posées simultanément sur le porte-pièces pour la fabrication (22), **caractérisé en ce que** le préhenseur multiple (80) présente au moins deux bras de préhension (82) déplaçables indépendamment l'un de l'autre qui sont conçus respectivement pour accueillir un sous-ensemble électronique (12) et/ou une pièce d'œuvre (14), et que par le biais des bras de préhension (82), une orientation d'au moins un, notamment de tous les sous-ensembles électroniques (12) et/ou d'au moins une, notamment de toutes les pièces d'œuvre (14) peut avoir lieu dans un axe transversalement ou longitudinalement au préhenseur multiple (80).

2. Système (10) selon la revendication 1, **caractérisé en ce que** le préhenseur multiple (80) présente quatre bras de préhension (82) qui sont conçus respectivement pour accueillir un sous-ensemble électronique (12) et/ou une pièce d'œuvre (14), sachant que de préférence, au moins un arbre de préhension (82) est piloté pneumatiquement de sorte que celui-ci est déplaçable et/ou pivotable par rapport audit au moins un autre bras de préhension (82).

3. Système (10) selon l'une des revendications précédentes, **caractérisé en ce que** le préhenseur multiple (80) présente quatre bras de préhension (82) qui sont disposés de manière parallèle les uns aux autres le long d'une ligne, sachant que les deux bras de préhension extérieurs (82) sont mobiles le long de la ligne de sorte que ceux-ci sont mobiles par rapport aux deux bras de préhension intérieurs (82).

4. Système (10) selon l'une des revendications précédentes, **caractérisé en ce qu'**est prévu dans la station de chargement (18) et/ou la station de déchargement (20), au moins un robot automatisé (46) pour conduire le préhenseur multiple (80) par le biais duquel au moins deux sous-ensembles électroniques (12) et/ou pièces d'œuvre (14) peuvent être posées de manière automatisée et simultanée d'un porte-pièces pour le transport (44) sur le porte-pièces pour la fabrication (22) dans la station de chargement (18).

5. Système (10) selon l'une des revendications précédentes, **caractérisé en ce qu'**au moins un bras de préhension (82), notamment chaque bras de préhension (82), présente au moins deux éléments préhenseurs (110) pour accueillir un sous-ensemble électronique (12) et/ou une pièce d'œuvre (14), qui opèrent une orientation du sous-ensemble électronique (12) et/ou de la pièce d'œuvre (14) dans un axe, sachant que l'axe s'étend notamment à travers les deux éléments préhenseurs (110).

6. Système (10) selon l'une des revendications précédentes, **caractérisé en ce qu'**est comprise une unité d'orientation (112) qui opère une orientation du sous-ensemble électronique (12) et/ou de la pièce d'œuvre (14) accueillis par le préhenseur multiple (80) dans un axe parallèlement et/ou transversalement au préhenseur multiple (80).

7. Système (10) selon la revendication 6, **caractérisé en ce que** l'unité d'orientation (112) opère une orientation des sous-ensembles électroniques (12) et/ou des pièces d'œuvre (14) dans un axe transversalement aux éléments préhenseurs (110).

8. Système (10) selon l'une des revendications précédentes, **caractérisé en ce qu'**un dispositif de centrage (114) est prévu dans la station de chargement (18) pour l'orientation et/ou le centrage du porte-pièces pour la fabrication (22) ou d'une plaque de base (138) du porte-pièces pour la fabrication (22), accueillie dans un cadre de transport (122), lequel dispositif de centrage opère une orientation horizontale et/ou verticale et/ou un centrage du porte-pièces pour la fabrication (22) avant l'accueil des sous-ensembles électroniques (12) et/ou des pièces d'œuvre (14).

9. Système (10) selon la revendication 8, **caractérisé en ce que** le dispositif de centrage (114) comprend une plaque de centrage (116) et/ou une unité de levage (118), sachant qu'un pilotage a lieu notamment pneumatiquement.

10. Système (10) selon la revendication 8 ou 9, **caractérisé en ce qu'**au moins une saillie ou un tourillon (120) est prévu(e) sur la plaque de centrage (116) qui peut entrer en contact avec le porte-pièces pour la fabrication (22) au moyen d'une butée (122) de sorte que l'orientation et/ou le centrage du porte-pièces pour la fabrication (22) peut avoir lieu par rapport à la plaque de centrage (116), dans le plan horizontal.

11. Système (10) selon au moins l'une des revendications précédentes, **caractérisé en ce qu'**est prévue une autre unité de transport (42) pour accueillir le porte-pièces pour le transport (44) qui est mobile indépendamment des modules (16), de la station de chargement (18) à la station de déchargement (20), notamment en contournant la station de fabrication (21).

12. Système (10) selon l'une des revendications précédentes, comprenant également un porte-pièces pour la fabrication (22) qui est conçu pour accueillir au moins deux pièces d'œuvre (14), **caractérisé en ce que** lesdites au moins deux pièces d'œuvre (14) peuvent être disposées superposées sur le porte-pièces pour la fabrication (22), sachant que de préférence, un film (30) peut être disposé entre lesdits au moins deux pièces d'œuvre (14) pouvant être disposées superposées sur le porte-pièces pour la fabrication (22), et sachant également que de préférence, un film (30) peut être disposé sous la pièce d'œuvre (14) inférieure sur le porte-pièces pour la fabrication (22).

13. Procédé (100) pour relier des sous-ensembles électroniques (12) et/ou pour fabriquer des pièces d'œuvre (14), en utilisant un système selon l'une des revendications précédentes, **caractérisé par les étapes suivantes** :
- Préparation de sous-ensembles électroniques (12) et/ou de pièces d'œuvre (14) par un préhenseur multiple (80) par le biais duquel au moins deux sous-ensembles électroniques (12) et/ou pièces d'œuvre (14) sont posés simultanément sur un porte-pièces pour la fabrication (22) dans la station de chargement (18), sachant que lors de la préparation dans la station de chargement (18), un changement de position automatique des sous-ensembles électroniques (12) et/ou des pièces d'œuvre (14) a lieu depuis un porte-pièces pour le transport (44) jusque sur le porte-pièces pour la fabrication (22), au moyen du préhenseur multiple (80).
- Translation automatisée du porte-pièces pour la fabrication (22) de la station de chargement (18) vers au moins une station de fabrication (21) ;
- Déchargement des sous-ensembles électroniques (12) et/ou des pièces d'œuvre (14) par un préhenseur multiple (80) depuis le porte-pièces pour la fabrication (22) jusque dans le porte-pièces pour le transport (44) dans une station de déchargement (20) après passage des sous-ensembles électroniques (12) et/ou des pièces d'œuvre (14) à travers la station de fabrication (21),
- Retour automatisé du porte-pièces pour la fabrication (22) vers la station de chargement (18), notamment en contournant la station de fabrication (21).

14. Procédé (100) selon la revendication 3, **caractérisé en ce que** le retour du porte-pièces pour la fabrication (22) a lieu dans un plan qui est disposé en-dessous, au-dessus ou à côté, d'un plan dans lequel le porte-pièces pour la fabrication (22) est disposé lors du chargement et/ou du déchargement.

15. Procédé (100) selon l'une des revendications 13 ou 14, **caractérisé en ce que** le retour du porte-pièces pour la fabrication (22) a lieu au moyen d'une première unité de transport (24), et que le porte-pièces pour le transport (44) est disposé sur une autre unité de transport (42) qui est mobile notamment de manière automatisée, sachant que la première unité de transport (24) et l'autre unité de transport (42) sont mobiles indépendamment l'une de l'autre, et notamment en contournant la station de fabrication (21).

16. Procédé (100) selon l'une des revendications 13 à 15, **caractérisé en ce que** le porte-pièces pour le transport (44) accueille un sous-ensemble électronique (12) et/ou une pièce d'œuvre (14), et que le porte-pièces pour la fabrication (22) accueille plus de deux, de préférence plus de cinq, notamment plus de sept, et en particulier vingt-quatre sous-ensembles électroniques (12) et/ou pièces d'œuvre (14) ou plus, de sorte que lors du chargement et/ou du déchargement, le porte-pièces pour la fabrication (22) demeure à une position dans la station de chargement (18) jusqu'à ce que l'unité de transport (42) ait complètement chargé le porte-pièces pour la fabrication (22), de sous-ensembles électroniques (12) et/ou de pièces d'œuvre (14).

17. Procédé pour le chargement d'un porte-pièces (22) d'un système (10) selon l'une des revendications 1 à 12, sachant qu'une orientation de ladite au moins première pièce d'œuvre (14) a lieu au moyen du préhenseur multiple (80) et/ou d'une unité d'orientation (112) de sorte que ladite au moins une, de préférence toutes les pièces d'œuvre (14), sont orientées dans un plan horizontal transversalement et/ou longitudinalement à un axe du préhenseur multiple (80).

18. Procédé pour le chargement d'un porte-pièces (22) d'un système (10) selon la revendication 17, sachant qu'une orientation supplémentaire du porte-pièces pour la fabrication (22) ou d'une plaque de base (138), du porte-pièces pour la fabrication (22), accueillie dans un cadre de transport (122) a lieu au moyen d'un dispositif de centrage (114).

19. Procédé pour le chargement d'un porte-pièces (22) selon la revendication 17 ou 18, comprenant les étapes suivantes :
- Chargement du porte-pièces pour la fabrication (22) avec au moins une première pièce d'œuvre (14),
- Pose d'un film (30) et/ou d'un coussin de pression sur la première pièce d'œuvre (14),
- Nouveau chargement avec au moins une deuxième pièce d'œuvre (14) au-dessus du film (30) et au-dessus de la première pièce d'œuvre (14) déjà disposée,
- Pose d'un autre film (30) et/ou d'un autre coussin de pression sur la deuxième pièce d'œuvre (14).

20. Procédé pour le déchargement d'un porte-pièces (22) d'un système (10) selon l'une des revendications 1 à 12 et consécutif à un procédé pour le chargement d'un porte-pièces (22) selon la revendication 19, comprenant au moins les étapes suivantes :
- Retrait du film supérieur (30) et/ou d'un coussin de pression supérieur,
- Retrait d'une pièce d'œuvre supérieure (14) ou d'un plan supérieur de pièces d'œuvre (14) hors du porte-pièces pour la fabrication (22) ;
- Retrait d'un autre film (30) et/ou d'un autre coussin de pression,
- Retrait d'au moins une autre pièce d'œuvre (14) ou d'un autre plan de pièces d'œuvre (14) hors du porte-pièces pour la fabrication (22).
